# EUROPEAN PATENT APPLICATION

(11) **EP 4 161 235 A2**
(43) Date of publication of application: **05.04.2023**
(21) Application number: 22198495.8
(22) Date of filing: 28.09.2022
(51) Int. Cl.: H10K 50/165, H10K 85/60, H10K 50/17

(54) **LIGHT EMITTING ELEMENT AND DISPLAY DEVICE INCLUDING THE SAME**

(30) Priority: 30.09.2021 KR 20210130277
(71) Applicant: Samsung Display Co., Ltd., Gyeonggi-Do (KR)
(72) Inventor: KA, Yoonseok, Seongnam-si (KR); KIM, Dong Chan, Suwon-si (KR); MOON, Jiyoung, Gwangju-si (KR); LEE, Hakchoong, Hwaseong-si (KR); SONG, Hajin, Hwaseong-si (KR); YOON, Jihwan, Yongin-si (KR); HWANG, Jaehoon, Seoul (KR)
(74) Representative: Marks & Clerk LLP

(57) **Abstract**

A light emitting element includes a first electrode, a hole transport region disposed on the first electrode, an emission layer disposed on the hole transport region, an electron transport region which is disposed on the emission layer and includes an electron transport layer and an electron injection layer disposed on the electron transport layer, and a second electrode disposed on the electron transport region, wherein the electron injection layer includes a host represented by Formula A or Formula B, and a metal dopant, and the metal dopant includes Ag, Bi, Mg, Li, Yb, Cu, La, Pr, Nd, Pm, Sm, Eu, Gd, Tb, Dy, Ho, Er, Tm, or Lu, thereby improving electron injection characteristics and having excellent or suitable luminous efficiency.

## Description

### BACKGROUND

The present disclosure herein relates to a light emitting element and a display device including the same, and for example, to a light emitting element containing a charge injection layer and a display device including the same.

Recently, the development of an organic electroluminescence display device as an image display device is being actively conducted. Unlike liquid crystal display devices and/or the like, the organic electroluminescence display device is a so-called self-luminescent display device in which holes and electrons injected from a first electrode and a second electrode recombine in an emission layer, and thus a luminescent material including an organic compound in the emission layer emits light to implement display (e.g., to display an image).

In the application of a light emitting element to a display device, there is a desire (e.g., a demand) for a light emitting element having low driving voltage, high luminous efficiency, and/or a long service life (e.g., long lifespan), and the development of materials for a light emitting element capable of stably attaining such characteristics is being continuously pursued (e.g., required).

### SUMMARY

Aspects according to embodiments of the present disclosure are directed toward a light emitting element having high luminous efficiency and a display device including the same.

According to an embodiment of the present disclosure, a light emitting element includes a first electrode, a hole transport region on the first electrode, an emission layer on the hole transport region, an electron transport region on the emission layer and including an electron transport layer and an electron injection layer on the electron transport layer, and a second electrode on the electron transport region, wherein the electron injection layer includes a host represented by Formula A or Formula B, and a metal dopant, and the metal dopant includes Ag, Bi, Mg, Li, Yb, Cu, La, Pr, Nd, Pm, Sm, Eu, Gd, Tb, Dy, Ho, Er, Tm, and/or Lu.

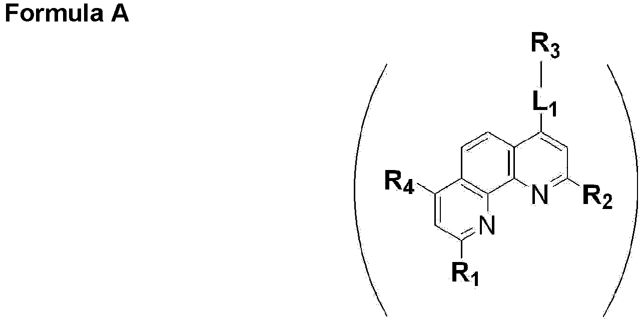

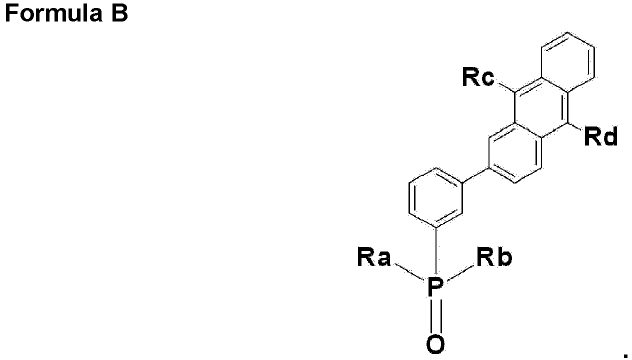

In Formula A, L₁ is a direct linkage, or a substituted or unsubstituted phenylene group, R₁ and R₂ are each independently a hydrogen atom, a substituted or unsubstituted methyl group, or a substituted or unsubstituted phenyl group, R₃ and R₄ are each independently a hydrogen atom, a substituted or unsubstituted aryl group having 6 to 30 ring-forming carbon atoms, or a substituted or unsubstituted heteroaryl group having 2 to 30 ring-forming carbon atoms, and in Formula B, Ra and Rb are each independently a substituted or unsubstituted alkyl group having 1 to 20 carbon atoms, or a substituted or unsubstituted aryl group having 6 to 30 ring-forming carbon atoms, and Rc and Rd are each independently a substituted or unsubstituted aryl group having 6 to 30 ring-forming carbon atoms.

In an embodiment, an absolute value of a difference between a lowest unoccupied molecular orbital (LUMO) energy level of the host doped with the metal dopant and a work function energy level of the second electrode may be about 0.2 eV or less.

In an embodiment, a binding energy between the host and the metal dopant may be about 2.0 eV or more.

In an embodiment, the metal dopant may be Li, and a volume ratio of the metal dopant to a total volume of the host and the metal dopant in the electron injection layer may be 3-10 volume%.

In an embodiment, the metal dopant may be Yb, and a volume ratio of the metal dopant to a total volume of the host and the metal dopant in the electron injection layer may be 5-10 volume%.

In an embodiment, the second electrode may be directly on the electron injection layer.

In an embodiment, the host represented by Formula A may be represented by Formula A-1 or Formula A-2:

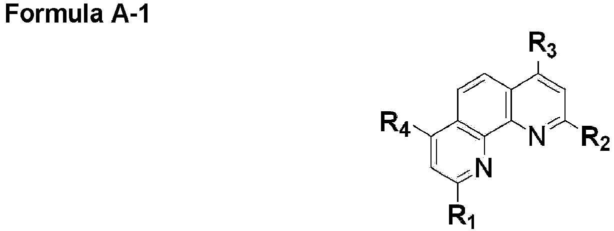

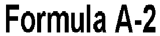

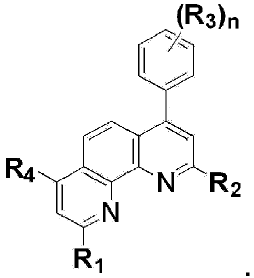

In Formula A-2, n is an integer of 0 to 5, and in Formula A-1 and Formula A-2, R₁ to R₄ are each independently the same as defined in connection with Formula A.

In an embodiment, in Formula A-2, R₃ may be represented by any one among S1 to S25:

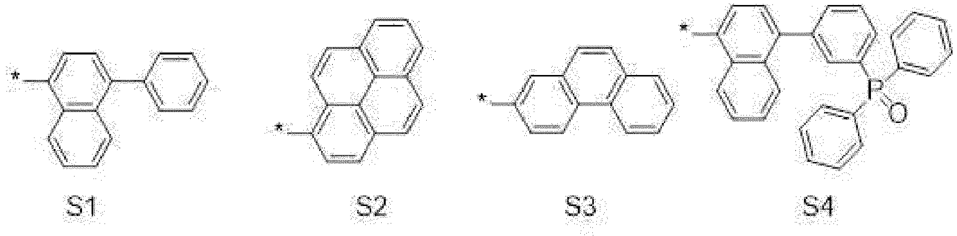

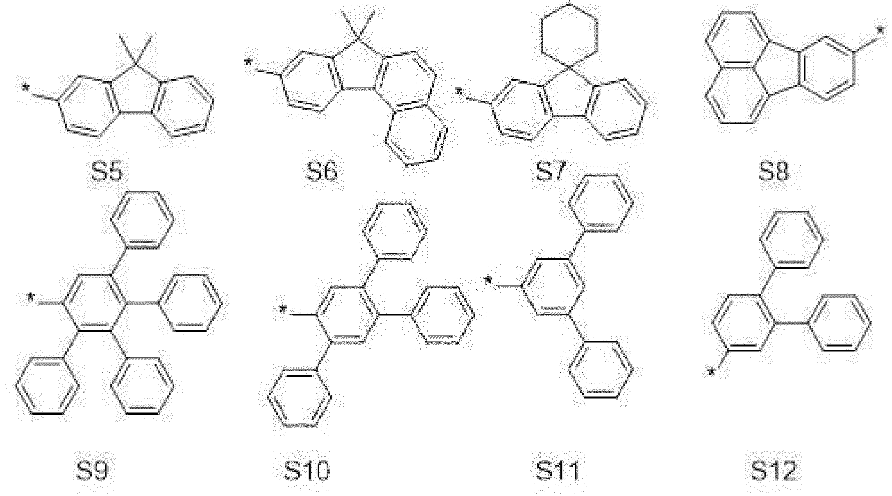

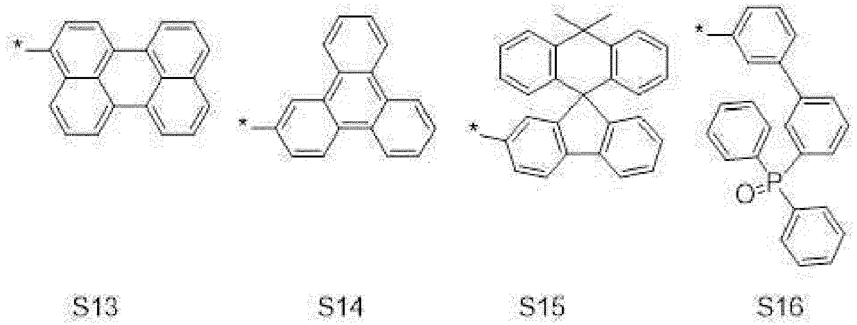

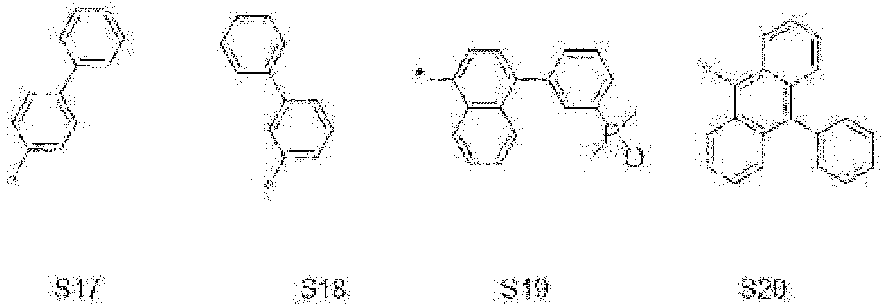

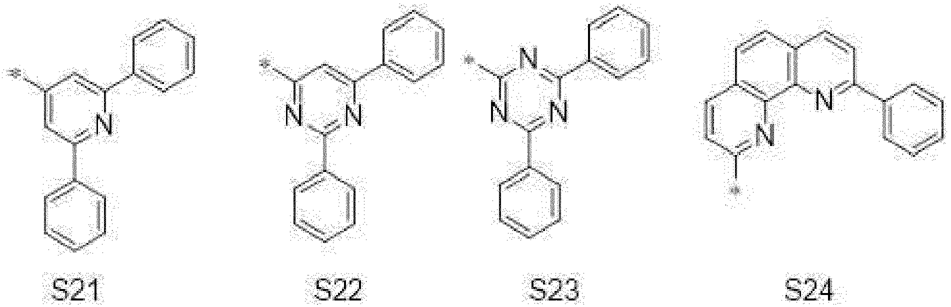

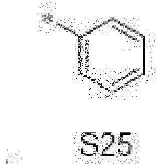

In an embodiment, the host represented by Formula B may be represented by Formula B-1 or Formula B-2:

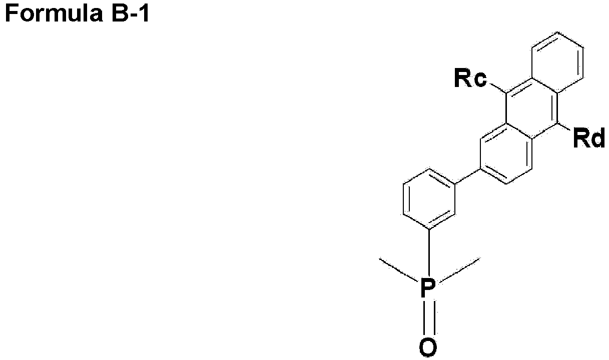

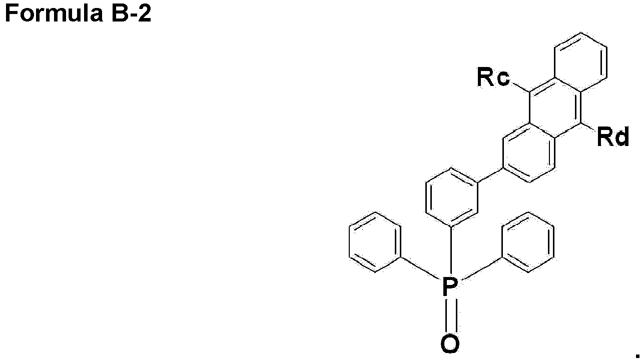

In Formula B-1 and Formula B-2, Rc and Rd are each independently the same as defined in connection with Formula B.

In an embodiment, Rc and Rd in Formula B may each independently be represented by any one among T1 to T4:

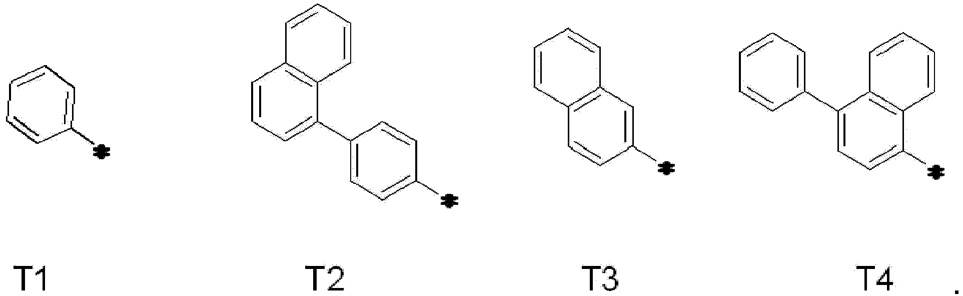

In an embodiment of the present disclosure, a light emitting element includes a first electrode, a hole transport region on the first electrode, an emission layer on the hole transport region, an electron transport region on the emission layer and including an electron transport layer and an electron injection layer on the electron transport layer, and a second electrode on the electron transport region, wherein the electron injection layer includes a host represented by Formula A or Formula B, and a metal dopant, and an absolute value of a difference between a LUMO energy level of the host doped with the metal dopant and a work function energy level of the second electrode is 0.2 eV or less.

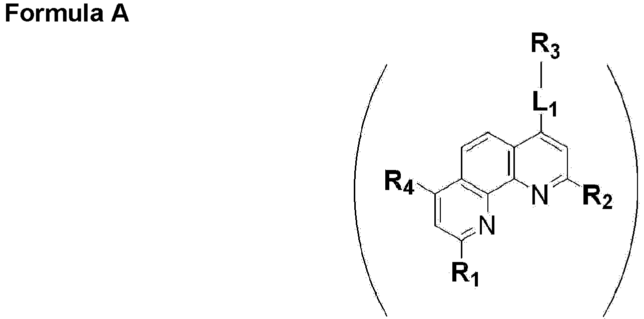

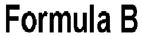

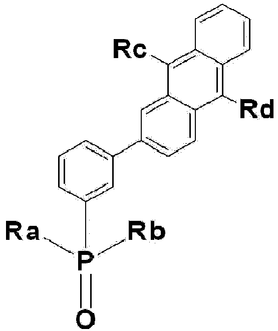

In Formula A, L₁ is a direct linkage, or a substituted or unsubstituted phenylene group, R₁ and R₂ are each independently a hydrogen atom, a substituted or unsubstituted methyl group, or a substituted or unsubstituted phenyl group, R₃ and R₄ are each independently a hydrogen atom, a substituted or unsubstituted aryl group having 6 to 30 ring-forming carbon atoms, or a substituted or unsubstituted heteroaryl group having 2 to 30 ring-forming carbon atoms, and in Formula B, Ra and Rb are each independently a substituted or unsubstituted alkyl group having 1 to 20 carbon atoms, or a substituted or unsubstituted aryl group having 6 to 30 ring-forming carbon atoms, and Rc and Rd are each independently a substituted or unsubstituted aryl group having 6 to 30 ring-forming carbon atoms.

In an embodiment, a binding energy between the host and the metal dopant may be 2.0 eV or more.

In an embodiment, the metal dopant may be Li, Yb, or Bi.
In an embodiment, the metal dopant may be Li, and a volume ratio of the metal dopant to a total volume of the host and the metal dopant in the electron injection layer may be about 3 volume% to about 10 volume%.

In an embodiment, the metal dopant may be Yb, and a volume ratio of the metal dopant to a total volume of the host and the metal dopant in the electron injection layer may be about 5 volume% to about 10 volume%.

In an embodiment, the host represented by Formula A above may be represented by Formula A-1 to Formula A-2:

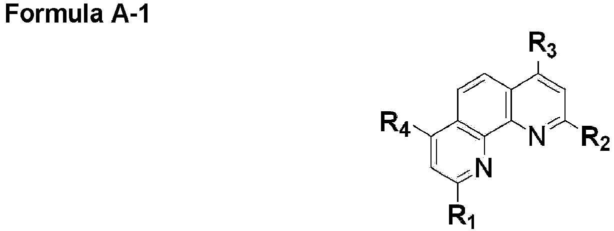

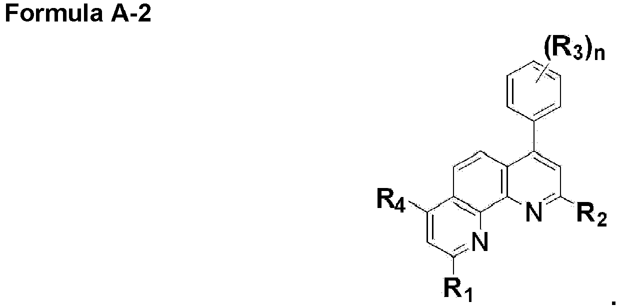

In Formula A-2, n is an integer of 0 to 5, and in Formula A-1 and Formula A-2, the definitions of R₁ to R₄ are each independently the same as defined in connection with Formula A.

In an embodiment, in Formula A-2, R₃ may be represented by any one among compounds S1 to S25:

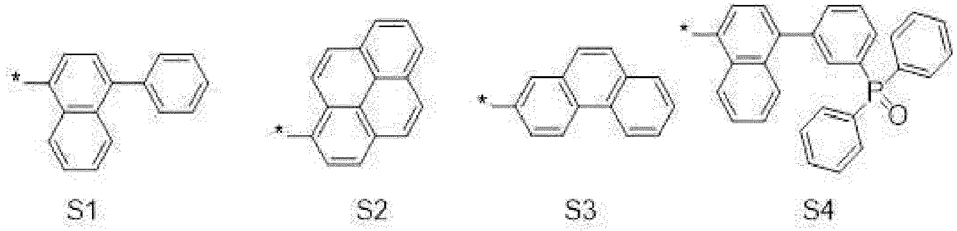

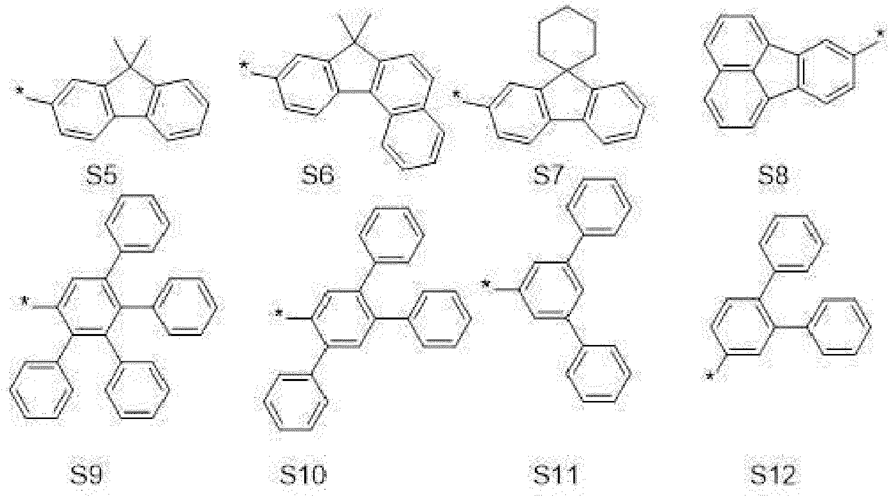

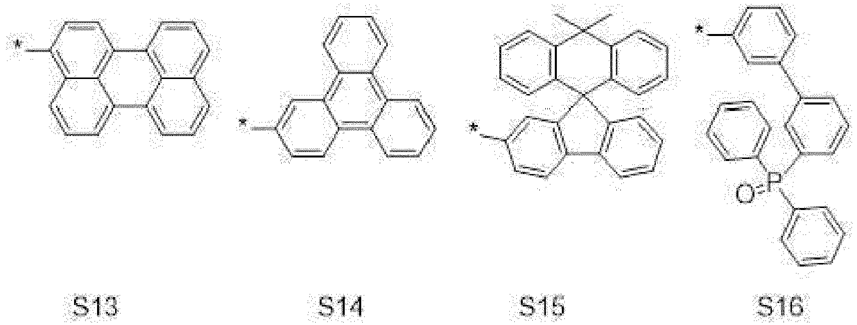

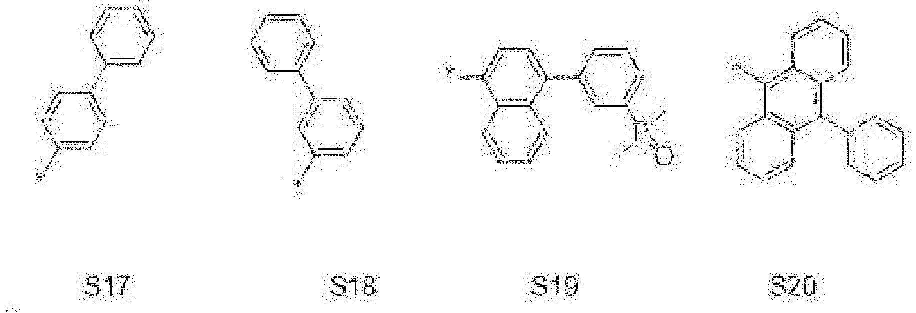

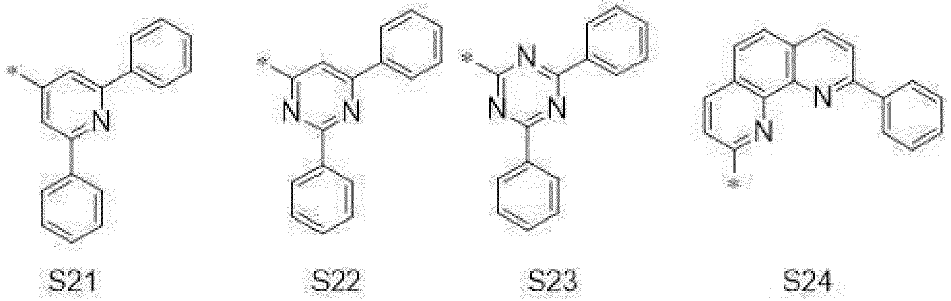

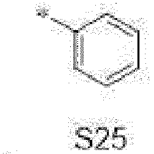

In an embodiment, in Formula B, Ra and Rb may each independently be an unsubstituted methyl group or an unsubstituted phenyl group.

In an embodiment, in Formula B, Rc and Rd may each independently be a substituted or unsubstituted phenyl group, or a substituted or unsubstituted naphthyl group.

In an embodiment of the present disclosure, a light emitting element includes a first electrode, a second electrode facing the first electrode, a plurality of light emitting structures between the first and second electrodes and each including a hole transport region, an emission layer on the hole transport region, and an electron transport region on the emission layer, and a charge generation layer between neighboring light emitting structures, wherein the electron transport region of a light emitting structure adjacent to the second electrode among the plurality of light emitting structures includes an electron transport layer and an electron injection layer disposed between the electron transport layer and the second electrode, the electron injection layer includes a host represented by Formula A or Formula B, and a metal dopant, and an absolute value of a difference between a LUMO energy level of the host doped with the metal dopant and a work function energy level of the second electrode is about 0.2 eV or less.

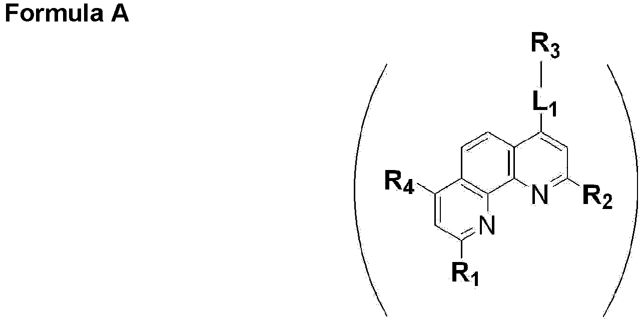

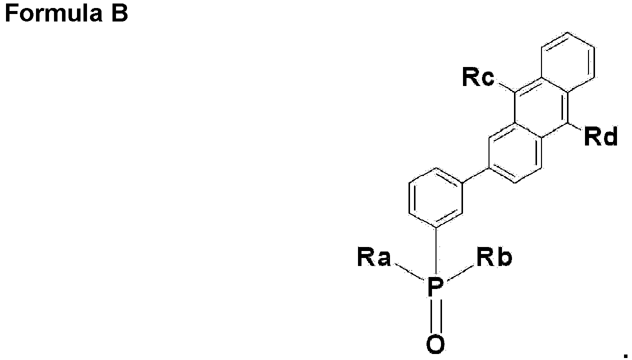

In Formula A, L₁ is a direct linkage, or a substituted or unsubstituted phenylene group, R₁ and R₂ are each independently a hydrogen atom, a substituted or unsubstituted methyl group, or a substituted or unsubstituted phenyl group, R₃ and R₄ may each independently be a hydrogen atom, a substituted or unsubstituted aryl group having 6 to 30 ring-forming carbon atoms, or a substituted or unsubstituted heteroaryl group having 2 to 30 ring-forming carbon atoms, and in Formula B, Ra and Rb are each independently a substituted or unsubstituted alkyl group having 1 to 20 carbon atoms, or a substituted or unsubstituted aryl group having 6 to 30 ring-forming carbon atoms, and Rc and Rd are each independently a substituted or unsubstituted aryl group having 6 to 30 ring-forming carbon atoms.

In an embodiment, the metal dopant may include Ag, Bi, Mg, Li, Yb, Cu, La, Pr, Nd, Pm, Sm, Eu, Gd, Tb, Dy, Ho, Er, Tm, or Lu.

In an embodiment, a binding energy between the host and the metal dopant may be 2.0 eV or more.

At least some of the above and other features of the invention are set out in the claims.

### BRIEF DESCRIPTION OF THE FIGURES

The accompanying drawings are included to provide a further understanding of the present disclosure, and are incorporated in and constitute a part of this specification. The drawings illustrate example embodiments of the present disclosure and, together with the description, serve to explain principles of the present disclosure. In the drawings:
FIG. 1 is a plan view illustrating a display device according to an embodiment of the present disclosure;
FIG. 2 is a cross-sectional view of a display device according to an embodiment of the present disclosure;
FIG. 3 is a cross-sectional view schematically illustrating a light emitting element according to an embodiment of the present disclosure;
FIG. 4 is a cross-sectional view schematically illustrating a light emitting element according to an embodiment of the present disclosure;
FIG. 5 is a cross-sectional view schematically illustrating a light emitting element according to an embodiment of the present disclosure;
FIG. 6 is a cross-sectional view schematically illustrating a light emitting element according to an embodiment of the present disclosure;
FIG. 7 is a cross-sectional view of a display device according to an embodiment of the present disclosure;
FIG. 8 is a cross-sectional view of a display device according to an embodiment of the present disclosure;
FIG. 9 is a cross-sectional view schematically illustrating a light emitting element according to an embodiment of the present disclosure;
FIG. 10A is a graph showing a change in a driving voltage of a light emitting element over time, the light emitting element having a binding energy between a metal dopant and a host contained in an electron injection layer of about 2.30 eV; and
FIG. 10B is a graph showing a change in a driving voltage of a light emitting element over time, the light emitting element having a binding energy between a metal dopant and a host contained in an electron injection layer of about 1.09 eV.

### DETAILED DESCRIPTION

The subject matter of the present disclosure may be modified in many alternate forms, and thus specific embodiments will be shown in the drawings and described in more detail. It should be understood, however, that it is not intended to limit the subject matter of the present disclosure to the particular forms disclosed, but rather, is intended to cover all modifications, equivalents, and alternatives falling within the scope of the present disclosure, and equivalents thereof.

When explaining each of the drawings, like reference numbers are used for referring to like elements. In the accompanying drawings, the dimensions of each structure may be exaggeratingly illustrated for clarity. It will be understood that, although the terms "first," "second," etc. may be used herein to describe various components, these components should not be limited by these terms. These terms are only used to distinguish one component from another. For example, a first component may be referred to as a second component, and, similarly, the second component may be referred to as the first component, without departing from the scope of the present disclosure. As used herein, the singular forms, "a", "an" and "the" are intended to include the plural forms as well, unless the context clearly indicates otherwise.

In the present description, it will be understood that the terms "include," "have" etc., specify the presence of a feature, a fixed number, a step, an operation, an element, a component, or a combination thereof disclosed in the specification, but do not exclude the possibility of presence or addition of one or more other features, fixed numbers, steps, operations, elements, components, or any combination thereof.

In the present description, when a part such as a layer, a film, a region, or a plate is referred to as being "on" or "above" another part, it can be directly on the other part, or an intervening part may also be present. In contrast, when a part such as a layer, a film, a region, or a plate is referred to as being "under" or "below" another part, it can be directly under the other part, or an intervening part may also be present. In addition, it will be understood that when a part is referred to as being "on" another part, it can be disposed on the other part, or disposed under the other part as well.

In the specification, the term "substituted or unsubstituted" may refer to a functional group that is unsubstituted or substituted with at least one substituent selected from the group consisting of a deuterium atom, a halogen atom, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, an alkoxy group, a hydrocarbon ring group, an aryl group, and a heterocyclic group. In some embodiments, each of the substituents described above may be substituted or unsubstituted. For example, a biphenyl group may be interpreted as an aryl group or a phenyl group substituted with a phenyl group.

In the specification, the phrase "bonded to an adjacent group to form a ring" may indicate that a group is bonded to an adjacent group to form a substituted or unsubstituted hydrocarbon ring, or a substituted or unsubstituted heterocycle. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be monocyclic or polycyclic. In some embodiments, the rings formed by adjacent groups being bonded to each other may be connected to another ring to form a spiro structure.

In the specification, the term "adjacent group" may refer to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as "adjacent groups" to each other and two ethyl groups in 1,1-diethylcyclopentane may be interpreted as "adjacent groups" to each other. In addition, two methyl groups in 4,5-dimethylphenanthrene may be interpreted as "adjacent groups" to each other.

In the specification, examples of the halogen atom may include a fluorine atom, a chlorine atom, a bromine atom, or an iodine atom.

In the specification, the alkyl group may be a linear, branched or cyclic alkyl group. The number of carbon atoms in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a cyclopentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, a cyclohexyl group, a 4-methylcyclohexyl group, a 4-t-butylcyclohexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, a cyclooctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, etc., but the embodiment of the present disclosure is not limited thereto.

In the specification, the alkyl group may be linear or branched. The number of carbon atoms in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, etc., but the embodiment of the present disclosure is not limited thereto.

In the specification, a cycloalkyl group may refer to a cyclic alkyl group. The number of carbon atoms in the cycloalkyl group may be 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, etc., but the embodiment of the present disclosure is not limited thereto.

In the specification, an alkenyl group refers to a hydrocarbon group including at least one carbon-carbon double bond in the middle and/or at a terminal end of an alkyl group having 2 or more carbon atoms. The alkenyl group may be a linear chain or a branched chain. The carbon number is not specifically limited, but may be 2 to 30, 2 to 20 or 2 to 10. Examples of the alkenyl group may include a vinyl group, a 1-butenyl group, a 1-pentenyl group, a 1,3-butadienyl aryl group, a styrenyl group, a styrylvinyl group, etc., without limitation.

In the specification, an alkynyl group refers to a hydrocarbon group including at least one carbon-carbon triple bond in the middle and/or at a terminal end of an alkyl group having 2 or more carbon atoms. The alkynyl group may be a linear chain or a branched chain. The carbon number is not specifically limited, but may be 2 to 30, 2 to 20 or 2 to 10. Examples of the alkynyl group may include an ethynyl group, a propynyl group, etc., without limitation.

The term "hydrocarbon ring group" as used herein may refer to any functional group or substituent derived from an aliphatic hydrocarbon ring. The hydrocarbon ring group may be a saturated hydrocarbon ring group having 5 to 20 ring-forming carbon atoms.

In the specification, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 36, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, etc., but the embodiment of the present disclosure is not limited thereto.

In the specification, the fluorenyl group may be substituted, and two substituents may be bonded to each other to form a spiro structure. Examples of cases where the fluorenyl group is substituted may be as follows. However, the embodiment of the present disclosure is not limited thereto.

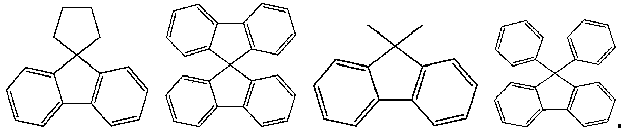

The term "heterocyclic group" as used herein may refer to any functional group or substituent derived from a ring including at least one of B, O, N, P, Si, and Se as a ring-forming heteroatom. The heterocyclic group may include an aliphatic heterocyclic group and an aromatic heterocyclic group. The aromatic heterocyclic group may be a heteroaryl group. The aliphatic heterocycle and the aromatic heterocycle may be monocyclic or polycyclic.

In the specification, the heterocyclic group may include at least one of B, O, N, P, Si and S as a ring-forming heteroatom. When the heterocyclic group includes two or more heteroatoms, the two or more heteroatoms may be the same as or different from each other. The heterocyclic group may be a monocyclic heterocyclic group or a polycyclic heterocyclic group and may include a heteroaryl group. The number of ring-forming carbon atoms in the heterocyclic group may be 2 to 30, 2 to 20, or 2 to 10.

In the specification, the aliphatic heterocyclic group may include one or more among B, O, N, P, Si, and S as a ring-forming heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, etc., but the embodiment of the present disclosure is not limited thereto.

The heteroaryl group as used herein may include at least one of B, O, N, P, Si, and S as a ring-forming heteroatom. When the heteroaryl group contains two or more heteroatoms, the two or more heteroatoms may be the same as or different from each other. The heteroaryl group may be a monocyclic heteroaryl group or a polycyclic heteroaryl group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a triazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, etc., but the embodiment of the present disclosure is not limited thereto.

In the specification, the above description of the aryl group may be applied to an arylene group except that the arylene group is a divalent group. The above description of the heteroaryl group may be applied to a heteroarylene group except that the heteroarylene group is a divalent group.

In the specification, a silyl group includes an alkylsilyl group and an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., but the embodiment of the present disclosure is not limited thereto.

In the specification, the number of carbon atoms in an amino group is not specifically limited, but may be 1 to 30. The amino group may include an alkyl amino group, an aryl amino group, or a heteroaryl amino group. Examples of the amino group may include a methylamino group, a dimethylamino group, a phenylamino group, a diphenylamino group, a naphthylamino group, a 9-methyl-anthracenylamino group, a triphenylamino group, etc., but are not limited thereto.

In the specification, the number of ring-forming carbon atoms in the carbonyl group is not specifically limited, but may be 1 to 40, 1 to 30, or 1 to 20. For example, the carbonyl group may have the following structures, but the embodiment of the present disclosure is not limited thereto.

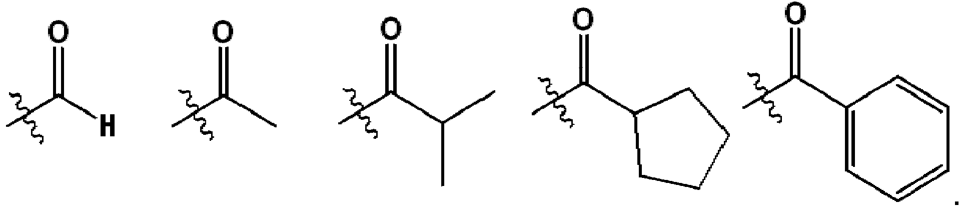

In the specification, the number of carbon atoms in a sulfinyl group and a sulfonyl group is not particularly limited, but may be 1 to 30. The sulfinyl group may include an alkyl sulfinyl group and an aryl sulfinyl group. The sulfonyl group may include an alkyl sulfonyl group and an aryl sulfonyl group.

In the specification, a thio group may include an alkylthio group and an arylthio group. The thio group may refer to that a sulfur atom is bonded to the alkyl group or the aryl group as defined above. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, but the embodiment of the present disclosure is not limited thereto.

In the specification, an oxy group may refer to that an oxygen atom is bonded to the alkyl group or the aryl group as defined above. The oxy group may include an alkoxy group and an aryl oxy group. The alkoxy group may be a linear chain, a branched chain or a ring chain. The number of carbon atoms in the alkoxy group is not specifically limited, but may be, for example, 1 to 20 or 1 to 10. Examples of the oxy group may include a methoxy group, an ethoxy group, an n-propoxy group, an isopropoxy group, a butoxy group, a pentyloxy group, a hexyloxy group, an octyloxy group, a nonyloxy group, a decyloxy group, a benzyloxy group, etc., but the embodiment of the present disclosure is not limited thereto.

The boron group as used herein may refer to that a boron atom is bonded to the alkyl group or the aryl group as defined above. The boron group may include an alkyl boron group and an aryl boron group. Examples of the boron group may include a trimethylboron group, a triethylboron group, a t-butyldimethylboron group, a triphenylboron group, a diphenylboron group, a phenylboron group, etc., but the embodiment of the present disclosure is not limited thereto.

In the specification, the number of carbon atoms in an amine group is not specifically limited, but may be 1 to 30. The amine group may include an alkyl amine group and an aryl amine group. Examples of the amine group may include a methylamine group, a dimethylamine group, a phenylamine group, a diphenylamine group, a naphthylamine group, a 9-methyl-anthracenylamine group, a triphenylamine group, etc., but the embodiment of the present disclosure is not limited thereto.

In the specification, the alkyl group in an alkylthio group, an alkylsulfoxy group, an alkylaryl group, an alkylamino group, an alkyl boron group, an alkyl silyl group, and an alkyl amine group is the same as the examples of the alkyl group described above.

In the specification, the aryl group in an aryloxy group, an arylthio group, an arylsulfoxy group, an arylamino group, an arylboron group, an arylsilyl group, and an arylamine group is the same as the examples of the aryl group described above.

In the specification, the phosphine oxide group may be substituted with, for example, at least one of the alkyl groups or aryl groups described above.

In the specification, the phosphine sulfide group may be substituted with, for example, at least one of the alkyl groups or aryl groups described above.

The term "a direct linkage" as used herein may refer to a single bond (e.g., a single covalent bond).

In the specification, 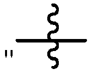 and 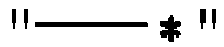 each refer to a position to be connected.

Hereinafter, a light emitting element and a display device according to an embodiment of the present disclosure will be described with reference to the drawings.

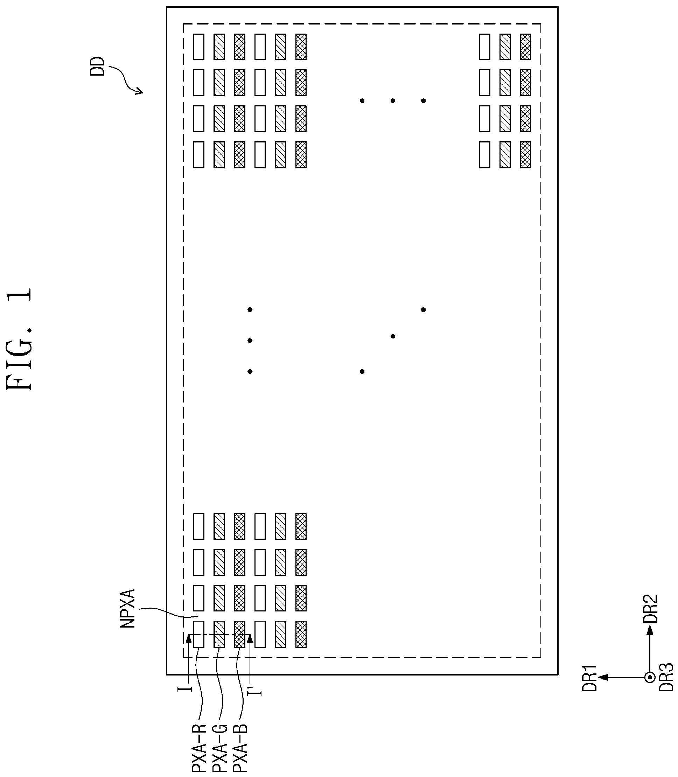

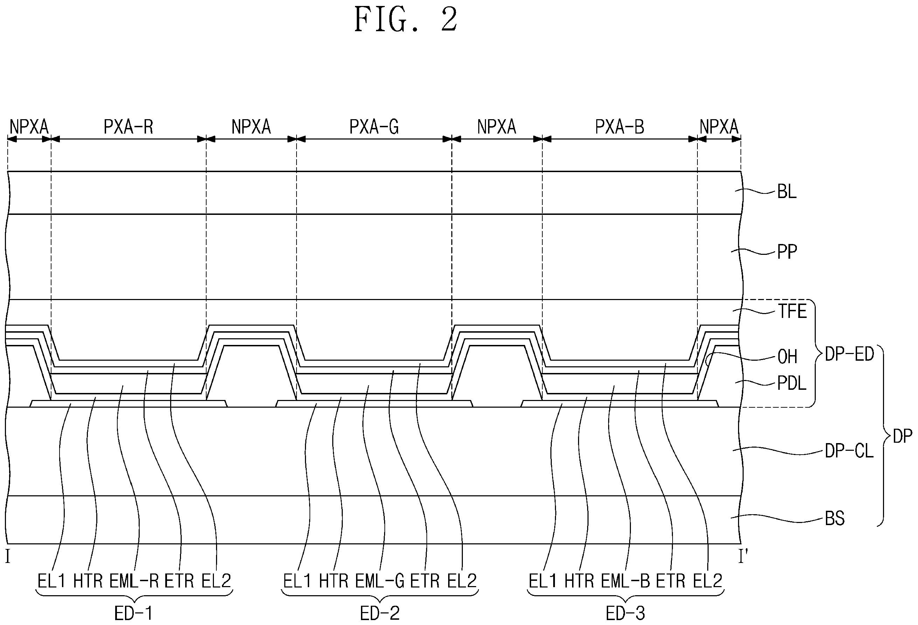

FIG. 1 is a plan view illustrating a display device DD according to an embodiment. FIG. 2 is a cross-sectional view of the display device DD of the embodiment. FIG. 2 is a cross-sectional view illustrating a portion corresponding to the line I-I' of FIG. 1.

The display device DD may include a display panel DP and an optical layer PP disposed on the display panel DP. For example, an organic light emitting display panel may be applied to the display panel DP. The following embodiment illustrates the case in which the organic light emitting display panel is applied as the display panel DP, but the embodiment of the present disclosure is not limited thereto, other kinds of display panel, such as a liquid crystal display, a quantum dot organic light emitting display panel, a quantum dot liquid crystal display, a quantum dot nano-light emitting display panel, and/or a micro LED, may be applied.

The display panel DP includes light emitting elements ED-1, ED-2, and ED-3. The display device DD may include a plurality of light emitting elements ED-1, ED-2, and ED-3. The optical layer PP may be disposed on the display panel DP and control reflected light in the display panel DP due to external light. The optical layer PP may include, for example, a polarization layer and/or a color filter layer. In some embodiments, unlike the view illustrated in the drawing, the optical layer PP may not be provided in the display device DD of an embodiment.

A base substrate BL may be disposed on the optical layer PP. The base substrate BL may be a member which provides a base surface on which the optical layer PP is disposed. The base substrate BL may be a glass substrate, a metal substrate, a plastic substrate, etc. However, the embodiment of the present disclosure is not limited thereto, and the base substrate BL may be an inorganic layer, an organic layer, or a composite material layer. In some embodiments, unlike the one shown, the base substrate BL may not be provided.

The display device DD according to an embodiment may further include a filling layer. The filling layer may be disposed between a display element layer DP-ED and the base substrate BL. The filling layer may be an organic material layer. The filling layer may include at least one of an acrylic-based resin, a silicone-based resin, and an epoxy-based resin.

The display panel DP may include a base layer BS, a circuit layer DP-CL provided on the base layer BS, and the display element layer DP-ED. The display element layer DP-ED may include a pixel defining film PDL, the light emitting elements ED-1, ED-2, and ED-3 disposed between portions of the pixel defining film PDL, and an encapsulation layer TFE disposed on the light emitting elements ED-1, ED-2, and ED-3.

The base layer BS may be a member which provides a base surface on which the display element layer DP-ED is disposed. The base layer BS may be a glass substrate, a metal substrate, a plastic substrate, etc. However, the embodiment of the present disclosure is not limited thereto, and the base layer BS may be an inorganic layer, an organic layer, or a composite material layer.

In an embodiment, the circuit layer DP-CL is disposed on the base layer BS, and the circuit layer DP-CL may include a plurality of transistors. Each of the transistors may include a control electrode, an input electrode, and an output electrode. For example, the circuit layer DP-CL may include a switching transistor and a driving transistor in order to drive the light emitting elements ED-1, ED-2, and ED-3 of the display element layer DP-ED.

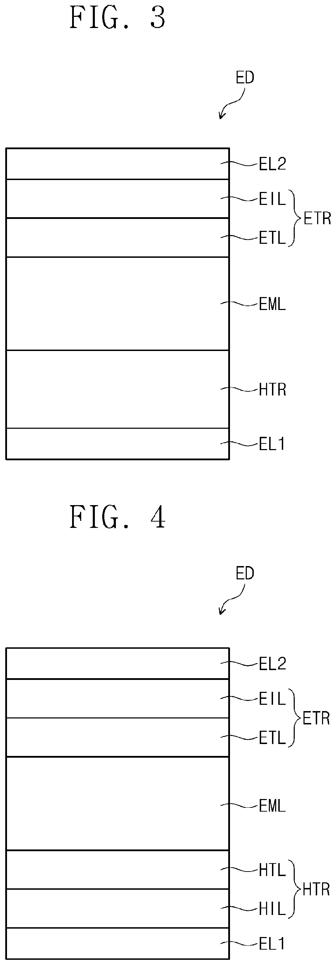

Each of the light emitting elements ED-1, ED-2, and ED-3 may have a structure of a light emitting element ED of an embodiment according to FIGS. 3 to 6, which will be described in more detail later. Each of the light emitting elements ED-1, ED-2 and ED-3 may include a first electrode EL1, a hole transport region HTR, at least one emission layer among emission layers EML-R, EML-G and EML-B (e.g., a corresponding one of the emission layer EML-R, the emission layer EML-G, or the emission layer EML-B), an electron transport region ETR, and a second electrode EL2.

FIG. 2 illustrates an embodiment in which the emission layers EML-R, EML-G, and EML-B of the light emitting elements ED-1, ED-2, and ED-3 are disposed in the openings OH defined in the pixel defining film PDL, and the hole transport region HTR, the electron transport region ETR, and the second electrode EL2 are provided as a common layer in the entire light emitting elements ED-1, ED-2, and ED-3. However, the embodiment of the present disclosure is not limited thereto, and unlike (different from) the feature illustrated in FIG. 2, the hole transport region HTR and the electron transport region ETR in an embodiment may be provided by being patterned inside the opening OH defined in the pixel defining film PDL. For example, the hole transport region HTR, the emission layers EML-R, EML-G, and EML-B, and the electron transport region ETR of the light emitting elements ED-1, ED-2, and ED-3 in an embodiment may be provided by being patterned through an inkjet printing method.

The encapsulation layer TFE may cover the light emitting elements ED-1, ED-2 and ED-3. The encapsulation layer TFE may seal the display element layer DP-ED. The encapsulation layer TFE may be a thin film encapsulation layer. The encapsulation layer TFE may be formed as one layer or by laminating a plurality of layers. The encapsulation layer TFE includes at least one insulation layer. The encapsulation layer TFE according to an embodiment may include at least one inorganic film (hereinafter, an encapsulation-inorganic film). The encapsulation layer TFE according to an embodiment may also include at least one organic film (hereinafter, an encapsulation-organic film) and at least one encapsulation-inorganic film.

The encapsulation-inorganic film protects the display element layer DP-ED from moisture/oxygen, and the encapsulation-organic film protects the display element layer DP-ED from foreign substances such as dust particles. The encapsulation-inorganic film may include silicon nitride, silicon oxynitride, silicon oxide, titanium oxide, aluminium oxide, and/or the like, but the embodiment of the present disclosure is not particularly limited thereto. The encapsulation-organic film may include an acrylic-based compound, an epoxy-based compound, and/or the like. The encapsulation-organic film may include a photopolymerizable organic material, but the embodiment of the present disclosure is not particularly limited thereto.

The encapsulation layer TFE may be disposed on the second electrode EL2 and may be disposed to fill the opening OH.

Referring to FIGS. 1 and 2, the display device DD may include a non-light emitting region NPXA and light emitting regions PXA-R, PXA-G and PXA-B. The light emitting regions PXA-R, PXA-G and PXA-B may be regions in which light generated by the respective light emitting elements ED-1, ED-2 and ED-3 is emitted. The light emitting regions PXA-R, PXA-G, and PXA-B may be spaced apart from each other on a plane (e.g., in a plan view).

Each of the light emitting regions PXA-R, PXA-G, and PXA-B may be a region divided by the pixel defining film PDL. The non-light emitting regions NPXA may be regions between the adjacent light emitting regions PXA-R, PXA-G, and PXA-B, which correspond to portions of the pixel defining film PDL. In some embodiments, in the specification, the light emitting regions PXA-R, PXA-G, and PXA-B may respectively correspond to pixels. The pixel defining film PDL may divide (e.g., separate) the light emitting elements ED-1, ED-2, and ED-3. The emission layers EML-R, EML-G and EML-B of the light emitting elements ED-1, ED-2 and ED-3 may be disposed in openings OH defined in the pixel defining film PDL and separated from each other.

The light emitting regions PXA-R, PXA-G and PXA-B may be divided into a plurality of groups according to the color of light generated from the light emitting elements ED-1, ED-2 and ED-3. In the display device DD of an embodiment shown in FIGS. 1 and 2, three light emitting regions PXA-R, PXA-G, and PXA-B which emit red light, green light, and blue light, respectively are illustrated. For example, the display device DD of an embodiment may include the red light emitting region PXA-R, the green light emitting region PXA-G, and the blue light emitting region PXA-B that are separated from each other.

In the display device DD according to an embodiment, the plurality of light emitting elements ED-1, ED-2 and ED-3 may emit light (e.g., light beams) having wavelengths different from each other. For example, in an embodiment, the display device DD may include a first light emitting element ED-1 that emits red light, a second light emitting element ED-2 that emits green light, and a third light emitting element ED-3 that emits blue light. For example, the red light emitting region PXA-R, the green light emitting region PXA-G, and the blue light emitting region PXA-B of the display device DD may correspond to the first light emitting element ED-1, the second light emitting element ED-2, and the third light emitting element ED-3, respectively.

However, the embodiment of the present disclosure is not limited thereto, and the first to third light emitting elements ED-1, ED-2, and ED-3 may emit light (e.g., light beams) in substantially the same wavelength range or at least one light emitting element may emit a light (e.g., light beams) in a wavelength range different from the others. For example, the first to third light emitting elements ED-1, ED-2, and ED-3 may all emit blue light.

The light emitting regions PXA-R, PXA-G, and PXA-B in the display device DD according to an embodiment may be arranged in a stripe form. Referring to FIG. 1, the plurality of red light emitting regions PXA-R may be arranged with each other along a second directional axis DR2, the plurality of green light emitting regions PXA-G may be arranged with each other along the second directional axis DR2, and the plurality of blue light emitting regions PXA-B may be arranged with each other along the second directional axis DR2. In some embodiments, the red light emitting region PXA-R, the green light emitting region PXA-G, and the blue light emitting region PXA-B may be alternately arranged in this stated order along a first directional axis DR1.

FIGS. 1 and 2 illustrate that all the light emitting regions PXA-R, PXA-G, and PXA-B have similar areas, but the embodiment of the present disclosure is not limited thereto. Thus, the light emitting regions PXA-R, PXA-G, and PXA-B may have different areas from each other according to the wavelength range of the emitted light. In this case, the areas of the light emitting regions PXA-R, PXA-G, and PXA-B may refer to areas when viewed on a plane defined by the first directional axis DR1 and the second directional axis DR2 (e.g., in a plan view).

In some embodiments, the arrangement form of the light emitting regions PXA-R, PXA-G, and PXA-B is not limited to the feature illustrated in FIG. 1, and the order in which the red light emitting region PXA-R, the green light emitting region PXA-G, and the blue light emitting region PXA-B are arranged may be provided in one or more suitable combinations according to the characteristics of the display quality desired or required in the display device DD. For example, the light emitting regions PXA-R, PXA-G, and PXA-B may be in a pentile (PENTILE)^{®} arrangement form (e.g., an RGBG matrix, RGBG structure, or RGBG matrix structure) or a diamond arrangement form. PENTILE^{®} is a duly registered trademark of Samsung Display Co., Ltd.

In some embodiments, the areas of the light emitting regions PXA-R, PXA-G, and PXA-B may be different from each other. For example, in an embodiment, the area of the green light emitting region PXA-G may be smaller than that of the blue light emitting region PXA-B, but the embodiment of the present disclosure is not limited thereto.

Hereinafter, FIGS. 3 to 6 are cross-sectional views schematically illustrating light emitting devices according to embodiments.

Referring to FIG. 3, each of the light emitting devices ED according to embodiments includes a first electrode EL1, a hole transport region HTR, an emission layer EML, an electron transport region ETR, and a second electrode EL2 that are sequentially stacked. The electron transport region ETR includes an electron transport layer ETL and an electron injection layer EIL disposed between the electron transport layer ETL and the second electrode EL2. The second electrode EL2 may be directly disposed on the electron injection layer EIL.

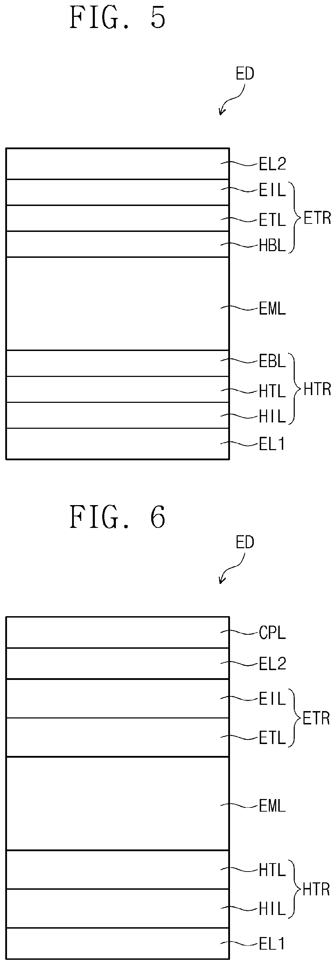

Compared to FIG. 3, FIG. 4 illustrates a cross-sectional view of a light emitting element ED of an embodiment, in which a hole transport region HTR includes a hole injection layer HIL and a hole transport layer HTL. In some embodiments, compared to FIG. 3, FIG. 5 illustrates a cross-sectional view of a light emitting element ED of an embodiment in which a hole transport region HTR includes a hole injection layer HIL, a hole transport layer HTL, and an electron blocking layer EBL, and an electron transport region ETR further includes a hole blocking layer HBL between an electron transport layer ETL and an emission layer EML. Compared to FIG. 4, FIG. 6 illustrates a cross-sectional view of a light emitting element ED of an embodiment further including a capping layer CPL disposed on the second electrode EL2.

The first electrode EL1 has conductivity (e.g., is a conductor). The first electrode EL1 may be formed of a metal material, a metal alloy, or a conductive compound. The first electrode EL1 may be an anode or a cathode. However, the embodiment of the present disclosure is not limited thereto. In some embodiments, the first electrode EL1 may be a pixel electrode. The first electrode EL1 may be a transmissive electrode, a transflective electrode, or a reflective electrode. When the first electrode EL1 is the transmissive electrode, the first electrode EL1 may be formed utilizing a transparent metal oxide such as indium tin oxide (ITO), indium zinc oxide (IZO), zinc oxide (ZnO), and/or indium tin zinc oxide (ITZO). When the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca, LiF/Al, Mo, Ti, W, a compound thereof, or a mixture thereof (e.g., a mixture of Ag and Mg). In some embodiments, the first electrode EL1 may have a multilayer structure including a reflective film or a transflective film formed of the above-described materials, and a transparent conductive film formed of ITO, IZO, ZnO, ITZO, etc. For example, the first electrode EL1 may have a three-layer structure of ITO/Ag/ITO, but the embodiment of the present disclosure is not limited thereto. In some embodiments, the first electrode EL1 may include one or more of the above-described metal materials, combinations of at least two metal materials of the above-described metal materials, one or more oxides of the above-described metal materials, and/or the like. The thickness of the first electrode EL1 may be from about 700 Å to about 10,000 Å. For example, the thickness of the first electrode EL1 may be from about 1,000 Å to about 3,000 Å.

The hole transport region HTR is provided on the first electrode EL1. The hole transport region HTR may include at least one of a hole injection layer HIL, a hole transport layer HTL, a buffer layer, an emission-auxiliary layer, and an electron blocking layer EBL. The thickness of the hole transport region HTR may be, for example, from about 50 Å to about 15,000 Å.

The hole transport region HTR may have a single layer formed of a single material, a single layer formed of a plurality of different materials, or a multilayer structure including a plurality of layers formed of a plurality of different materials.

For example, the hole transport region HTR may have a single layer structure of the hole injection layer HIL or the hole transport layer HTL, or may have a single layer structure formed of a hole injection material and a hole transport material. In some embodiments, the hole transport region HTR may have a single layer structure formed of a plurality of different materials, or a structure in which a hole injection layer HIL/hole transport layer HTL, a hole injection layer HIL/hole transport layer HTL/buffer layer, a hole injection layer HIL/buffer layer, a hole transport layer HTL/buffer layer, or a hole injection layer HIL/hole transport layer HTL/electron blocking layer EBL are stacked in the respective stated order from the first electrode EL1, but the embodiment of the present disclosure is not limited thereto.

The hole transport region HTR may be formed utilizing one or more suitable methods such as a vacuum deposition method, a spin coating method, a cast method, a Langmuir-Blodgett (LB) method, an inkjet printing method, a laser printing method, and/or a laser induced thermal imaging (LITI) method.

The hole transport region HTR may include a compound represented by Formula H-1:

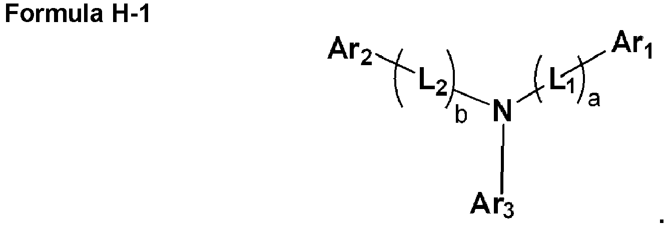

In Formula H-1 above, L₁ and L₂ are each independently a direct linkage, a substituted or unsubstituted arylene group having 6 to 30 ring-forming carbon atoms, or a substituted or unsubstituted heteroarylene group having 2 to 30 ring-forming carbon atoms. a and b are each independently an integer of 0 to 10. In some embodiments, when a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ are each independently a substituted or unsubstituted aryl group having 6 to 30 ring-forming carbon atoms, or a substituted or unsubstituted heteroaryl group having 2 to 30 ring-forming carbon atoms. In some embodiments, in Formula H-1, Ar₃ may be a substituted or unsubstituted aryl group having 6 to 30 ring-forming carbon atoms.

The compound represented by Formula H-1 above may be a monoamine compound (e.g., a compound including a single amine group). In some embodiments, the compound represented by Formula H-1 above may be a diamine compound in which at least one among Ar₁ to Ar₃ includes the amine group as a substituent. In some embodiments, the compound represented by Formula H-1 above may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be represented by any one among the compounds of Compound Group H below. However, the compounds listed in Compound Group H below are examples, and the compounds represented by Formula H-1 are not limited to those represented by Compound Group H below:

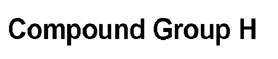

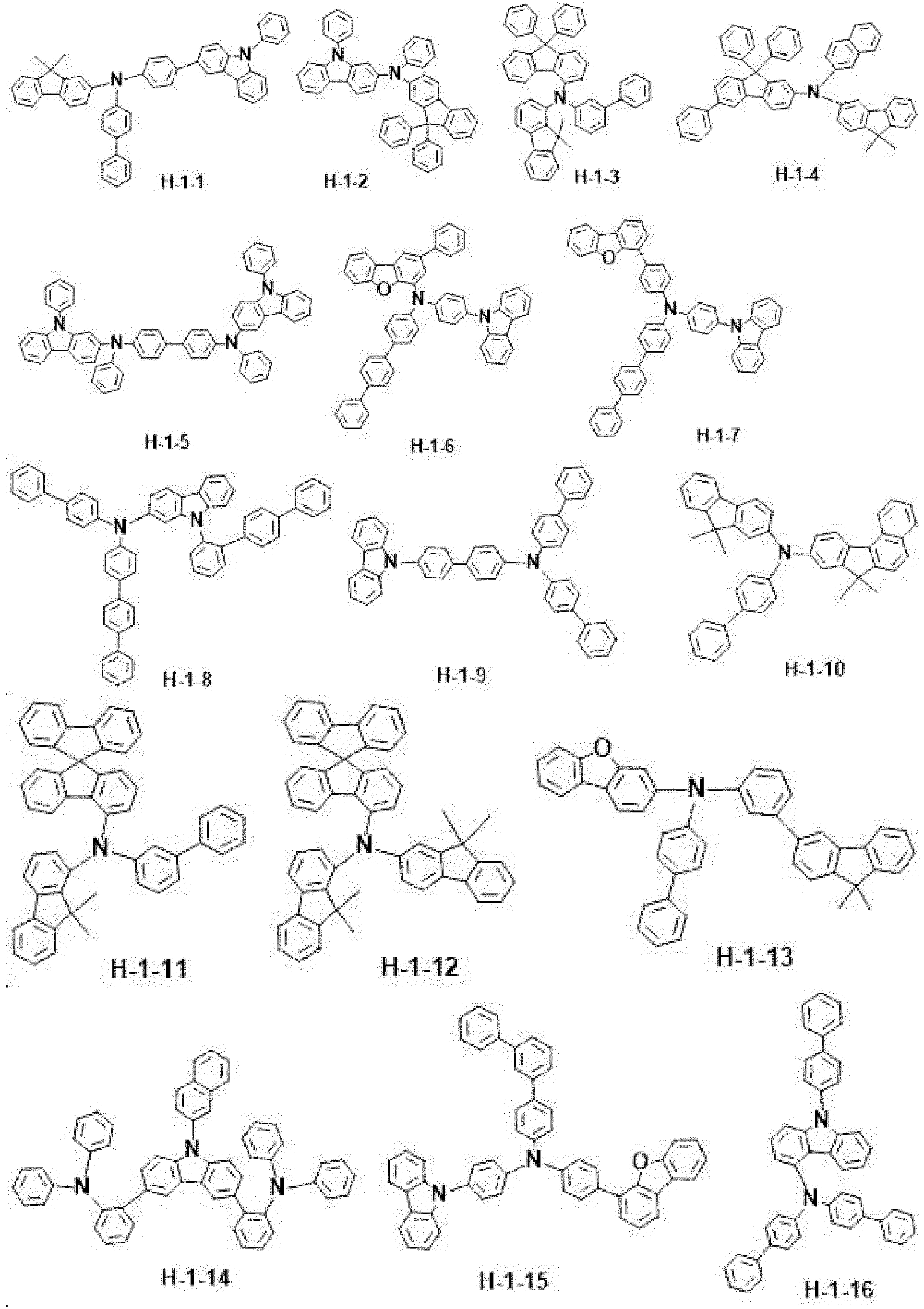

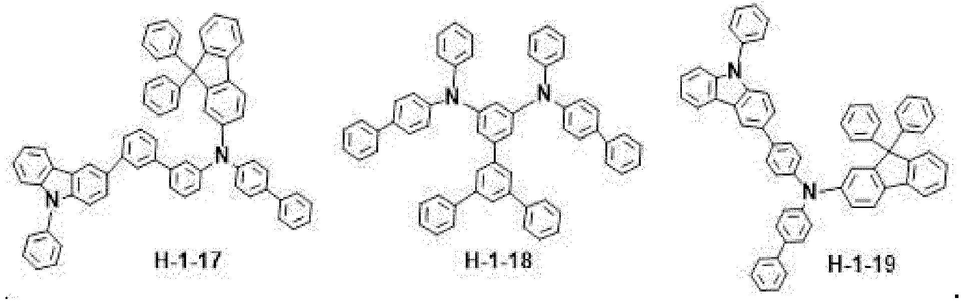

The hole transport region HTR may include a phthalocyanine compound such as copper phthalocyanine; N1,N^{1'}-([1,1'-biphenyl]-4,4'-diyl)bis(N¹-phenyl-N⁴,N⁴-dim-tolylbenzene-1,4-diamine) (DNTPD), 4,4',4"-[tris(3-methylphenyl)phenylamino] triphenylamine (m-MTDATA), 4,4'4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-I-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HATCN), etc.

The hole transport region HTR may include a carbazole-based derivative such as N-phenyl carbazole and/or polyvinyl carbazole, a fluorene-based derivative, N,N'-bis(3-methylphenyl)-N,N'-diphenyl-[1,1-biphenyl]-4,4'-diamine (TPD), a triphenylamine-based derivative such as 4,4',4"-tris(N-carbazolyl)triphenylamine (TCTA), N,N'-di(naphthalene-I-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), etc.

In some embodiments, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), etc.

The hole transport region HTR may include the above-described compounds of the hole transport region in at least one of a hole injection layer HIL, a hole transport layer HTL, and an electron blocking layer EBL.

The thickness of the hole transport region HTR may be from about 100 Å to about 10,000 Å, for example, from about 100 Å to about 5,000 Å. When the hole transport region HTR includes the hole injection layer HIL, the hole injection layer HIL may have, for example, a thickness of about 30 Å to about 1,000 Å. When the hole transport region HTR includes the hole transport layer HTL, the hole transport layer HTL may have a thickness of about 30 Å to about 1,000 Å. For example, when the hole transport region HTR includes the electron blocking layer EBL, the electron blocking layer EBL may have a thickness of about 10 Å to about 1,000 Å. When the thicknesses of the hole transport region HTR, the hole injection layer HIL, the hole transport layer HTL and the electron blocking layer EBL satisfy the above-described ranges, satisfactory hole transport properties may be achieved without a substantial increase in a driving voltage.

The hole transport region HTR may further include a charge generating material to increase conductivity in addition to the above-described materials. The charge generating material may be dispersed uniformly or non-uniformly in the hole transport region HTR. The charge generating material may be, for example, a p-dopant. The p-dopant may include at least one of a halogenated metal compound, a quinone derivative, a metal oxide, and a cyano group-containing compound, but the embodiment of the present disclosure is not limited thereto. For example, the p-dopant may include a metal halide compound such as CuI and/or RbI, a quinone derivative such as tetracyanoquinodimethane (TCNQ) and/or 2,3,5,6-tetrafluoro-7,7,8,8-tetracyanoquinodimethane (F4-TCNQ), a metal oxide such as tungsten oxide and/or molybdenum oxide, a cyano group-containing compound such as dipyrazino[2,3-f: 2',3'-h] quinoxaline-2,3,6,7,10,11-hexacarbonitrile (HATCN), 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), etc., but the embodiment of the present disclosure is not limited thereto.

As described above, the hole transport region HTR may further include at least one of the buffer layer and the electron blocking layer EBL in addition to the hole injection layer HIL and the hole transport layer HTL. The buffer layer may compensate for a resonance distance according to the wavelength of light emitted from the emission layer EML and may thus increase light emission efficiency. A material that may be included in the hole transport region HTR may be utilized as a material to be included in the buffer layer. The electron blocking layer EBL is a layer that serves to prevent or reduce the electron injection from the electron transport region ETR to the hole transport region HTR.

The emission layer EML is provided on the hole transport region HTR. The emission layer EML may have a thickness of, for example, about 100 Å to about 1,000 Å or about 100 Å to about 300 Å. The emission layer EML may have a single layer formed of a single material, a single layer formed of a plurality of different materials, or a multilayer structure having a plurality of layers formed of a plurality of different materials.

In the light emitting element ED of an embodiment, the emission layer EML may include an anthracene derivative, a pyrene derivative, a fluoranthene derivative, a chrysene derivative, a dehydrobenzanthracene derivative, and/or a triphenylene derivative. For example, the emission layer EML may include the anthracene derivative or the pyrene derivative.

In each light emitting element ED of embodiments illustrated in FIGS. 3 to 6, the emission layer EML may include a host and a dopant, and the emission layer EML may include a compound represented by Formula E-1 below. The compound represented by Formula E-1 below may be utilized as a fluorescence host material.

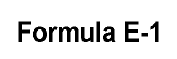

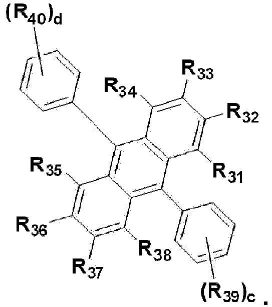

In Formula E-1, R₃₁ to R₄₀ are each independently a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 1 to 10 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In some embodiments, R₃₁ to R₄₀ may be bonded to an adjacent group to form a saturated hydrocarbon ring or an unsaturated hydrocarbon ring, a saturated heterocycle, or an unsaturated heterocycle.

In Formula E-1, c and d are each independently an integer of 0 to 5.

Formula E-1 may be represented by any one among Compound E1 to Compound E19 below:

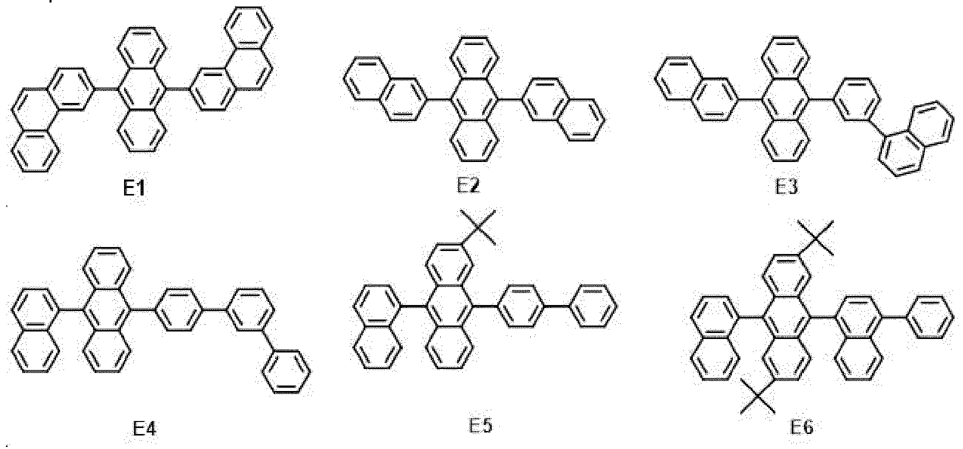

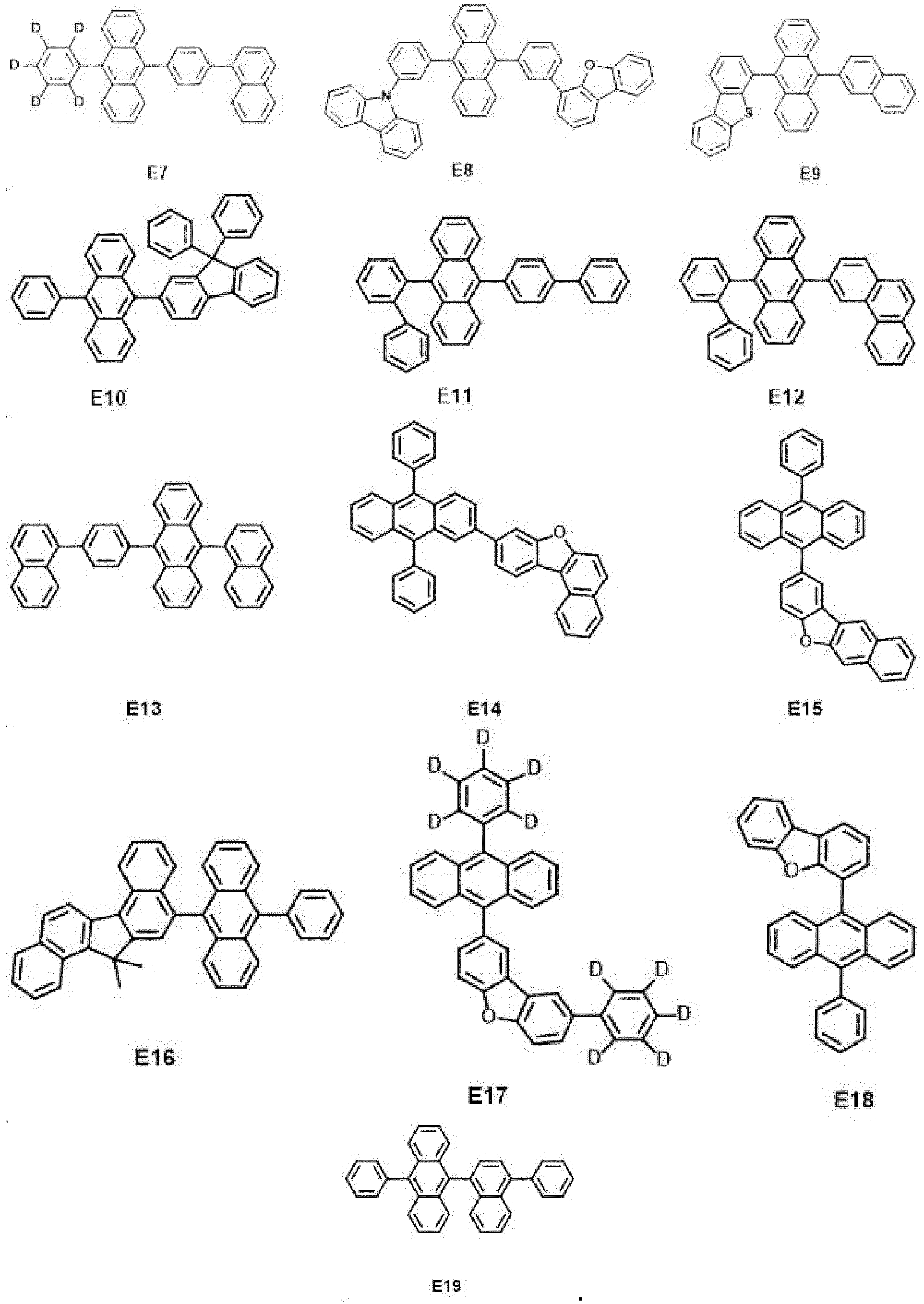

In an embodiment, the emission layer EML may include a compound represented by Formula E-2a or Formula E-2b below. The compound represented by Formula E-2a or Formula E-2b below may be utilized as a phosphorescence host material.

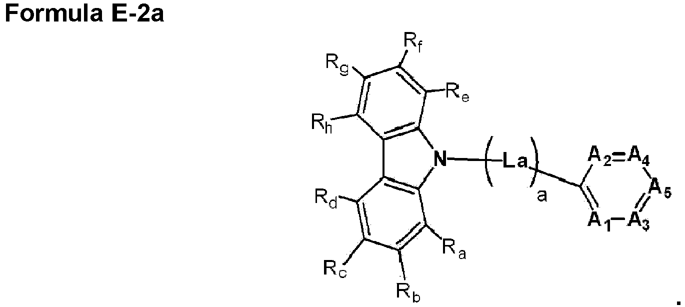

In Formula E-2a, a is an integer of 0 to 10, and Lₐ is a direct linkage, a substituted or unsubstituted arylene group having 6 to 30 ring-forming carbon atoms, or a substituted or unsubstituted heteroarylene group having 2 to 30 ring-forming carbon atoms. In some embodiments, when a is an integer of 2 or more, a plurality of Lₐ's may each independently be a substituted or unsubstituted arylene group having 6 to 30 ring-forming carbon atoms, or a substituted or unsubstituted heteroarylene group having 2 to 30 ring-forming carbon atoms.

In some embodiments, in Formula E-2a, A₁ to A₅ may each independently be N or CRᵢ. Rₐ to Rᵢ are each independently a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. Rₐ to Rᵢ may be bonded to an adjacent group to form a hydrocarbon ring or a heterocycle containing N, O, S, etc. as a ring-forming atom.

In some embodiments, in Formula E-2a, two or three selected from among A₁ to A₅ may be N, and the remainder (e.g., the rest) may be CRᵢ.

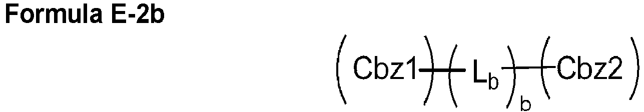

In Formula E-2b, Cbz1 and Cbz2 are each independently an unsubstituted carbazole group, or a carbazole group substituted with an aryl group having 6 to 30 ring-forming carbon atoms. L_{b} is a direct linkage, a substituted or unsubstituted arylene group having 6 to 30 ring-forming carbon atoms, or a substituted or unsubstituted heteroarylene group having 2 to 30 ring-forming carbon atoms. In some embodiments, b is an integer of 0 to 10, and when b is an integer of 2 or more, a plurality of L_{b}'s may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2a or Formula E-2b may be represented by any one among the compounds of Compound Group E-2 below. However, the compounds listed in Compound Group E-2 below are examples, and the compound represented by Formula E-2a or Formula E-2b is not limited to those represented by Compound Group E-2 below:

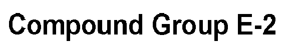

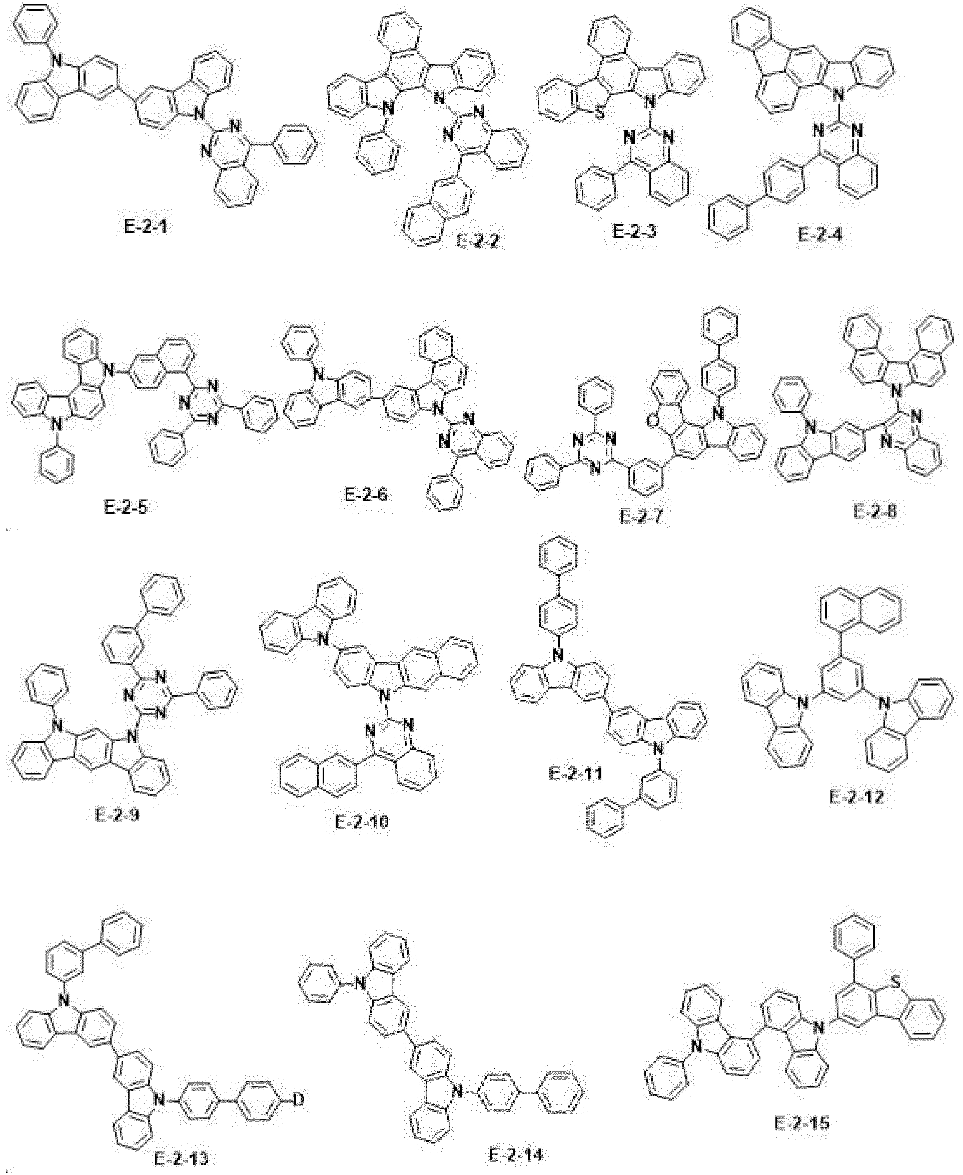

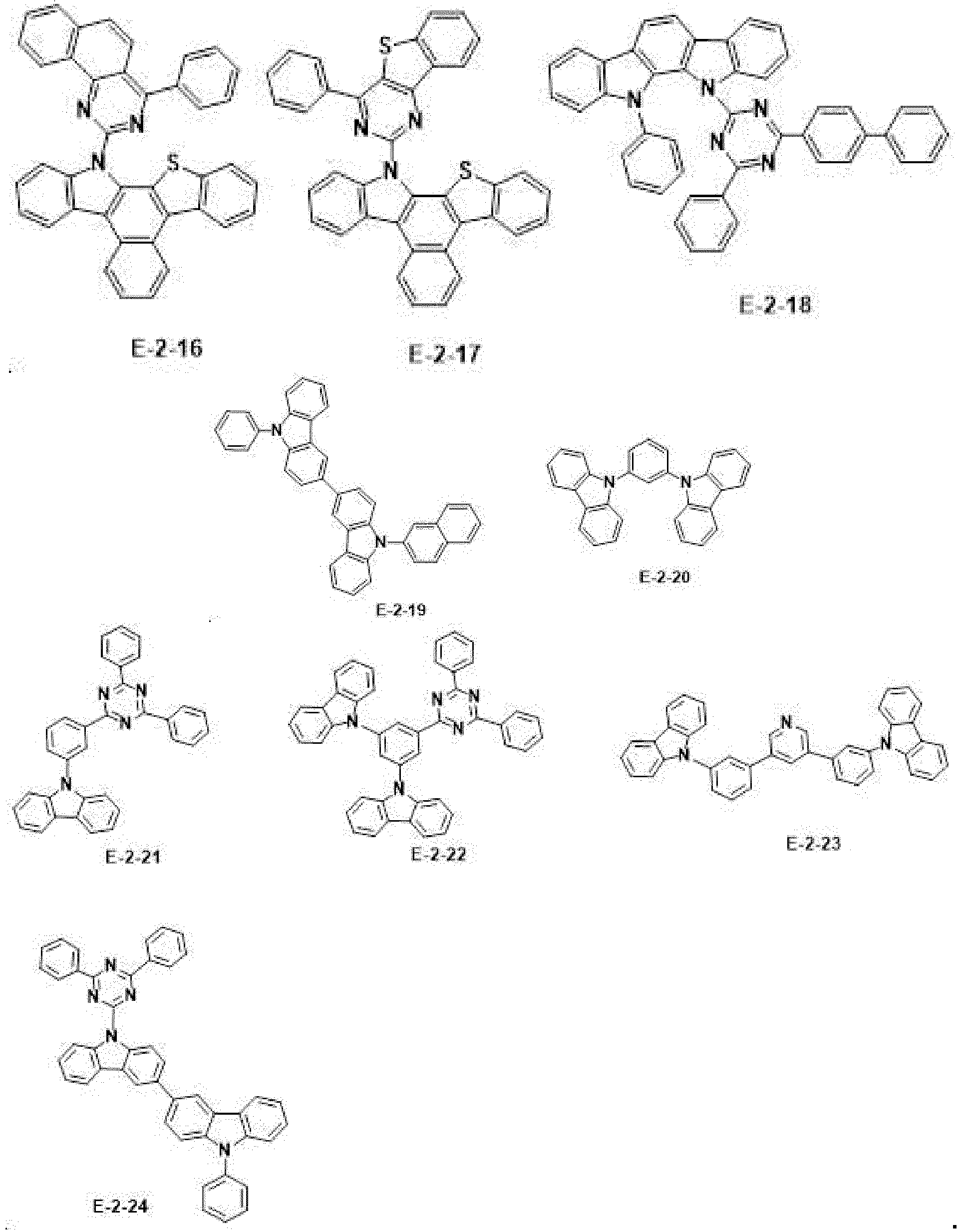

The emission layer EML may further include a material suitable in the art as a host material. For example, the emission layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), or 1,3,5-tris(1-phenyl-1H-benzo[d]imidazole-2-yl)benzene (TPBi). However, the embodiment of the present disclosure is not limited thereto, for example, tris(8-hydroxyquinolino)aluminium (Alq₃), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetrasiloxane (DPSiO₄), etc. may be utilized as a host material.

In an embodiment, the emission layer EML may include a compound represented by Formula M-a or Formula M-b below. The compound represented by Formula M-a or Formula M-b below may be utilized as a phosphorescence dopant material.

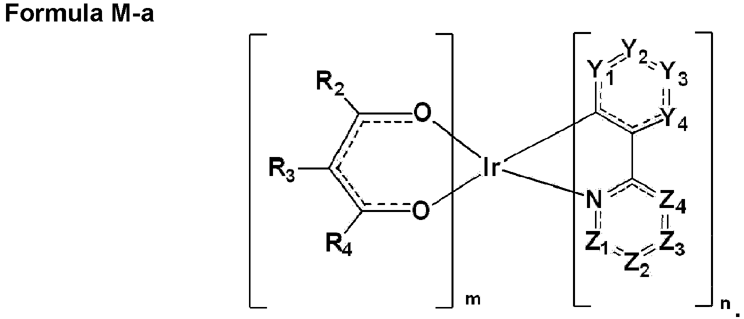

In Formula M-a above, Y₁ to Y₄ and Z₁ to Z₄ are each independently CR₁ or N, and R₁ to R₄ are each independently a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In Formula M-a, m is 0 or 1, and n is 2 or 3. In Formula M-a, when m is 0, n is 3, and when m is 1, n is 2.

The compound represented by Formula M-a may be utilized as a phosphorescence dopant.

The compound represented by Formula M-a may be represented by any one among Compound M-a1 to Compound M-a25 below. However, Compounds M-a1 to M-a25 below are examples, and the compound represented by Formula M-a is not limited to those represented by Compounds M-a1 to M-a25 below.

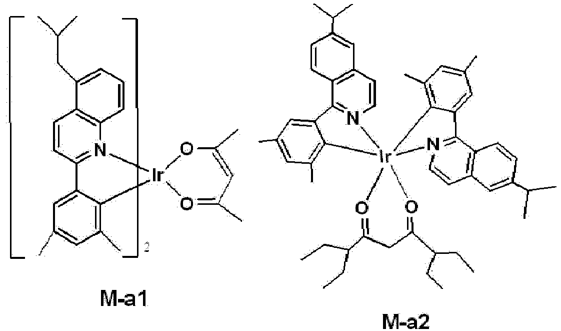

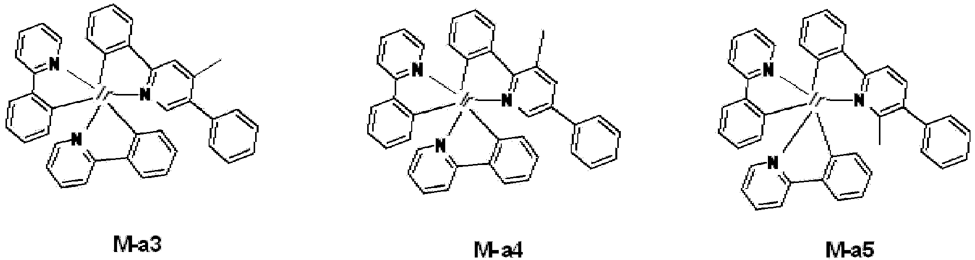

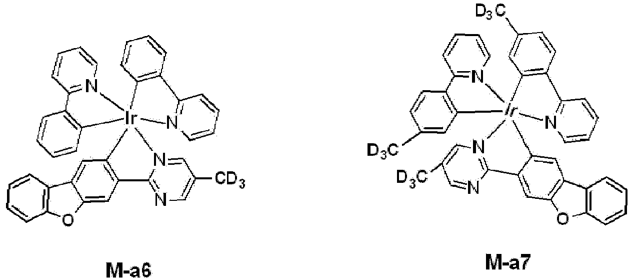

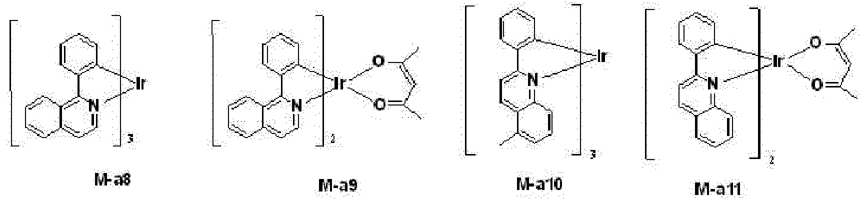

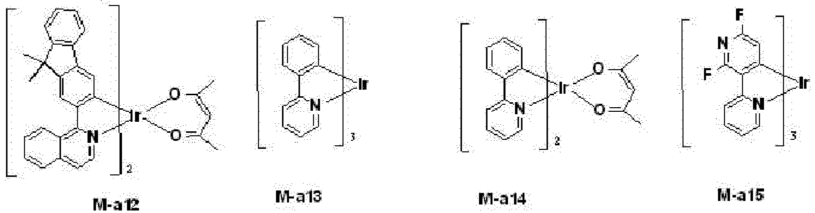

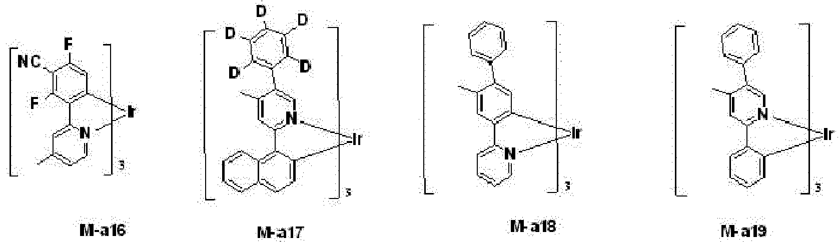

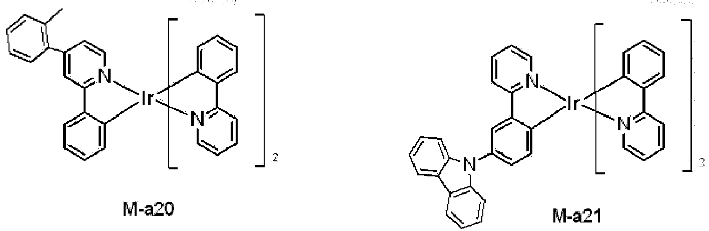

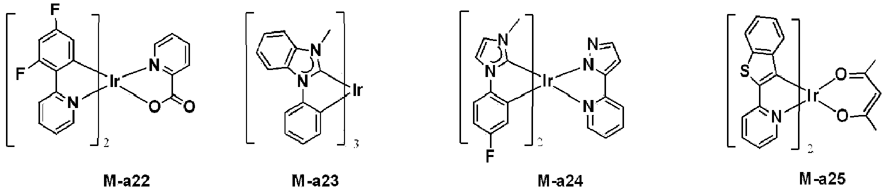

Compound M-a1 and Compound M-a2 may be utilized as a red dopant material, and Compound M-a3 to Compound M-a7 may be utilized as a green dopant material.

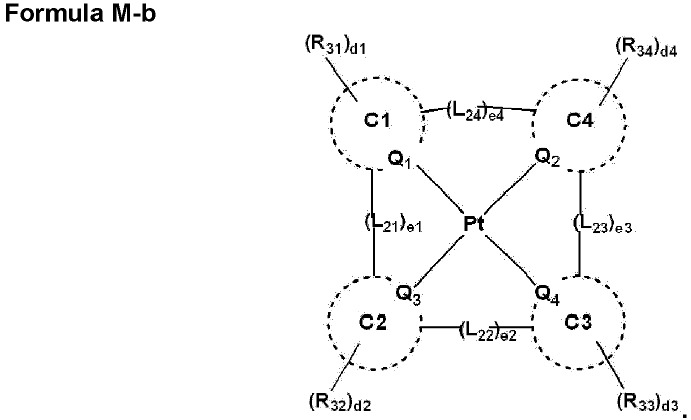

In Formula M-b, Q₁ to Q4 are each independently be C or N, and C1 to C4 are each independently a substituted or unsubstituted hydrocarbon ring having 5 to 30 ring-forming carbon atoms, or a substituted or unsubstituted heterocycle having 2 to 30 ring-forming carbon atoms. L₂₁ to L₂₄ are each independently a direct linkage, 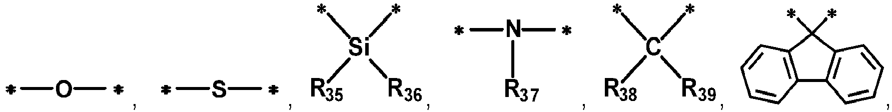 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms, and e1 to e4 are each independently 0 or 1. R₃₁ to R₃₉ are each independently a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or are bonded to an adjacent group to form a ring, and d1 to d4 are each independently an integer of 0 to 4.

The compound represented by Formula M-b may be utilized as a blue phosphorescence dopant or a green phosphorescence dopant.

The compound represented by Formula M-b may be represented by any one among the compounds below. However, the compounds below are presented as examples, and the compound represented by Formula M-b is not limited to those represented by the compounds below.

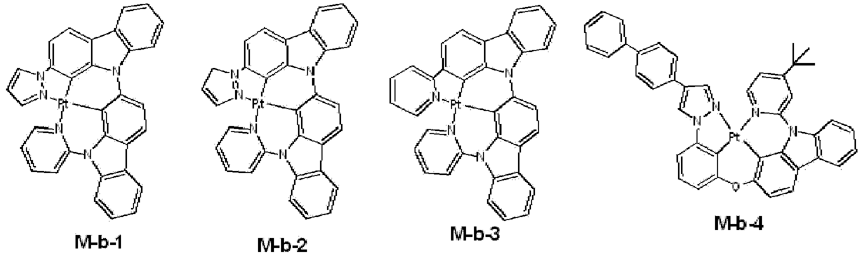

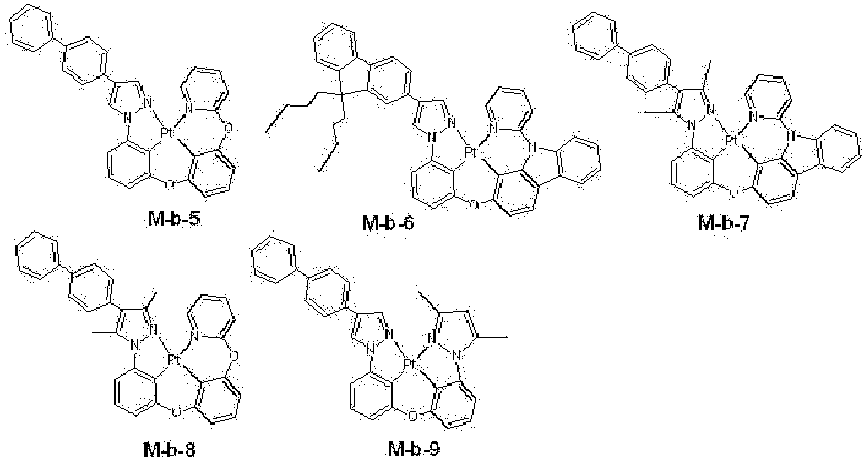

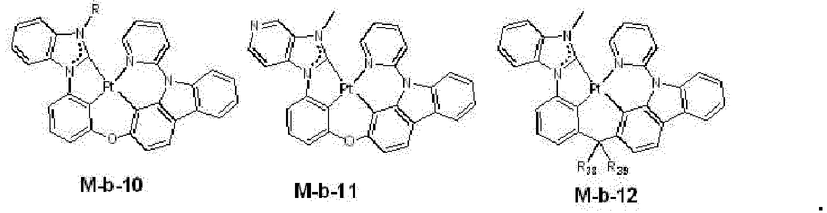

In the compounds above, R, R₃₈, and R₃₉ are each independently a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

The emission layer EML may include a compound represented by any one among Formula F-a to Formula F-c below. The compound represented by Formula F-a to Formula F-c below may be utilized as a fluorescence dopant material.

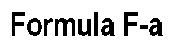

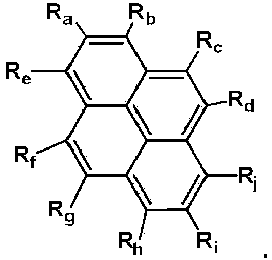

In Formula F-a above, two selected from among Rₐ to Rⱼ are each independently substituted with ∗-NAr₁Ar₂. The others (e.g., the rest of Rₐ to Rⱼ), which are not substituted with ∗-NAr₁Ar₂, among Rₐ to Rⱼ are each independently a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In ∗-NAr₁Ar₂, Ar₁ and Ar₂ are each independently a substituted or unsubstituted aryl group having 6 to 30 ring-forming carbon atoms, or a substituted or unsubstituted heteroaryl group having 2 to 30 ring-forming carbon atoms. For example, at least one of Ar₁ or Ar₂ may be a heteroaryl group containing O or S as a ring-forming atom.

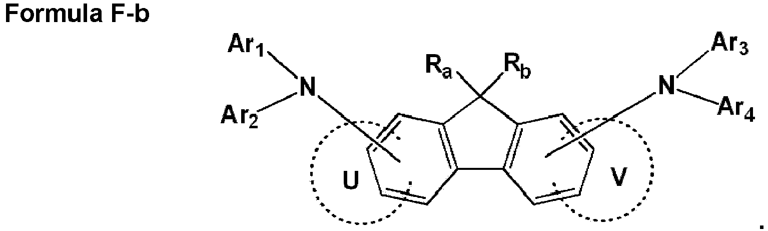

In Formula F-b above, Rₐ and R_{b} are each independently a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring.

In Formula F-b, U and V are each independently a substituted or unsubstituted hydrocarbon ring having 5 to 30 ring-forming carbon atoms, or a substituted or unsubstituted heterocycle having 2 to 30 ring-forming carbon atoms.

In Formula F-b, the number of rings represented by U and V are each independently 0 or 1. For example, in Formula F-b, when the number of U or V is 1, one ring indicated by U or V forms a condensed ring at the designated part (e.g., a portion indicated by U or V), and when the number of U or V is 0, a ring indicated by U or V does not exist. For example, when the number of U is 0 and the number of V is 1, or when the number of U is 1 and the number of V is 0, the condensed ring having a fluorene core in Formula F-b is a cyclic compound having four rings. In some embodiments, when each number of U and V is 0, the condensed ring in Formula F-b is a cyclic compound having three rings. In some embodiments, when each number of U and V is 1, the condensed ring having a fluorene core in Formula F-b is a cyclic compound having five rings.

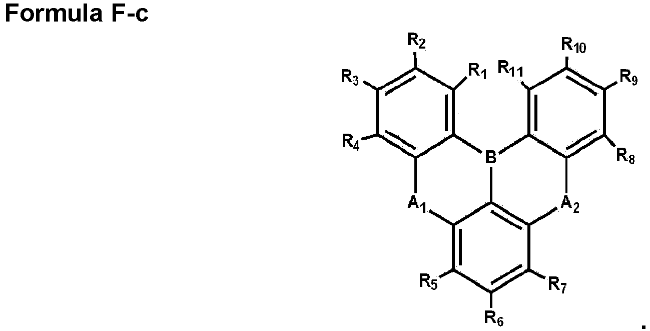

In Formula F-c, A₁ and A₂ are each independently O, S, Se, or NRₘ, and Rₘ is a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ are each independently a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring.

In Formula F-c, A₁ and A₂ may each independently be bonded to substituents of an adjacent ring to form a condensed ring. For example, when A₁ and A₂ may each independently be NRₘ, A₁ may be bonded to R₄ or R₅ to form a ring. In some embodiments, A₂ may be bonded to R₇ or R₈ to form a ring.

In an embodiment, the emission layer EML may include, as a suitable dopant material, a styryl derivative (e.g., 1,4-bis[2-(3-N-ethylcarbazoryl)vinyl]benzene (BCzVB), 4-(di-p-tolylamino)-4'-[(di-p-tolylamino)styryl]stilbene (DPAVB), and/or N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and/or a derivative thereof (e.g., 2,5,8,11-tetra-t-butylperylene (TBP)), pyrene and/or a derivative thereof (e.g., 1,1-dipyrene, 1,4-dipyrenylbenzene, 1,4-bis(N,N-diphenylamino)pyrene), etc.

The emission layer EML may include a suitable phosphorescence dopant material. For example, a metal complex including iridium (Ir), platinum (Pt), osmium (Os), gold (Au), titanium (Ti), zirconium (Zr), hafnium (Hf), europium (Eu), terbium (Tb), and/or thulium (Tm) may be utilized as a phosphorescence dopant. For example, iridium(III) bis(4,6-difluorophenylpyridinato-N,C2') picolinate (FIrpic), bis(2,4-difluorophenylpyridinato)-tetrakis(1-pyrazolyl)borate iridium(III) (Fir6), and/or platinum octaethyl porphyrin (PtOEP) may be utilized as a phosphorescence dopant. However, the embodiment of the present disclosure is not limited thereto.

The emission layer EML may include a quantum dot material. The core of the quantum dot may be selected from a Group II-VI compound, a Group III-VI compound, a Group I-III-VI compound, a Group III-V compound, a Group III-II-V compound, a Group IV-VI compound, a Group IV element, a Group IV compound, or a combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a mixture thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The Group III-VI compound may include a binary compound such as In₂S₃ and/or In₂Se₃, a ternary compound such as InGaS₃ and/or InGaSe₃, or any combination thereof.

The Group I-III-VI compound may be selected from a ternary compound selected from the group consisting of AglnS, AgInS₂, CuInS, CuInS₂, AgGaS₂, CuGaS₂ CuGaO₂, AgGaO₂, AgAlO₂, and a mixture thereof, and a quaternary compound such as AgInGaS₂ and/or CuInGaS₂.

The Group III-V compound may be selected from the group consisting of a binary compound selected from the group consisting of GaN, GaP, GaAs, GaSb, AIN, AlP, AlAs, AlSb, InN, InP, InAs, InSb, and a mixture thereof; a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof; and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. In some embodiments, the Group III-V compound may further include a Group II metal. For example, InZnP, etc. may be selected as a Group III-II-V compound.

The Group IV-VI compound may be selected from the group consisting of a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof. The Group IV element may be selected from the group consisting of Si, Ge, and a mixture thereof. The Group IV compound may be a binary compound selected from the group consisting of SiC, SiGe, and a mixture thereof.

In this case, the binary compound, the ternary compound, or the quaternary compound may be present in particles in a substantially uniform concentration distribution, or may be present in substantially the same particle in a partially different concentration distribution. In some embodiments, the quantum dot may have a core/shell structure in which one quantum dot is around (e.g., surrounds) another quantum dot. The core/shell structure may have a concentration gradient in which the concentration of elements present in the shell decreases toward the core.

In some embodiments, a quantum dot may have the above-described core-shell structure including a core containing nanocrystals and a shell around (e.g., surrounding) the core. The shell of the quantum dot may serve as a protection layer to prevent or reduce the chemical deformation of the core so as to maintain semiconductor properties, and/or a charging layer to impart electrophoresis properties to the quantum dot. The shell may be a single layer or a multilayer. An example of the shell of the quantum dot may include a metal or non-metal oxide, a semiconductor compound, or a combination thereof.

For example, the metal or non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO, and/or a ternary compound such as MgAl₂O₄, CoFe₂O₄, NiFe₂O₄, and/or CoMn₂O₄, but the embodiment of the present disclosure is not limited thereto.

Also, the semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc., but the embodiment of the present disclosure is not limited thereto.

The quantum dot may have a full width of half maximum (FWHM) of a light emission wavelength spectrum of about 45 nm or less, about 40 nm or less, or about 30 nm or less, and color purity or color reproducibility may be improved in the above ranges. In some embodiments, light emitted through such a quantum dot is emitted in all directions, and thus a wide viewing angle may be obtained (e.g., improved).

In some embodiments, the form of a quantum dot is not particularly limited as long as it is a form commonly utilized in the art, and for example, a quantum dot in the form of spherical, pyramidal, multi-arm, and/or cubic nanoparticles, nanotubes, nanowires, nanofibers, nanoparticles, etc. may be utilized.

The quantum dot may control the color of emitted light according to the particle size thereof, and accordingly, the quantum dot may have one or more suitable emission colors such as blue, red, and/or green.

In each light emitting element ED of embodiments illustrated in FIGS. 3 to 6, the electron transport region ETR is provided on the emission layer EML. In an embodiment, the electron transport region ETR may include the structure of an electron transport layer ETL/electron injection layer EIL sequentially stacked from the emission layer EML. In an embodiment, the electron transport region ETR may further include an hole blocking layer HBL disposed between the hole transport layer ETL and the emission layer EML. The electron transport region ETR may have a thickness, for example, from about 1,000 Å to about 1,500 Å.

The electron transport region ETR may be formed by utilizing one or more suitable methods such as a vacuum deposition method, a spin coating method, a cast method, a Langmuir-Blodgett (LB) method, an inkjet printing method, a laser printing method, a laser induced thermal imaging (LITI) method, etc.

In an embodiment, the electron injection layer EIL includes a metal dopant and a host. The metal dopant includes a metal material and the host includes an organic compound.

In an embodiment, the metal dopant contained in the electron injection layer EIL is doped in the host and may serve to reduce a lowest unoccupied molecular orbital (LUMO) energy level of the host. The metal dopant is doped in the host to reduce the LUMO energy level of the host, thereby minimizing or reducing the difference between the LUMO energy level and a work function energy level of the second electrode EL2. For example, the metal dopant may include Ag, Bi, Mg, Li, Yb, Cu, La, Pr, Nd, Pm, Sm, Eu, Gd, Tb, Dy, Ho, Er, Tm, and/or Lu. For example, the metal dopant may be Li, Yb, or Bi. However, this is merely an example, and the embodiment of the present disclosure is not limited thereto, and any suitable metal material may be utilized without limitation as long as it may serve to reduce the LUMO energy level of the host material contained in the electron injection layer EIL.

In an embodiment, when the metal dopant contained in the electron injection layer EIL is Li, the volume ratio of the metal dopant to the total volume of the host and the metal dopant may be about 3 volume% to about 10 volume%. When the volume ratio of Li as the metal dopant is less than 3 volume%, the driving voltage of the light emitting element ED may increase. When the volume ratio of the metal dopant is greater than 10 volume%, the driving voltage of the light emitting element ED may increase and the efficiency may decrease.

In an embodiment, when the metal dopant contained in the electron injection layer EIL is Yb, the volume ratio of the metal dopant to the total volume of the host and the metal dopant may be about 5 volume% to about 10 volume%. When the volume ratio of Yb as the metal dopant is less than 5 volume% or greater than 10 volume%, the driving voltage of the light emitting element ED may increase and the luminous efficiency may decrease.

In an embodiment, the host contained in the electron injection layer EIL is a polycyclic compound represented by Formula A or Formula B:

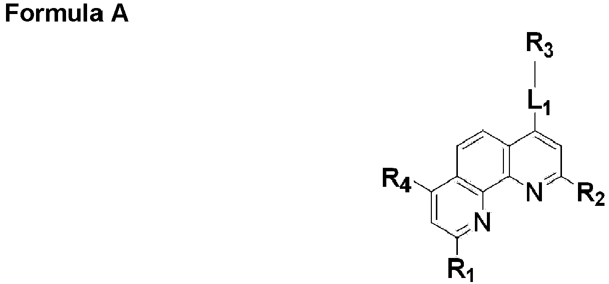

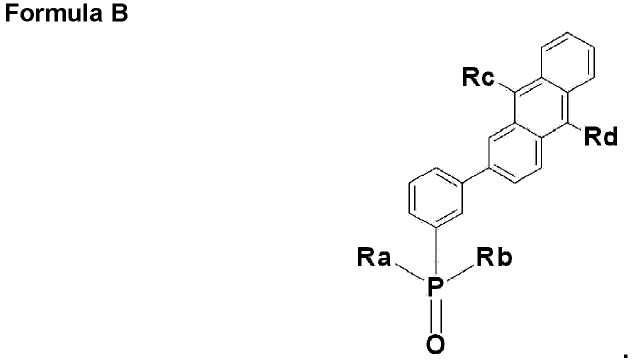

In Formula A, L₁ is a direct linkage, or a substituted or unsubstituted phenylene group. R₃, which will be described in more detail later, may be bonded to the core structure of Formula A with L₁ located therebetween. When L₁ is a direct linkage, R₃ may be directly bonded to the core structure of Formula A, and when L₁ is a substituted or unsubstituted phenylene group, R₃ may be bonded to the core structure of Formula A via the substituted or unsubstituted phenylene group.

R₁ to R₂ are each independently a hydrogen atom, a substituted or unsubstituted methyl group, or a substituted or unsubstituted phenyl group. R₁ and R₂ may be the same as or different from each other.

R₃ to R₄ are each independently a hydrogen atom, a substituted or unsubstituted aryl group having 6 to 30 ring-forming carbon atoms, or a substituted or unsubstituted heteroaryl group having 2 to 30 ring-forming carbon atoms. R₃ and R₄ may be the same as or different from each other.

In Formula B, Ra and Rb are each independently a substituted or unsubstituted alkyl group having 1 to 20 carbon atoms, or a substituted or unsubstituted aryl group having 6 to 30 ring-forming carbon atoms. For example, Ra and Rb may each independently be a substituted or unsubstituted alkyl group having 1 to 10 carbon atoms, or a substituted or unsubstituted aryl group having 6 to 20 ring-forming carbon atoms. For example, Ra and Rb may each independently be a substituted or unsubstituted alkyl group having 1 to 5 carbon atoms, or a substituted or unsubstituted aryl group having 6 to 10 ring-forming carbon atoms. Ra and Rb may be the same as or different from each other.

In Formula B, Rc and Rd are each independently a substituted or unsubstituted aryl group having 6 to 30 ring-forming carbon atoms. For example, Rc and Rd may each independently be a substituted or unsubstituted aryl group having 6 to 20 ring-forming carbon atoms. Rc and Rd may be the same as or different from each other.

The polycyclic compound represented by Formula A may be represented by Formula A-1 or Formula A-2. Formula A-1 is the case where L₁ is a direct linkage, and Formula A-2 is the case where L₁ is an unsubstituted phenylene group.

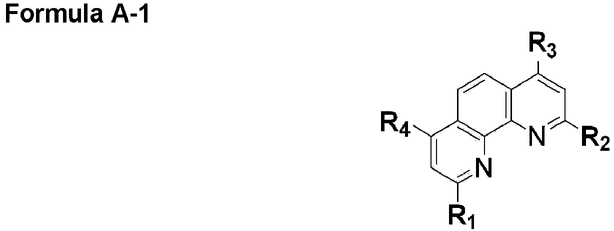

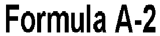

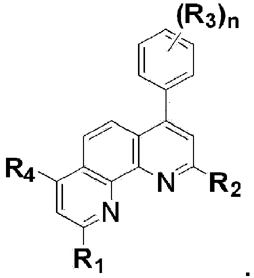

In Formula A-2, n is an integer of 0 to 5. When n is 2 or greater, a plurality of R₃'s may all be the same, or at least one R₃ may be different from the rest. In Formula A-1 and Formula A-2, R₁ to R₄ are each independently the same as described in connection with Formula A.

In Formula A-2, R₃ may be represented by any one among S1 to S25 below.

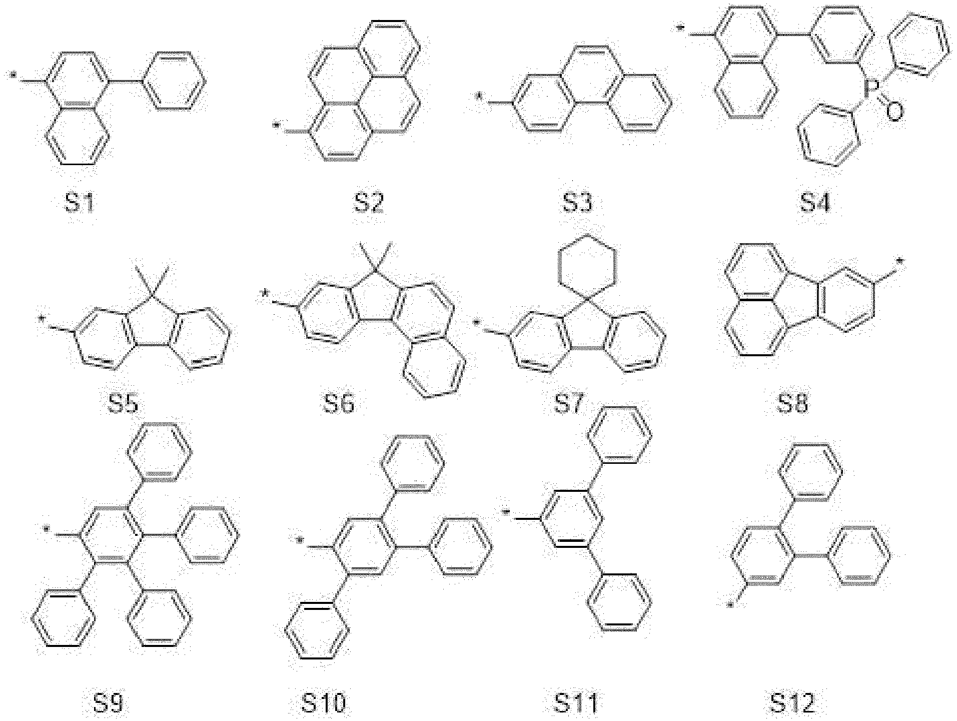

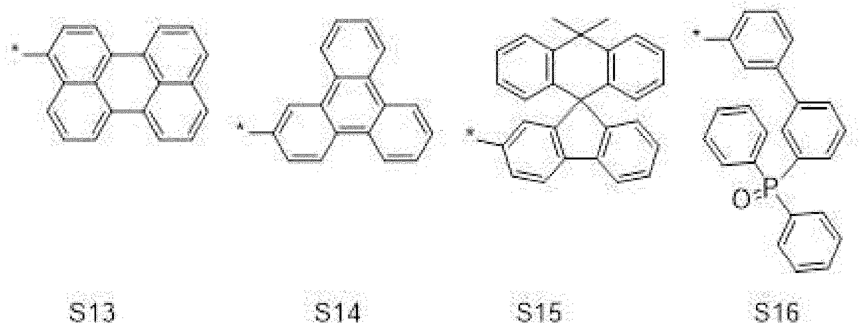

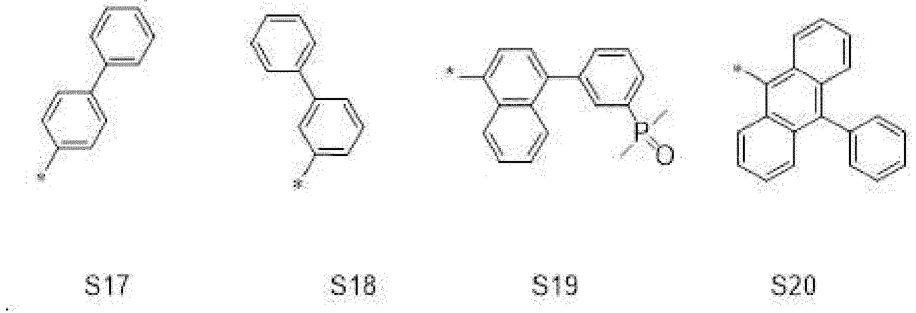

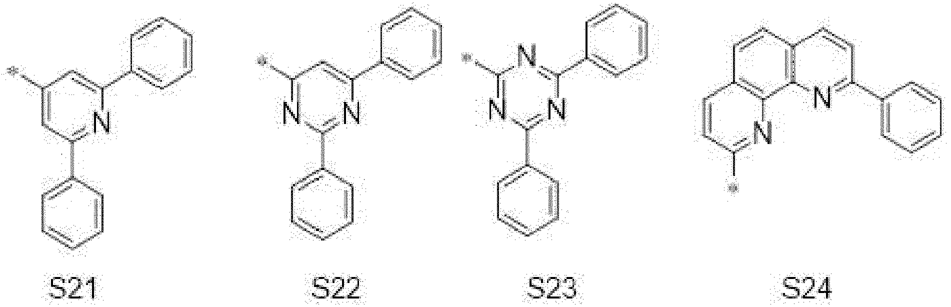

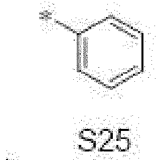

In an embodiment, the electron injection layer EIL may include at least one among the polycyclic compounds of Compound Group 1 below. For example, the electron injection layer EIL may include one polycyclic compound selected from the polycyclic compounds of Compound Group 1 below or include a plurality of the polycyclic compounds of Compound Group 1.

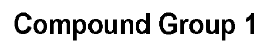

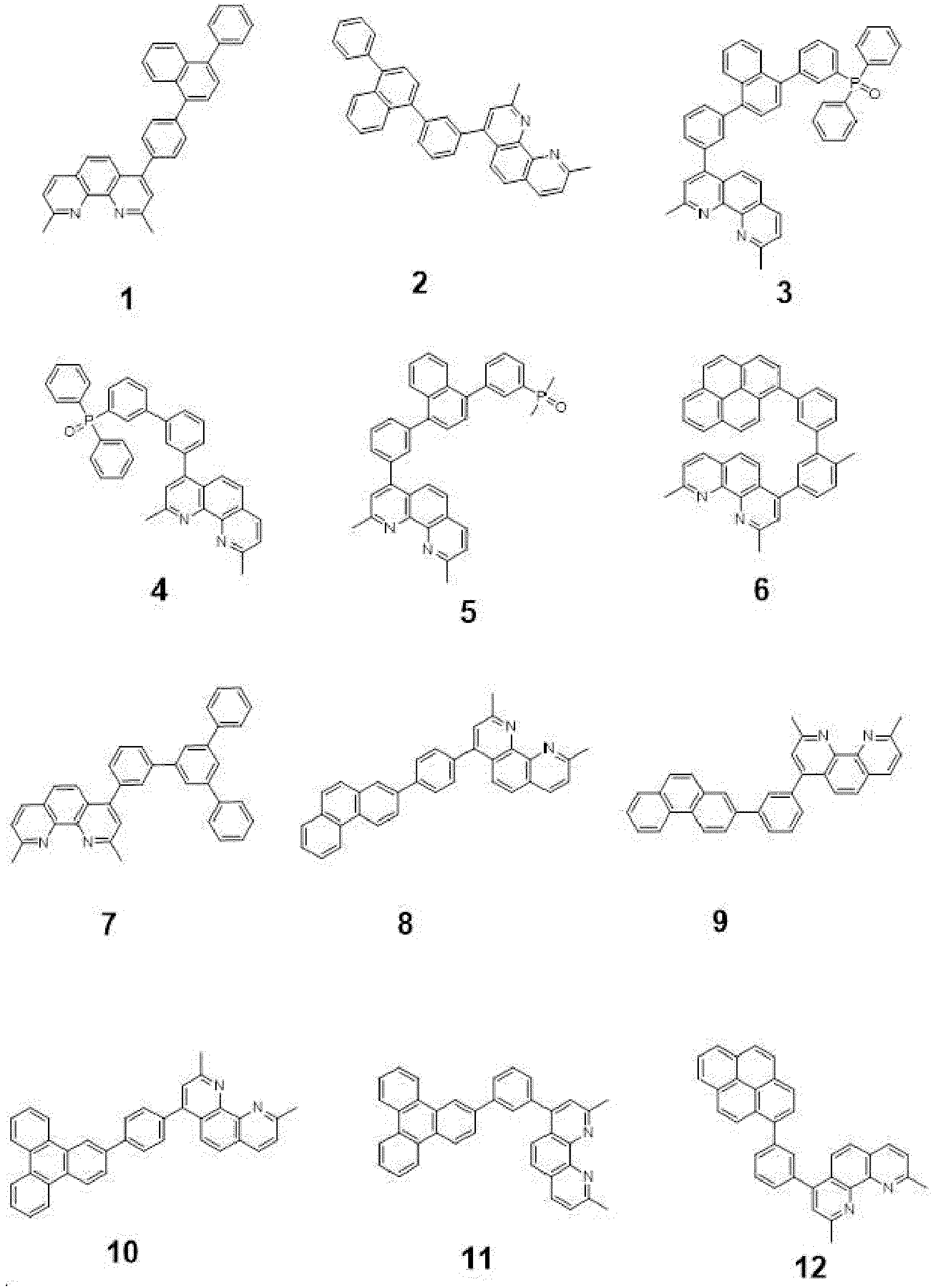

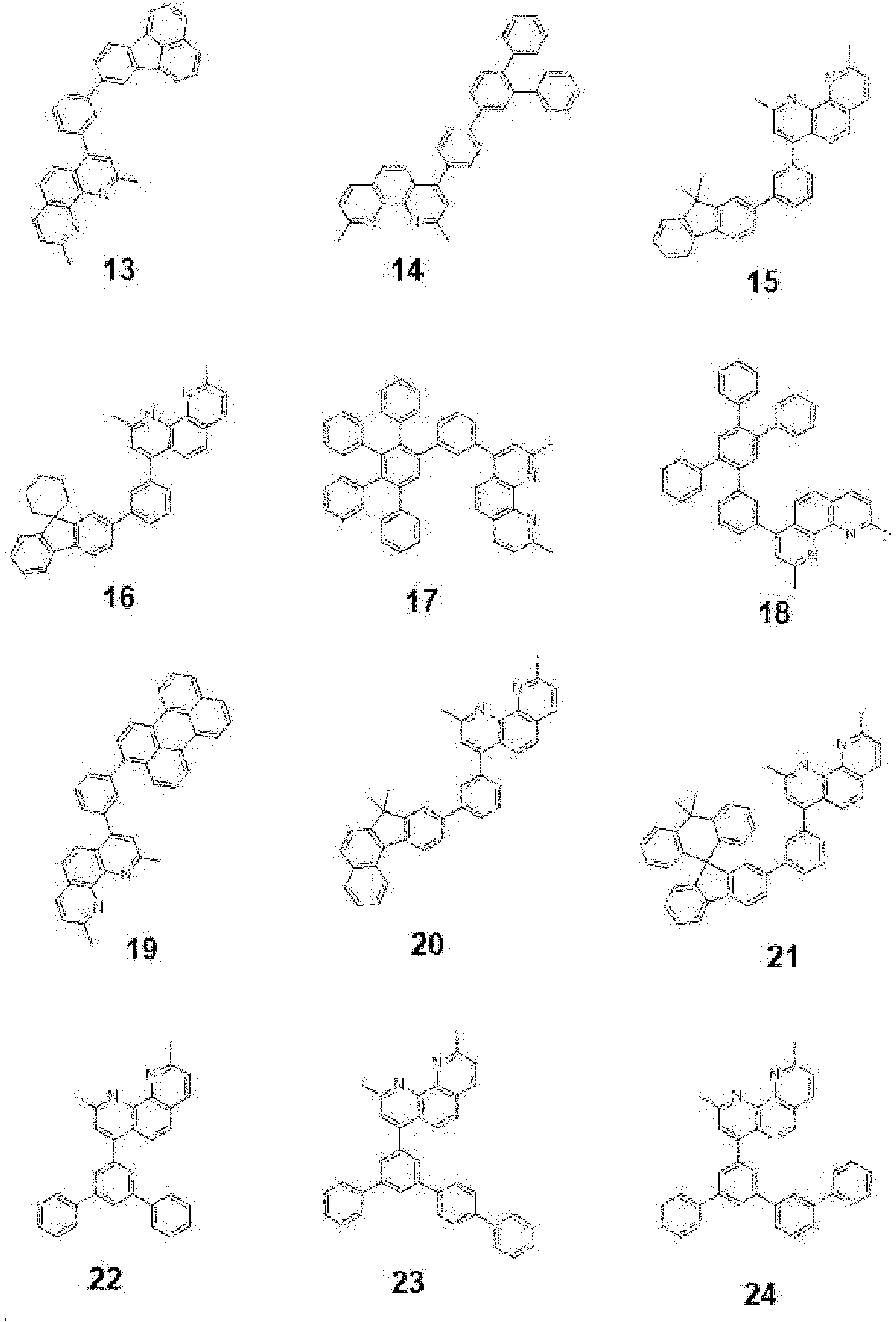

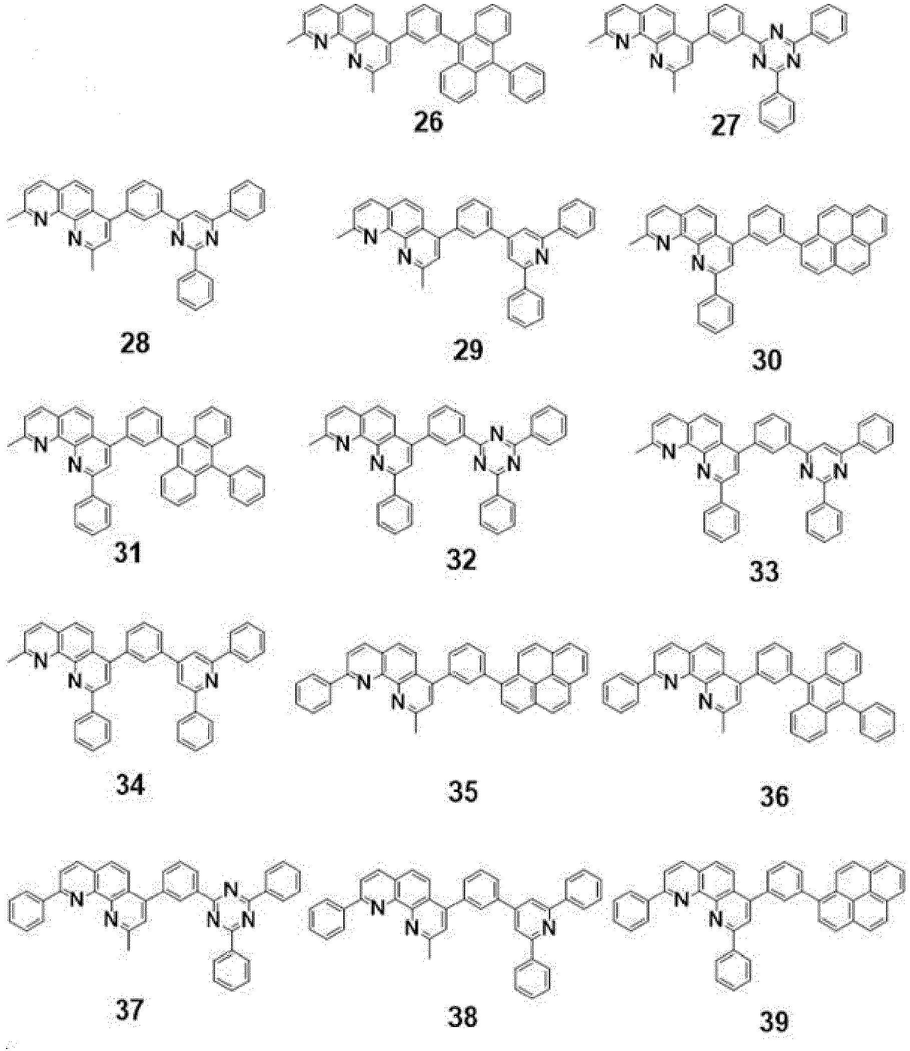

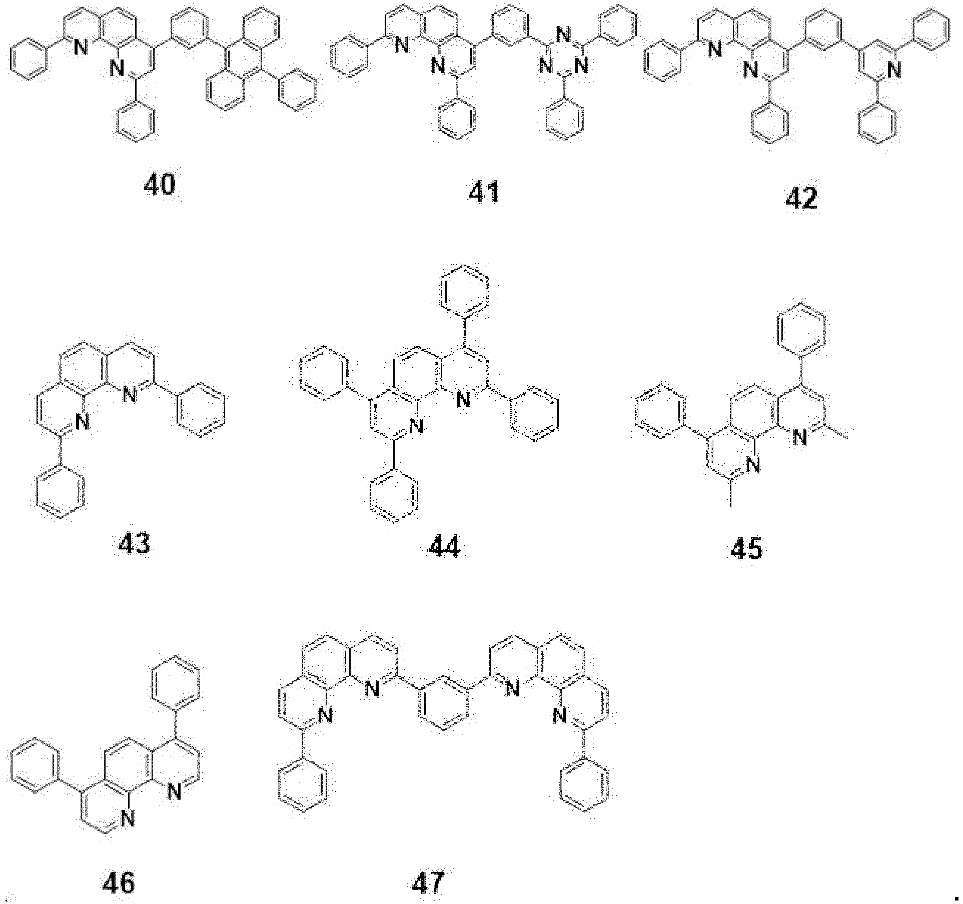

The polycyclic compound represented by Formula B may be represented by Formula B-1 or Formula B-2 below. Formula B-1 is the case where in Formula B, Ra and Rb are each an unsubstituted methyl group, and Formula B-2 is the case where in Formula B-2, Ra and Rb are each an unsubstituted phenyl group.

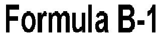

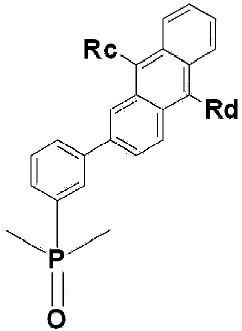

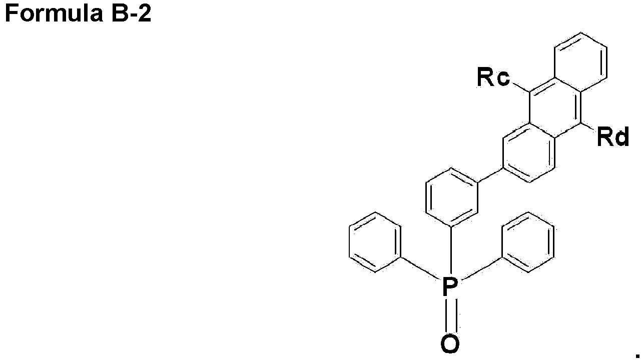

In Formula B-1 and Formula B-2, Rc and Rd are each independently the same as described in connection with Formula B .

In Formula B, Rc and Rd may each independently be represented by any one among T1 to T4 below:

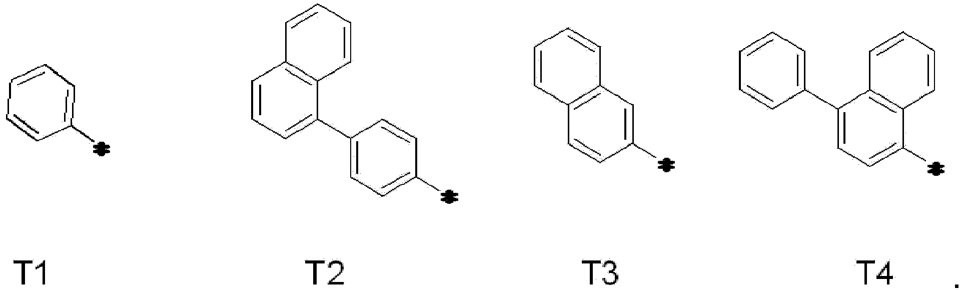

In an embodiment, the electron injection layer EIL may include at least one among the polycyclic compounds of Compound Group 2 below:

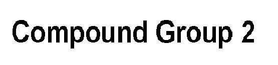

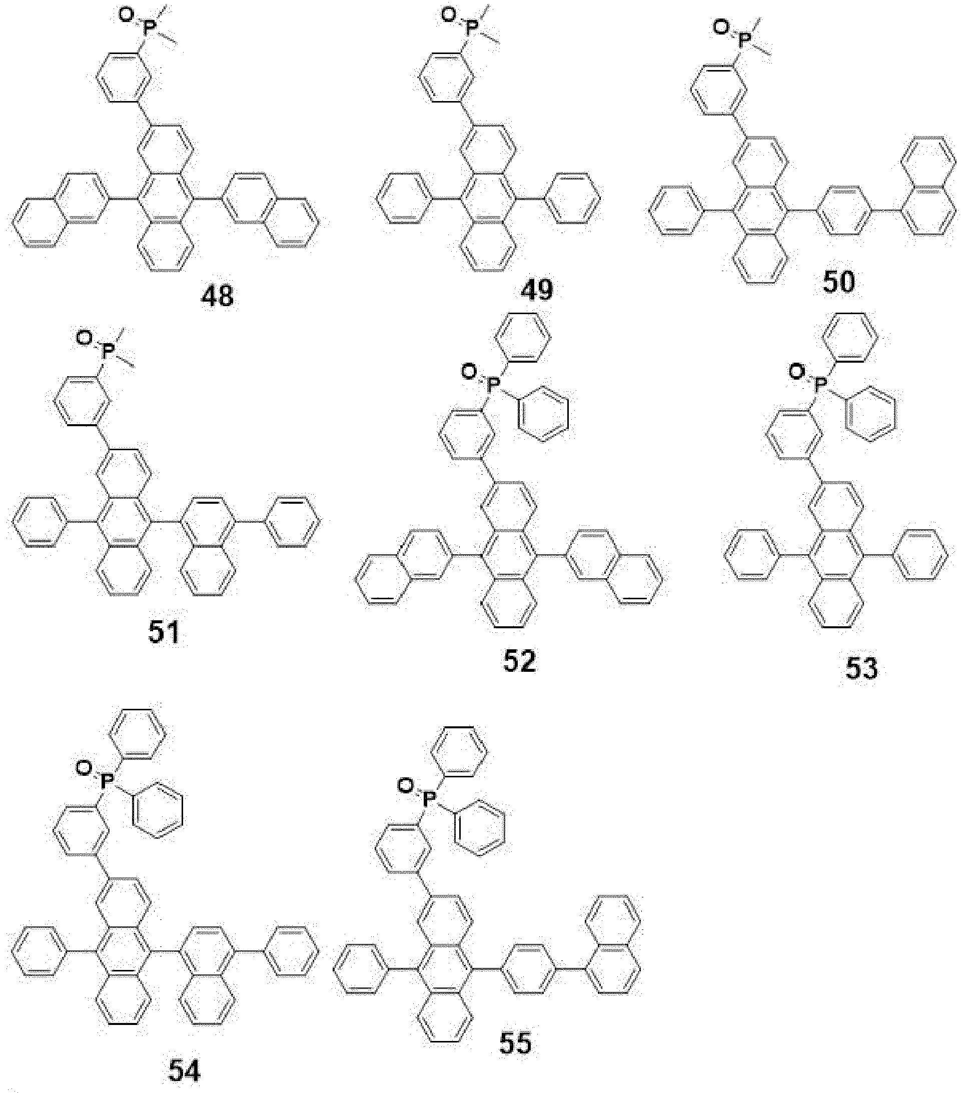

The absolute value of the energy difference between the LUMO energy level of the host doped with the metal dopant and the work function energy level of the second electrode EL2 may be about 0.2 eV or less. For example, the light emitting element ED of an embodiment may improve the characteristics of electron injection from the second electrode EL2 to the electron injection layer EIL by minimizing or reducing the energy level difference between the electron injection layer EIL and the second electrode EL2.

In an embodiment, the electron injection layer EIL containing the metal dopant and the host may be formed in a thin layer thinner than an electron injection layer containing only a metal. For example, the electron injection layer EIL of an embodiment may have a thickness of about 10 Å to about 200 Å. For example, the electron injection layer EIL may have a thickness of about 10 Å to about 50 Å.

In an embodiment, the electron injection layer EIL containing the metal dopant and the host has the metal content (e.g., amount) smaller than the electron injection layer containing only a metal, and thus light absorption occurs relatively less. Therefore, the luminous efficiency of the light emitting element including the electron injection layer EIL containing the metal dopant and the host may be improved.

In an embodiment, the binding energy between the host and the metal dopant contained in the electron injection layer EIL may be about 2.0 eV or more. When the binding energy between the host and the metal dopant is about 2.0 eV or more, the stability of the host doped with the metal dopant may be high or suitable. Accordingly, the change over time in the driving voltage of the light emitting element ED is less, and thus the light emitting element ED may have suitable or long service life characteristics.

In contrast, when the binding energy between the host and the metal dopant is less than 2.0 eV, the stability of the host doped with the metal dopant may be low. Accordingly, the driving voltage of the light emitting element ED is increased over time, and thus the service life of the light emitting element ED may be reduced.

The electron transport region ETR may further include electron transport materials in addition to the above-described host and metal dopant material contained in the electron injection layer EIL of an embodiment.

The electron transport region ETR of an embodiment may include a compound represented by Formula ET-1 below:

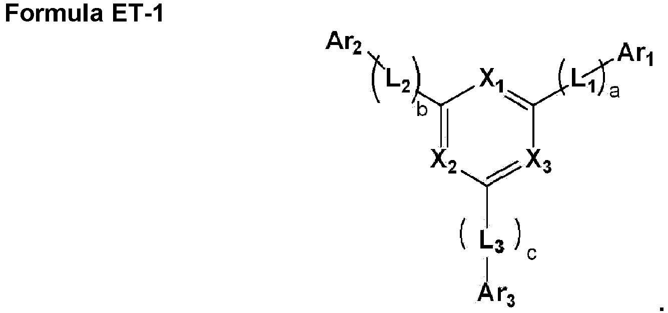

In Formula ET-1, at least one among X₁ to X₃ is N, and the remainder (e.g., the rest) are CRₐ. Rₐ is a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-1, a to c are each independently an integer of 0 to 10. In Formula ET-1, L₁ to L₃ are each independently a direct linkage, a substituted or unsubstituted arylene group having 6 to 30 ring-forming carbon atoms, or a substituted or unsubstituted heteroarylene group having 2 to 30 ring-forming carbon atoms. In some embodiments, when a to c are each an integer of 2 or more, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

The electron transport region ETR may include an anthracene-based compound. However, the embodiment of the present disclosure is not limited thereto, and the electron transport region ETR may include, for example, tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminium (BAIq), berylliumbis(benzoquinolin-10-olate (Bebq₂), 9,10-di(naphthalene-2-yl)anthracene (ADN), 1,3-bis[3,5-di(pyridin-3-yl)phenyl]benzene (BmPyPhB), or a mixture thereof.

The electron transport region ETR may include at least one among Compound ET1 to Compound ET36 below:

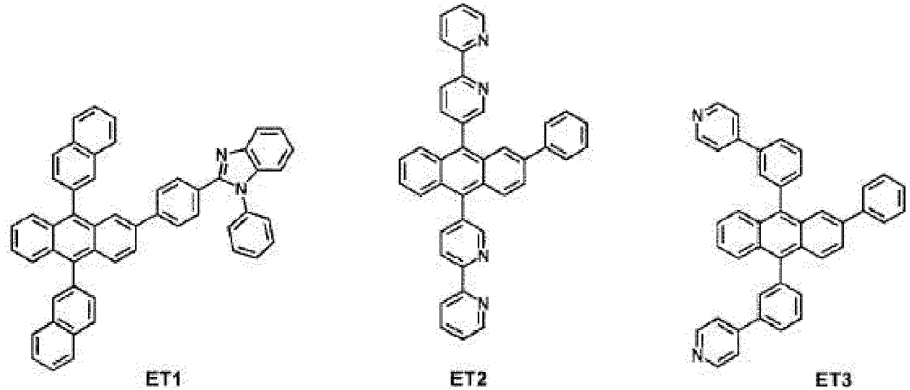

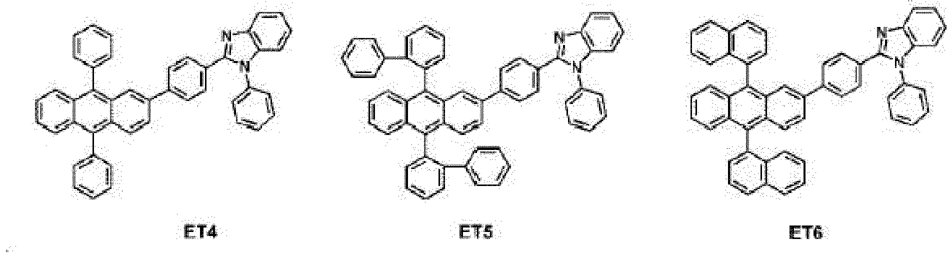

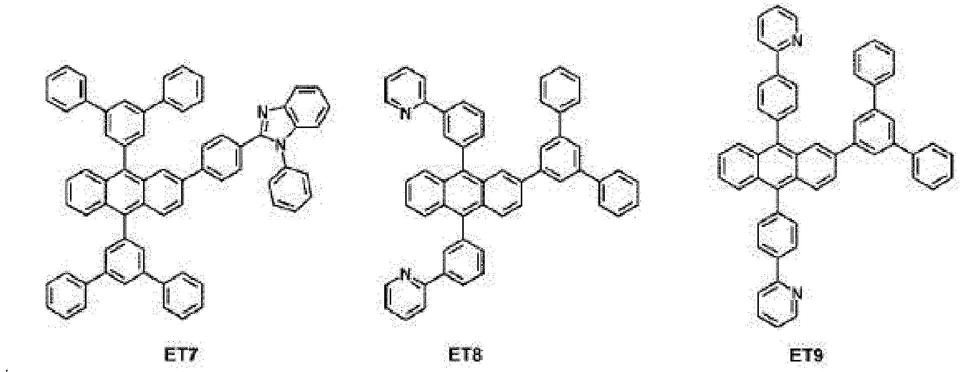

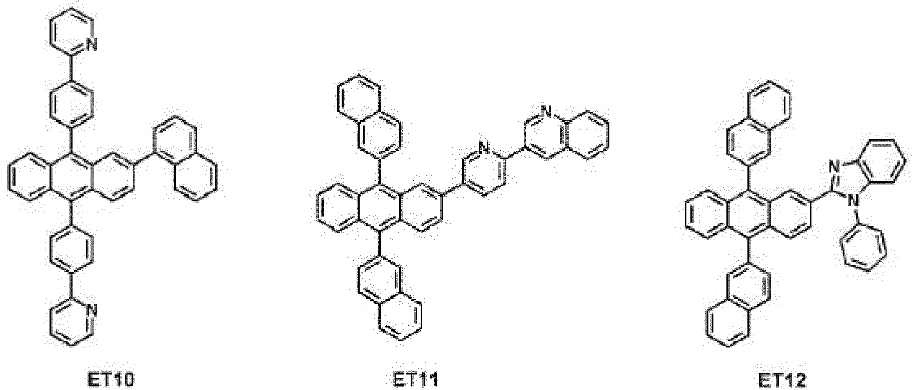

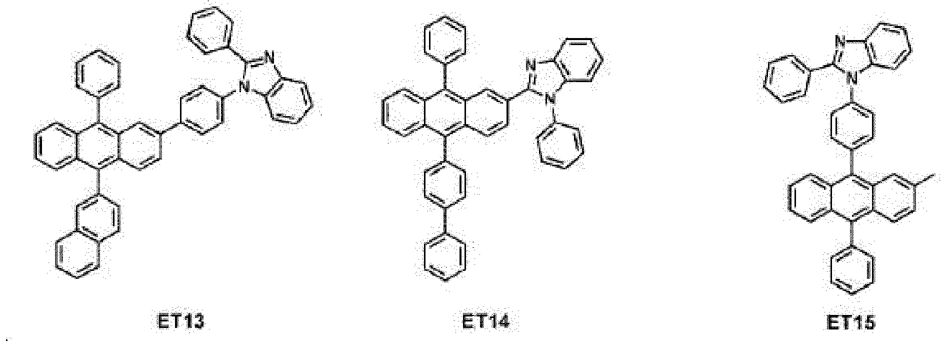

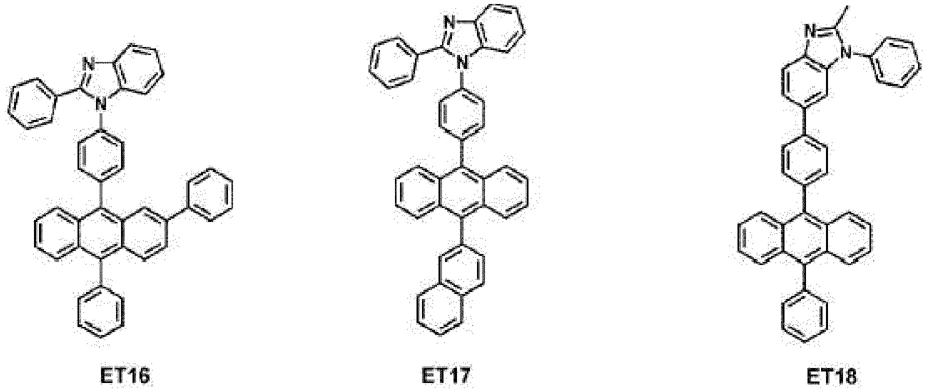

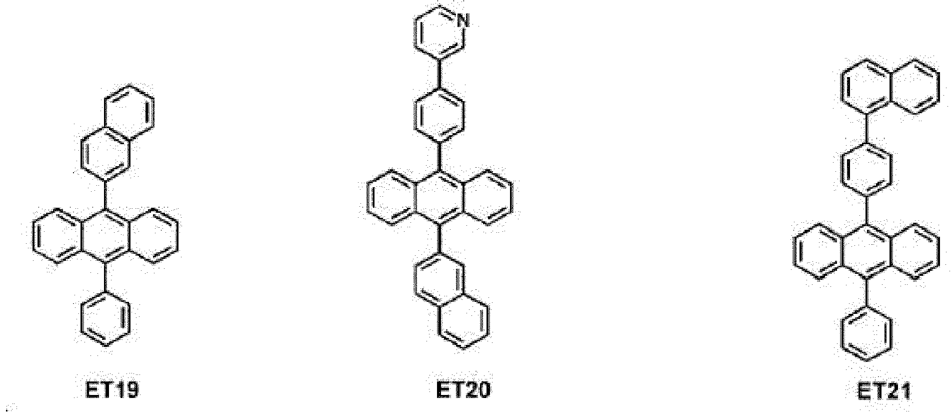

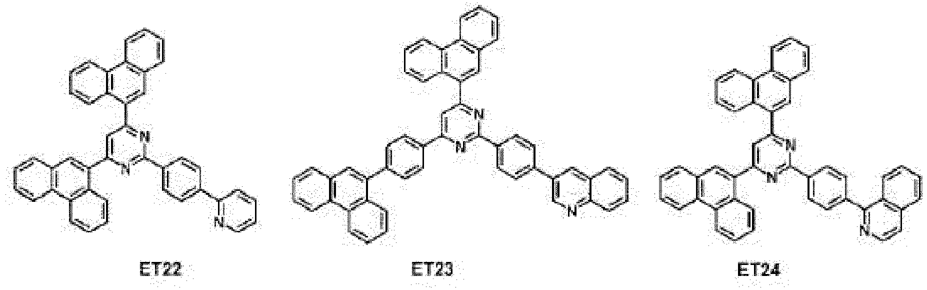

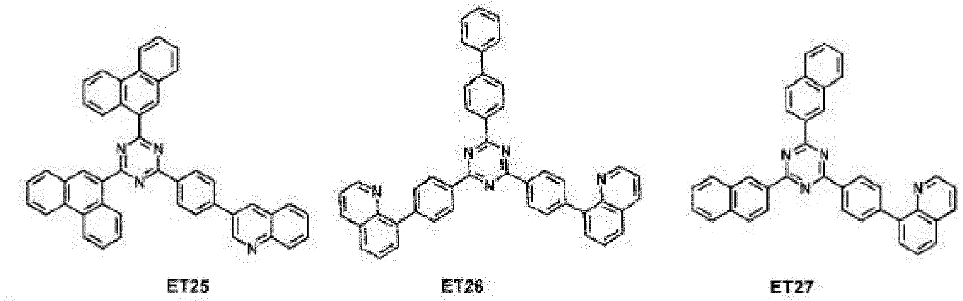

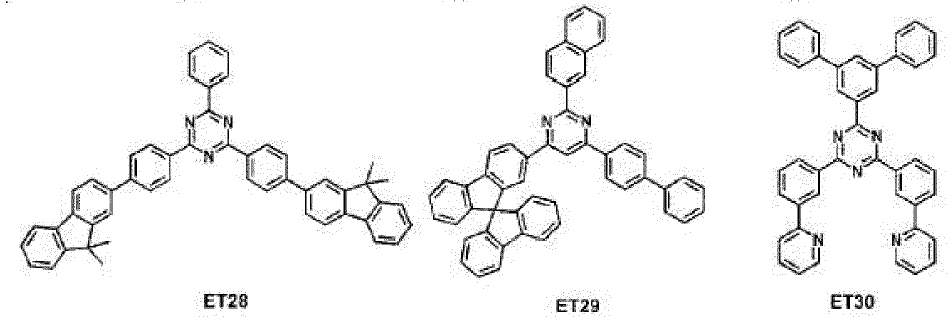

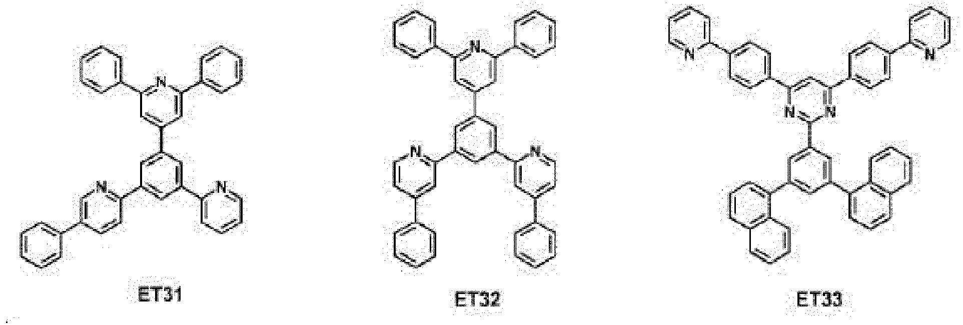

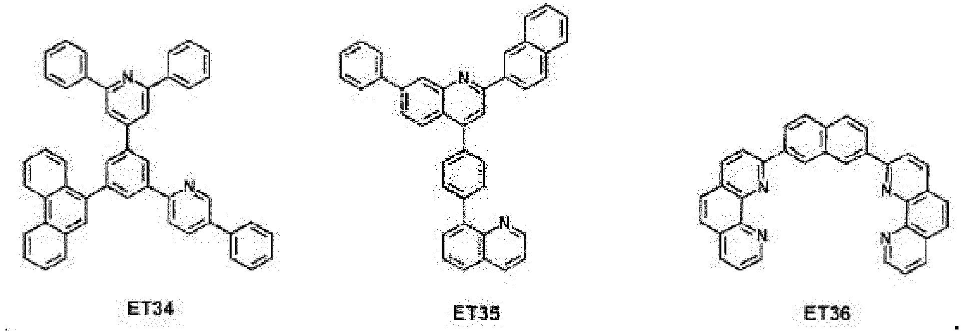

In some embodiments, the electron transport region ETR may include a metal halide such as LiF, NaCl, CsF, RbCI, RbI, CuI, and/or KI, a lanthanide metal such as Yb, and/or a co-deposited material of the metal halide and the lanthanide metal. For example, the electron transport region ETR may include KI:Yb, RbI:Yb, etc. as a co-deposited material. In some embodiments, the electron transport region ETR may be formed utilizing a metal oxide such as Li₂O and/or BaO, 8-hydroxyl-lithium quinolate (Liq), etc., but the embodiment of the present disclosure is not limited thereto. The electron transport region ETR may also be formed of a mixture material of an electron transport material and an insulating organometallic salt. The organometallic salt may be a material having an energy band gap of about 4 eV or more. For example, the organometallic salt may include, for example, a metal acetate, a metal benzoate, a metal acetoacetate, a metal acetylacetonate, and/or a metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1), and 4,7-diphenyl-1,10-phenanthroline (Bphen) in addition to the above-described materials, but the embodiment of the present disclosure is not limited thereto.

The electron transport region ETR may include the above-described compounds of the hole transport region in at least one of the electron injection layer EIL, the electron transport layer ETL, and the hole blocking layer HBL.

When the electron transport region ETR includes the electron transport layer ETL, the electron transport layer ETL may have a thickness of about 100 Å to about 1,000 Å, for example, about 150 Å to about 500 Å. When the thickness of the electron transport layer ETL satisfies the aforementioned ranges, satisfactory electron transport characteristics may be obtained without a substantial increase in a driving voltage. When the electron transport region ETR includes the electron injection layer EIL, the electron injection layer EIL may have a thickness of about 1 Å to about 100 Å, for example, about 3 Å to about 90 Å. When the thickness of the electron injection layer EIL satisfies the above-described range, satisfactory electron injection characteristics may be obtained without a substantial increase in a driving voltage.

The second electrode EL2 is provided on the electron transport region ETR. The second electrode EL2 may be a common electrode. The second electrode EL2 may be a cathode or an anode, but the embodiment of the present disclosure is not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), etc.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound thereof, or mixture thereof (e.g., AgMg, AgYb, or MgAg). In some embodiments, the second electrode EL2 may have a multilayer structure including a reflective film or a transflective film formed of the above-described materials, and a transparent conductive film formed of ITO, IZO, ZnO, ITZO, etc. For example, the second electrode EL2 may include the above-described metal materials, combinations of two or more metal materials of the above-described metal materials, oxides of the above-described metal materials, and/or the like.

In some embodiments, the second electrode EL2 may be connected with an auxiliary electrode. When the second electrode EL2 is connected with the auxiliary electrode, the resistance of the second electrode EL2 may decrease.

In some embodiments, a capping layer CPL may further be disposed on the second electrode EL2 of the light emitting element ED of an embodiment. The capping layer CPL may include a multilayer or a single layer.

In an embodiment, the capping layer CPL may be an organic layer or an inorganic layer. For example, when the capping layer CPL contains an inorganic material, the inorganic material may include an alkaline metal compound (for example, LiF), an alkaline earth metal compound (for example, MgF₂), SiON, SiNₓ, SiOy, etc.

For example, when the capping layer CPL contains an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-tris(carbazol sol-9-yl)triphenylamine (TCTA), etc., an epoxy resin, and/or an acrylate such as a methacrylate. However, the embodiment of the present disclosure is not limited thereto, and the capping layer CPL may include at least one among Compounds P1 to P5 below:

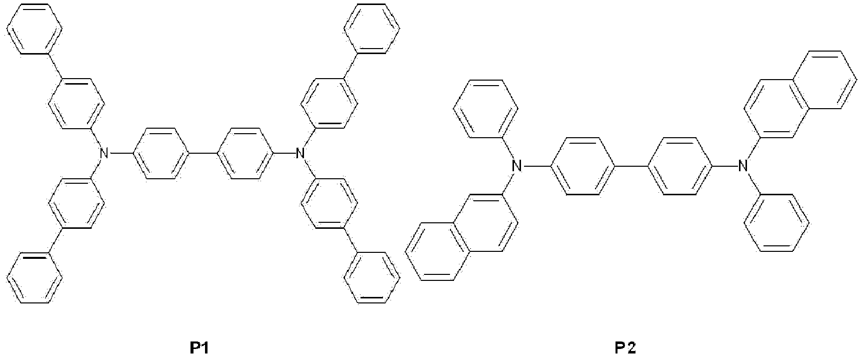

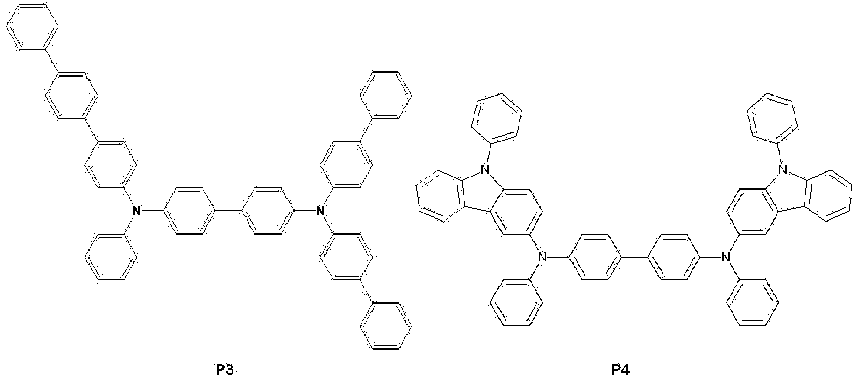

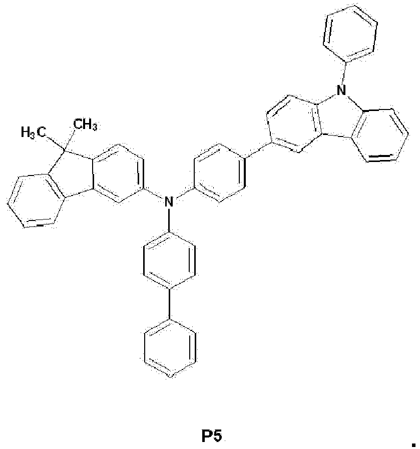

In some embodiments, the refractive index of the capping layer CPL may be about 1.6 or greater. For example, the refractive index of the capping layer CPL may be about 1.6 or greater with respect to light in a wavelength range of about 550 nm to about 660 nm.

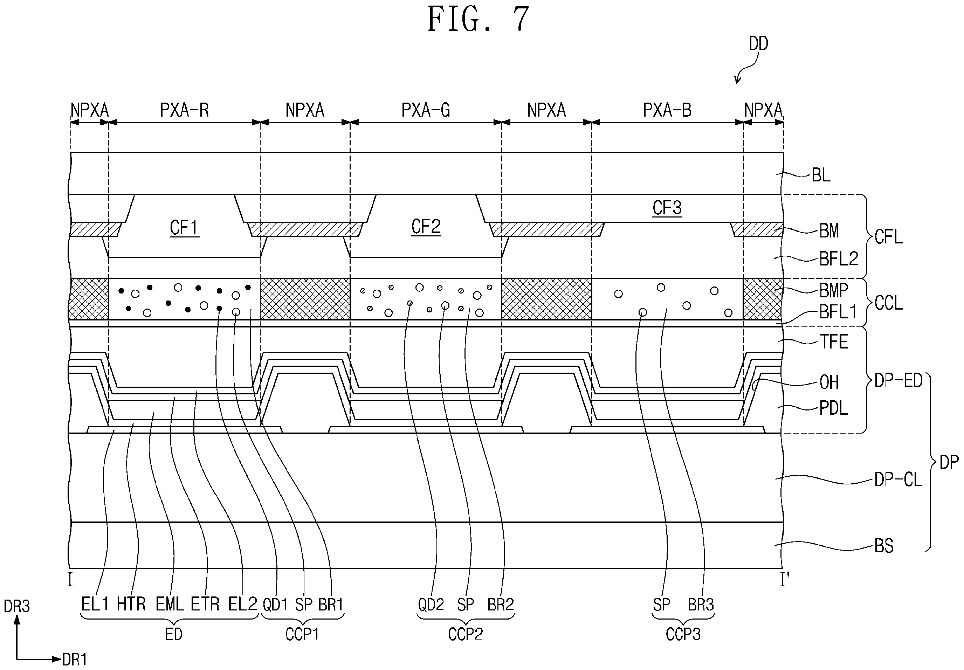

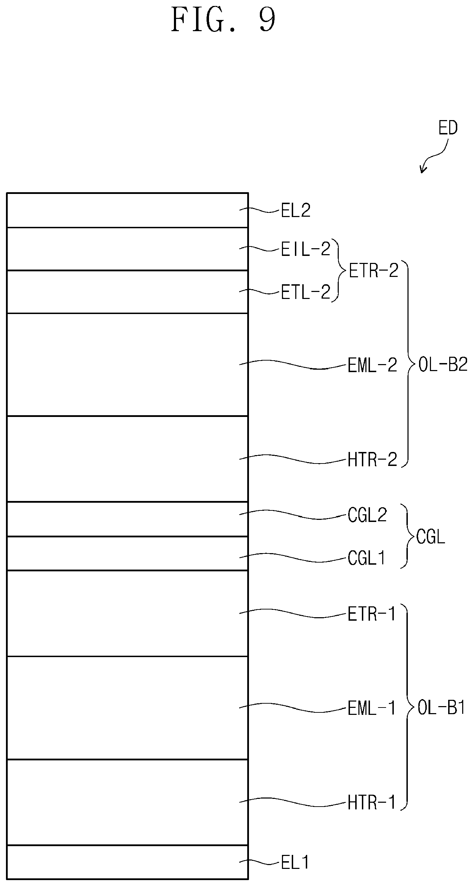

FIGS. 7-8 are each a cross-sectional view of a display device according to a respective embodiment, FIG. 9 is a cross-sectional view schematically illustrating a light emitting element according to an embodiment. Hereinafter, in describing the display devices of embodiments with reference to FIGS. 7 to 9, the duplicated features which have been described in FIGS. 1 to 6 are not described again, but their differences will be mainly described.

Referring to FIG. 7, the display device DD according to an embodiment may include a display panel DP including a display element layer DP-ED, a light control layer CCL disposed on the display panel DP, and a color filter layer CFL.

In an embodiment illustrated in FIG. 7, the display panel DP may include a base layer BS, a circuit layer DP-CL provided on the base layer BS, and the display element layer DP-ED, and the display element layer DP-ED may include a light emitting element ED.

The light emitting element ED may include a first electrode EL1, a hole transport region HTR disposed on the first electrode EL1, an emission layer EML disposed on the hole transport region HTR, an electron transport region ETR disposed on the emission layer EML, and a second electrode EL2 disposed on the electron transport region ETR. In some embodiments, the structures of the light emitting elements of FIGS. 3 to 6 as described above may be equally applied to the structure of the light emitting element ED illustrated in FIG. 7.

Referring to FIG. 7, the emission layer EML may be disposed in an opening OH defined in a pixel defining film PDL. For example, the emission layer EML which is divided by the pixel defining film PDL and provided corresponding to each light emitting regions PXA-R, PXA-G, and PXA-B may emit light in substantially the same wavelength range. In the display device DD of an embodiment, the emission layer EML may emit blue light. In some embodiments, unlike shown, the emission layer EML may be provided as a common layer in the entire light emitting regions PXA-R, PXA-G, and PXA-B.

The light control layer CCL may be disposed on the display panel DP. The light control layer CCL may include a light conversion body. The light conversion body may be a quantum dot, a phosphor, and/or the like. The light conversion body may convert the wavelength of received light and emit the resulting light by converting the wavelength thereof. For example, the light control layer CCL may be a layer containing the quantum dot or a layer containing the phosphor.

The light control layer CCL may include a plurality of light control parts CCP1, CCP2 and CCP3. The light control parts CCP1, CCP2, and CCP3 may be spaced apart from each other.

Referring to FIG. 7, divided patterns BMP may be disposed between the light control parts CCP1, CCP2 and CCP3 which are spaced apart from each other, but the embodiment of the present disclosure is not limited thereto. FIG. 7 illustrates that the divided patterns BMP do not overlap the light control parts CCP1, CCP2 and CCP3, but at least a portion of the edges of the light control parts CCP1, CCP2 and CCP3 may overlap the divided patterns BMP.

The light control layer CCL may include a first light control part CCP1 containing a first quantum dot QD1 which converts a first color light provided from the light emitting element ED into a second color light, a second light control part CCP2 containing a second quantum dot QD2 which converts the first color light into a third color light, and a third light control part CCP3 which transmits the first color light.

In an embodiment, the first light control part CCP1 may provide red light that is the second color light, and the second light control part CCP2 may provide green light that is the third color light. The third light control part CCP3 may provide blue light by transmitting the blue light that is the first color light provided from the light emitting element ED. For example, the first quantum dot QD1 may be a red quantum dot, and the second quantum dot QD2 may be a green quantum dot. The same as described above may be applied with respect to the quantum dots QD1 and QD2.

In some embodiments, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) any quantum dot but may include the scatterer SP.

The scatterer SP may be inorganic particles. For example, the scatterer SP may include at least one of TiO₂, ZnO, Al₂O₃, SiO₂, and hollow silica. The scatterer SP may include any one of TiO₂, ZnO, Al₂O₃, SiO₂, or hollow silica, or may be a mixture of at least two materials selected from among TiO₂, ZnO, Al₂O₃, SiO₂, and hollow silica.

The first light control part CCP1, the second light control part CCP2, and the third light control part CCP3 each may include base resins BR1, BR2, and BR3 in which the quantum dots QD1 and QD2 and the scatterer SP are dispersed. In an embodiment, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3. The base resins BR1, BR2, and BR3 are media in which the quantum dots QD1 and QD2 and the scatterer SP are dispersed, and may be formed of one or more suitable resin compositions, which may be generally referred to as a binder. For example, the base resins BR1, BR2, and BR3 may each independently be one or more of acrylic-based resins, urethane-based resins, silicone-based resins, epoxy-based resins, etc. The base resins BR1, BR2, and BR3 may each be transparent resins. In an embodiment, the first base resin BR1, the second base resin BR2, and the third base resin BR3 each may be the same as or different from each other.

The light control layer CCL may include a barrier layer BFL1. The barrier layer BFL1 may serve to prevent or reduce the penetration of moisture and/or oxygen (hereinafter, referred to as 'moisture/oxygen'). The barrier layer BFL1 may be disposed on the light control parts CCP1, CCP2, and CCP3 to block or reduce the light control parts CCP1, CCP2 and CCP3 from being exposed to moisture/oxygen. In some embodiments, the barrier layer BFL1 may cover the light control parts CCP1, CCP2, and CCP3. In some embodiments, a barrier layer BFL2 may be provided between the light control parts CCP1, CCP2, and CCP3 and the color filter layer CFL.

The barrier layers BFL1 and BFL2 may include at least one inorganic layer. For example, the barrier layers BFL1 and BFL2 may include an inorganic material. For example, the barrier layers BFL1 and BFL2 may include a silicon nitride, an aluminium nitride, a zirconium nitride, a titanium nitride, a hafnium nitride, a tantalum nitride, a silicon oxide, an aluminium oxide, a titanium oxide, a tin oxide, a cerium oxide, a silicon oxynitride, a metal thin film which secures a transmittance, etc. In some embodiments, the barrier layers BFL1 and BFL2 may further include an organic film. The barrier layers BFL1 and BFL2 may be formed of a single layer or a plurality of layers.

In the display device DD of an embodiment, the color filter layer CFL may be disposed on the light control layer CCL. For example, the color filter layer CFL may be directly disposed on the light control layer CCL. In this case, the barrier layer BFL2 may not be provided.

The color filter layer CFL may include a light shielding part BM and color filters CF1, CF2, and CF3. The color filter layer CFL may include a first filter CF1 configured to transmit the second color light, a second filter CF2 configured to transmit the third color light, and a third filter CF3 configured to transmit the first color light. For example, the first filter CF1 may be a red filter, the second filter CF2 may be a green filter, and the third filter CF3 may be a blue filter. The filters CF1, CF2, and CF3 each may include a polymeric photosensitive resin and a pigment and/or dye. The first filter CF1 may include a red pigment and/or dye, the second filter CF2 may include a green pigment and/or dye, and the third filter CF3 may include a blue pigment and/or dye. In some embodiments, the embodiment of the present disclosure is not limited thereto, and the third filter CF3 may not include (e.g., may exclude) a pigment or dye. The third filter CF3 may include a polymeric photosensitive resin and may not include (e.g., may exclude) a pigment or dye. The third filter CF3 may be transparent. The third filter CF3 may be formed of a transparent photosensitive resin.

Furthermore, in an embodiment, the first filter CF1 and the second filter CF2 may each be a yellow filter. The first filter CF1 and the second filter CF2 may not be separated but be provided as one filter.

The light shielding part BM may be a black matrix. The light shielding part BM may include an organic light shielding material and/or an inorganic light shielding material containing a black pigment and/or dye. The light shielding part BM may prevent or reduce light leakage, and may separate boundaries between the adjacent filters CF1, CF2, and CF3. In some embodiments, the light shielding part BM may be formed of a blue filter.

The first to third filters CF1, CF2, and CF3 may be disposed corresponding to the red light emitting region PXA-R, the green light emitting region PXA-G, and the blue light emitting region PXA-B, respectively.

A base substrate BL may be disposed on the color filter layer CFL. The base substrate BL may be a member which provides a base surface on which the color filter layer CFL, the light control layer CCL, and/or the like are disposed. The base substrate BL may be a glass substrate, a metal substrate, a plastic substrate, etc. However, the embodiment of the present disclosure is not limited thereto, and the base substrate BL may be an inorganic layer, an organic layer, or a composite material layer (e.g., a composite material layer including an inorganic material and an organic material). In some embodiments, unlike shown, the base substrate BL may not be provided.

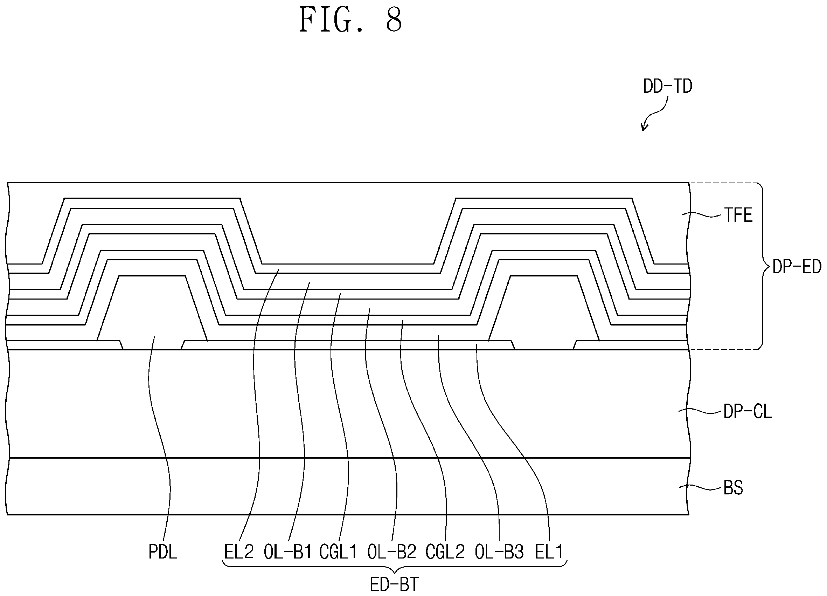

FIG. 8 is a cross-sectional view illustrating a part of a display device according to an embodiment. FIG. 8 illustrates a cross-sectional view of a part corresponding to the display panel DP of FIG. 7. In the display device DD-TD of an embodiment, the light emitting element ED-BT may include a plurality of light emitting structures OL-B1, OL-B2, and OL-B3. The light emitting element ED-BT may include a first electrode EL1 and a second electrode EL2 which face each other, and the plurality of light emitting structures OL-B1, OL-B2, and OL-B3 sequentially stacked in the thickness direction between the first electrode EL1 and the second electrode EL2. The light emitting structures OL-B1, OL-B2, and OL-B3 each may include an emission layer EML (FIG. 7) and a hole transport region HTR and an electron transport region ETR disposed with the emission layer EML (FIG. 7) located therebetween.

For example, the light emitting element ED-BT included in the display device DD-TD of an embodiment may be a light emitting element having a tandem structure and including a plurality of emission layers.

In an embodiment illustrated in FIG. 8, all light (e.g., light beams) respectively emitted from the light emitting structures OL-B1, OL-B2, and OL-B3 may be blue light. However, the embodiment of the present disclosure is not limited thereto, and the light (e.g., light beams) respectively emitted from the light emitting structures OL-B1, OL-B2, and OL-B3 may have wavelength ranges different from each other. For example, the light emitting element ED-BT including the plurality of light emitting structures OL-B1, OL-B2, and OL-B3 which emit light beams having wavelength ranges different from each other may emit white light.

A charge generation layer CGL (e.g., CGL1 or CGL2) may be disposed between the neighboring light emitting structures OL-B1, OL-B2, and OL-B3. For example, a charge generation layer CGL1 may be between the light emitting structure OL-B1 and the light emitting structure OL-B2, and a charge generation layer CGL2 may be between the light emitting structure OL-B2 and the light emitting structure OL-B3. The charge generation layer CGL may include a p-type or kind charge generation layer and/or an n-type or kind charge generation layer.

FIG. 9 is a cross-sectional view of a light emitting element of an embodiment. FIG. 9 is an enlarged cross-sectional view of the light emitting element including light emitting structures illustrated in FIG. 8. FIG. 9 illustrates, e.g., a light emitting element ED including two light emitting structures OL-B1 and OL-B2, unlike FIG. 8.

Referring to FIG. 9, the light emitting element ED of an embodiment may include a plurality of light emitting structures OL-B1 and OL-B2 and a charge generation layer CGL. FIG. 9, e.g., illustrates that the light emitting element includes two light emitting structures OL-B1 and OL-B2, but this is merely an example and the embodiment of the present disclosure is not limited thereto, and as illustrated in FIG. 8, the light emitting element ED may include at least three light emitting structures (OL-B1, OL-B2, and OL-B3) (FIG. 8).

The light emitting element ED of an embodiment may include a first light emitting structure OL-B1 and a second light emitting structure OL-B2 disposed on the first light emitting structure OL-B1. The charge generation layer CGL may be disposed between the first light emitting structure OL-B1 and the second light emitting structure OL-B2. For example, the second light emitting structure OL-B2 may be disposed on the charge generation layer CGL. The charge generation layer CGL may include an N-type or kind charge generation layer CGL1 and a P-type or kind charge generation layer CGL2 disposed on the N-type or kind charge generation layer CGL1.

The light emitting structures OL-B1 and OL-B2 may respectively include hole transport regions HTR-1 and HTR-2, emission layers EML-1 and EML-2, and electron transport regions ETR-1 and ETR-2 sequentially stacked.

The same as described in the hole transport region HTR (FIG. 3) and the emission layer EML (FIG. 3) of FIGS. 3 to 6 may be applied to the hole transport regions HTR-1 and HTR-2 and the emission layers EML-1 and EML-2 included in the light emitting structures OL-B1 and OL-B2.

The first light emitting structure OL-B1 may include the first electron transport region ETR-1. The first electron transport region ETR-1 included in the first light emitting structure OL-B1 may include at least one of a hole blocking layer, an electron transport layer, and an electron injection layer, but the embodiment of the present disclosure is not limited thereto.

The first electron transport region ETR-1 may have a single layer formed of a single material, a single layer formed of a plurality of different materials, or a multilayer structure including a plurality of layers formed of a plurality of different materials.

For example, the first electron transport region ETR-1 may have a single layer structure of the electron injection layer or the electron transport layer, and may have a single layer structure formed of an electron injection material and an electron transport material. In some embodiments, the first electron transport region ETR-1 may have a single layer structure formed of a plurality of different materials or a structure in which an electron transport layer/electron injection layer, or a hole blocking layer/electron transport layer/electron injection layer are stacked in the respective stated order from the first emission layer EML-1, but the embodiment of the present disclosure is not limited thereto. The first electron transport region ETR-1 may have a thickness, for example, from about 1,000 Å to about 1,500 Å.

The second electron transport region ETR-2 included in the second light emitting structure OL-B2 may be adjacent to a second electrode EL2. The electron transport region ETR-2 may include the electron transport layer ETL-2 and the second electron injection layer EIL-2. The second electron injection transport EIL-2 may be disposed between the second electron transport layer ETL-2 and the second electrode EL2. For example, the second electrode EL2 may be directly disposed on the second electron injection layer EIL-2. The same as described in the electron injection layer EIL of FIG. 3 may be applied to the description of the second electron injection layer EIL-2.

For example, the light emitting element ED of an embodiment may include the host and the metal dopant in the second electron injection layer EIL-2 included in the second light emitting structure OL-B2 adjacent to the second electrode EL2 of the plurality of light emitting structures OL-B1 and OL-B2. The difference between the LUMO energy level of the host doped with the metal dopant contained in the second electron injection layer EIL-2 and the work function energy level of the second electrode EL2 become about 0.2 eV, and thus the light emitting element ED of an embodiment may have improved characteristics of electrons injected from the second electrode EL2 into the second electron injection layer EIL-2. As a result, the light emitting element ED of an embodiment may exhibit high luminous efficiency and long service life characteristics.

Hereinafter, with reference to Examples and Comparative Examples, a polycyclic compound according to an embodiment of the present disclosure and a light emitting element of an embodiment of the present disclosure will be described in more detail. In addition, Examples shown below are illustrated only for the understanding of the present disclosure, and the scope of the present disclosure is not limited thereto.

### Manufacture of Light Emitting Element 1

A 100 Å-thick first glass substrate made by Corning Co., on which ITO of about 15 Ω/cm² is formed, a 1,000 Å-thick second glass substrate, on which Ag is formed, and a 100 Å-thick third glass substrate made by Corning Co., on which ITO of about 15 Ω/cm² is formed, were each cut to a size of 50 mm × 50 mm × 0.7 mm, cleansed by ultrasonic waves utilizing isopropyl alcohol and pure water for about five minutes each, and then irradiated with ultraviolet rays for about 30 minutes and exposed to ozone and cleansed. The first to third glass substrates were sequentially stacked on a vacuum deposition apparatus to form a 1,200 Å-thick first electrode. N,N'-di(1-naphthyl)-N,N'-diphenylbenzidine (NPB) was deposited in vacuum on the upper portion of the first electrode to form a 300 Å-thick hole injection layer. A compound TCTA was deposited in vacuum on the upper portion of the hole injection layer to form a 200 Å-thick hole transport layer.

Thereafter, N¹,N⁶-di(naphthalen-2-yl)-N¹,N⁶-diphenylpyrene-1,6-diamine and mCP were co-deposited at a weight ratio of 99:1 on the upper portion of the hole transport layer to form a 200 Å-thick emission layer.

Next, T2T and TPM-TAZ were deposited (e.g., co-deposited) on the upper portion of the emission layer to form a 200 Å-thick electron transport layer. On the upper portion of the electron transport layer, the polycyclic compound of an embodiment and metal dopants were deposited (e.g., co-deposited) or a single metal layer was deposited to form a 10 Å-thick electron injection layer.

Next, Ag and Mg were co-deposited at a weight ratio of 9:1 to form a 100 Å-thick second electrode, P4 was deposited on the second electrode to form a 500 Å-thick capping layer, thereby manufacturing light emitting elements of Examples 1 to 5, Examples 9 to 14, Comparative Examples 1 to 5, and Comparative Examples 7 to 9.

### Manufacture of Light Emitting Element 2

A 100 Å-thick first glass substrate made by Corning Co., on which ITO of about 15 Ω/cm² is formed, a 1000 Å-thick second glass substrate, on which Ag is formed, and a 100 Å-thick third glass substrate made by Corning Co., on which ITO of about 15 Ω/cm2 is formed, were each cut to a size of 50 mm × 50 mm × 0.7 mm, cleansed by ultrasonic waves utilizing isopropyl alcohol and pure water for about five minutes each, and then irradiated with ultraviolet rays for about 30 minutes and exposed to ozone and cleansed. The first to third glass substrates were sequentially stacked on a vacuum deposition apparatus to form a 1,200 Å-thick first electrode. N,N'-di(1-naphthyl)-N,N'-diphenylbenzidine (NPB) was deposited in vacuum on the upper portion of the first electrode to form a 300 Å-thick hole injection layer. A compound TCTA was deposited in vacuum on the upper portion of the hole injection layer to form a 200 Å-thick hole transport layer.

Thereafter, 4-(10-phenylanthracen-9-yl)dibenzo[b,d]furan, which is a light emitting host, and N¹,N⁶-di(naphthalen-2-yl)-N¹,N⁶-diphenylpyrene-1,6-diamine, which is a light emitting dopant, were co-deposited at a weight ratio of 99:1 on the upper portion of the hole transport layer to form a 200 Å-thick emission layer.

Next, T2T and TPM-TAZ were deposited (e.g., co-deposited) on the upper portion of the emission layer to form a 200 Å-thick electron transport layer.

Any one of Compound A to C was deposited on the electron transport layer to form a 15 nm-thick charge generation layer.

N,N'-di(1-naphthyl)-N,N'-diphenylbenzidine (NPB) was deposited in vacuum on the charge generation layer to form a 300 Å-thick hole injection layer. A compound TCTA was deposited in vacuum on the upper portion of the hole injection layer to form a 200 Å-thick hole transport layer. Thereafter, mCP and N¹,N⁶-di(naphthalen-2-yl)-N¹,N⁶-diphenylpyrene-1,6-diamine were co-deposited at a weight ratio of 99:1 on the upper portion of the hole transport layer to form a 200 Å-thick emission layer. Next, T2T and TPM-TAZ were deposited (e.g., co-deposited) on the upper portion of the emission layer to form a 200 Å-thick electron transport layer. On the upper portion of the electron transport layer, the polycyclic compound of an embodiment and metal dopants were deposited (e.g., co-deposited) or a single metal layer was deposited to form a 10 Å-thick electron injection layer.

Next, aluminium (Al) and magnesium (Mg) were co-deposited at a weight ratio of 9:1 to form a 100 Å-thick second electrode.

Then, P4 was deposited on the second electrode to form a 500 Å-thick capping layer, thereby manufacturing light emitting elements of Examples 6 to 8 and Comparative Example 6.

### Compounds Utilized to Manufacture Light Emitting Elements

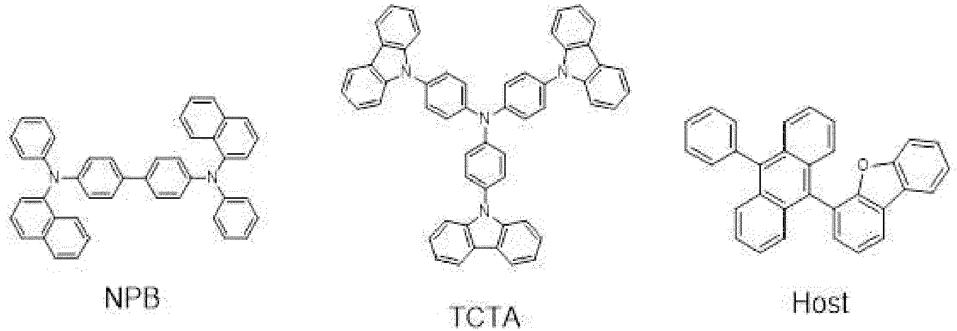

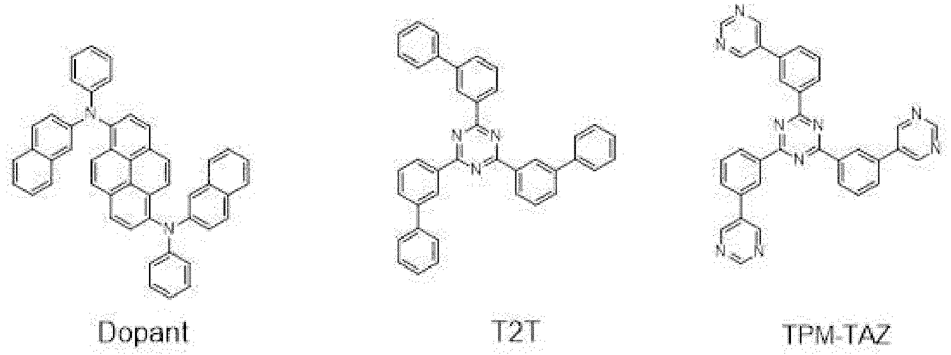

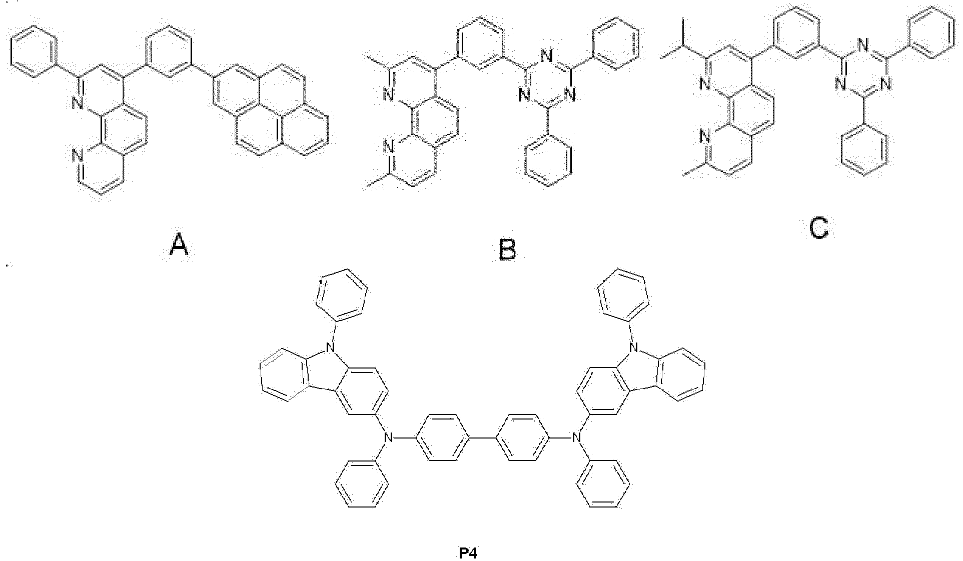

### Evaluation of Physical Properties of Light Emitting Element 1 and Light Emitting Element 2

Tables 1 to 3 show the evaluation results of the light emitting elements of Examples and Comparative Examples. Tables 1 to 3 each show the driving voltages and efficiencies of the light emitting elements of Examples as a relative value (%) to the driving voltages and efficiencies of a respective one of the light emitting elements of Comparative Examples, on the basis of 100% of the driving voltages and efficiencies of Comparative Examples.

For example, in Tables 1 to 3, for the driving voltage, on the basis of 100%, the driving voltage larger than 100% shows that the driving voltage is larger than those of the respective Comparative Examples, and the driving voltage smaller than 100% shows that the driving voltage is smaller than those of the respective Comparative Examples. In Tables 1 to 3, for the efficiency, on the basis of 100%, the efficiency larger than 100% shows that the efficiency is larger than those of the respective Comparative Examples, and the efficiency smaller than 100% shows that the efficiency is smaller than those of the respective Comparative Examples.

Table 1 shows the driving voltages and efficiencies by comparing those of the light emitting elements of Examples 1 to 3 with those of the light emitting elements of Comparative Examples 1 and 2.

**Table 1**

| Structure | Electron injection layer material (material, volume%) | Driving voltage (%) | Efficiency (%) |
|---|---|---|---|
| Comparative Example 1 | Yb, 100 volume% | 100% | 100% |
| Comparative Example 2 | Li, 1 volume % | 119% | 92% |
| Example 1 | Li, 3 volume % | 100% | 104% |
| Example 2 | Li, 5 volume % | 100% | 103% |
| Example 3 | Li, 7 volume % | 100% | 103% |

Referring to Table 1, it may be confirmed that the light emitting elements of Examples 1 to 3 have equivalent driving voltages, and exhibit higher efficiencies compared to the light emitting element of Comparative Example 1. Accordingly, it may be seen that the light emitting element utilizing the electron injection layer containing the organic host and metal dopant exhibits an element efficiency higher than the light emitting element utilizing the electron injection layer formed of only the metal single layer.

Comparing the light emitting element of Comparative Example 2 with the light emitting elements of Examples 1 to 3, it may be confirmed that the light emitting elements of Examples 1 to 3 exhibit lower driving voltages and higher efficiencies than the light emitting element of Comparative Example 2. Accordingly, it may be seen that the electron injection layer material containing Li (e.g., any amount of Li) does not simply lead to improvement of the efficiency, and the electron injection layer contains 3 volume% or more of Li in combination with the polycyclic compound, shows improved efficiency.

Table 2 shows the driving voltages and efficiencies by comparing those of the light emitting elements of Examples 4 and 5 with those of the light emitting elements of Comparative Examples 3 to 5.

**Table 2**

| Structure | Electron injection layer material (material, volume%) | Driving voltage (%) | Efficiency (%) |
|---|---|---|---|
| Comparative Example 3 | Yb, 100 volume% | 100% | 100% |
| Comparative Example 4 | Yb, 3 volume % | 112% | 95% |
| Example 4 | Yb, 5 volume % | 101% | 105% |
| Example 5 | Yb, 10 volume % | 100% | 109% |
| Comparative Example 5 | Yb, 15 volume % | 106% | 97% |

Referring to Table 2, it may be confirmed that the light emitting elements of Examples 4 and 5 have equivalent driving voltages, and exhibit higher efficiencies compared to the light emitting element of Comparative Example 3. Accordingly, it may be seen that the light emitting element utilizing the electron injection layer containing the organic host and metal dopant exhibit an element efficiency higher than the light emitting element utilizing the electron injection layer formed of only the metal single layer.

Comparing the light emitting elements of Examples 4 and 5 with the light emitting elements of Comparative Examples 4 and 5, it may be confirmed that the light emitting elements of Examples 4 and 5 exhibit efficiencies higher than the light emitting elements of Comparative Examples 4 and 5. Accordingly, it may be seen that the electron injection layer material containing Yb (e.g., any amount of Yb) does not simply lead to improvement of the efficiency of the light emitting element, and the electron injection layer contains 5 volume% to 10 volume% of Yb in combination with the polycyclic compound shows improved efficiency of the light emitting element.

Table 3 shows the driving voltages and efficiencies by comparing those of the light emitting elements of Examples 6 to 8 with those of the light emitting element of Comparative Example 6.

**Table 3**

| Structure | Electron injection layer material (material, volume%) | Driving voltage (%) | Efficiency (%) |
|---|---|---|---|
| Comparative Example 6 | Yb, 100 volume% | 100% | 100% |
| Example 6 | Li, 3 volume % | 100% | 105% |
| Example 7 | Li, 5 volume % | 100% | 105% |
| Example 8 | Li, 7 volume % | 100% | 104% |

Referring to Table 3, it may be confirmed that the light emitting elements of Examples 6 to 8 have equivalent driving voltages, and exhibit higher efficiencies compared to the light emitting element of Comparative Example 6. Accordingly, it may be seen that the light emitting element utilizing the electron injection layer containing the organic host and metal dopant exhibits an element efficiency higher than the light emitting element utilizing the electron injection layer formed of only the metal single layer.

In some embodiments, it may be confirmed through the results of Table 3 that even in a tandem structure, when the electron injection layer adjacent to the second electrode contains the organic host and metal dopant, higher element efficiency is exhibited.

Table 4 shows the light transmittances and light absorption rates by comparing those of the light emitting elements of Examples 9 to 12 with those of the light emitting element of Comparative Example 7.

**Table 4**

| Structure | Electron injection layer material (material, volume%) | Light transmittance (%) | | | Light absorption rate (%) | | |
|---|---|---|---|---|---|---|---|
| Structure | Electron injection layer material (material, volume%) | 450nm | 540nm | 640nm | 450nm | 540nm | 640nm |
| Comparative Example 7 | Yb, 100 volume% | 63.5 | 77.2 | 78.5 | 15.0 | 13.8 | 14.7 |
| Example 9 | Yb, 5 volume % | 66.3 | 80.5 | 82.4 | 11.5 | 9.7 | 10.7 |
| Example 10 | Yb, 10 volume % | 65.3 | 79.6 | 80.7 | 11.7 | 10.1 | 11.2 |
| Example 11 | Li, 5 volume % | 65.6 | 80.1 | 81.0 | 11.7 | 9.9 | 10.9 |
| Example 12 | Li, 10 volume % | 66.1 | 80.4 | 81.5 | 11.0 | 9.5 | 10.3 |

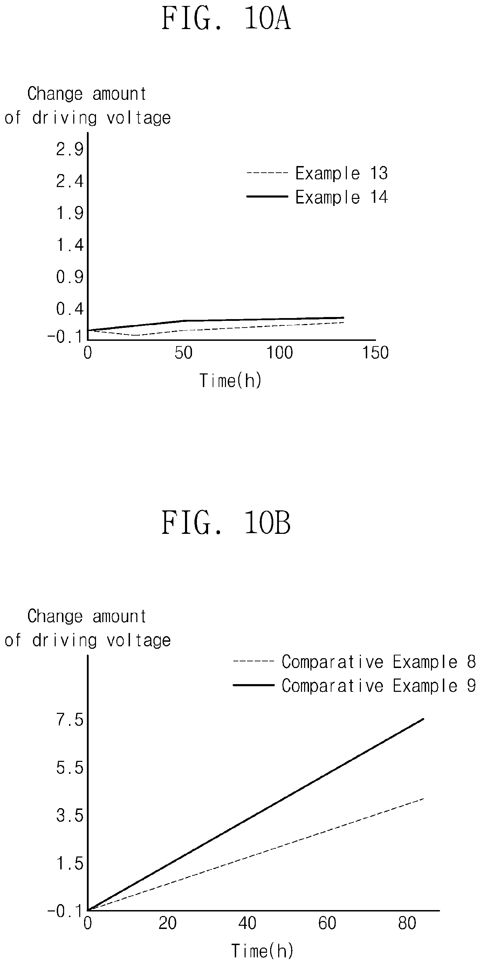

Referring to Table 4, it may be confirmed that the light emitting elements of Examples 9 to 12 each have higher light transmittance and lower light absorption rate for the light having a wavelength of 450 nm, 540 nm, or 640 nm compared to the light emitting element of Comparative Example 7. Accordingly, it may be confirmed that the light emitting element utilizing the electron injection layer containing the organic host and metal dopant has the amount of the light absorption less than the light emitting element utilizing the electron injection layer formed of the metal single layer. FIG. 10A is a graph showing a change in the driving voltage of the light emitting element over time when the binding energy between the metal dopant and the host contained in the electron injection layer is about 2.30 eV. FIG. 10B is a graph showing a change in the driving voltage of the light emitting element over time when the binding energy between the metal dopant and the host contained in the electron injection layer is about 1.09 eV.

Referring to FIGS. 10A and 10B, each of the light emitting elements of Examples 13 and 14 is the case where the binding energy between the metal dopant and the host is about 2.3 eV, and each of the light emitting elements of Comparative Examples 8 and 9 is the case where the binding energy between the metal dopant and the host about 1.09 eV. Each of the light emitting elements of Example 13 and Comparative Example 8 has the ratio of the metal dopant to the host of 5:95, and each of the light emitting elements of Example 14 and Comparative Example 9 has the ratio of the metal dopant to the host of 10:90. A change in the driving voltage over time is measured under high-temperature conditions (85 °C).

Referring to FIG. 10A, it may be seen that the light emitting elements of Examples 13 and 14 each have a small change in the driving voltage over time under high-temperature conditions. Unlike Examples 13-14, referring to FIG. 10B, it may be confirmed that the light emitting elements of Comparative Example 8 and 9 each have a significant and higher increase in the driving voltage over time under high-temperature conditions. Therefore, when the binding energy between the metal dopant and the host is about 2.0 eV or less (e.g., is less than 2.0 eV), it can be seen that the driving voltage increases over time under high-temperature conditions. In addition, when the binding energy between the metal dopant and the host is about 2.0 eV or more (e.g., is 2.0 eV or greater), it can be seen that the driving voltage is stably maintained under high-temperature conditions although time passes. When the binding energy between the metal dopant and the host is about 2.0 eV or more, the driving voltage of the light emitting element is stably maintained, and thus the light emitting element may have long service life characteristics.

In an embodiment, the light emitting element includes the electron injection layer containing the metal dopant and the host. When the host contained in the electron injection layer is doped with the metal dopant, the LUMO energy level of the host may be reduced, and the difference between the LUMO energy level of the doped host and the energy level of the work function of the second electrode may be about 0.2 eV or less. As a result, the characteristics of the electron injection from the second electrode into the electron injection layer may be improved, and the efficiency of the light emitting element may be improved.

The light emitting element of an embodiment and the display device including the same include an electron injection layer containing a polycyclic compound and a metal dopant, thereby having high luminous efficiency.

As used herein, the terms "substantially," "about," and similar terms are used as terms of approximation and not as terms of degree, and are intended to account for the inherent deviations in measured or calculated values that would be recognized by those of ordinary skill in the art. Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The display device and/or any other relevant devices or components according to embodiments of the present invention described herein may be implemented utilizing any suitable hardware, firmware (e.g. an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments.

Although the present disclosure has been described with reference to a preferred embodiment of the present disclosure, it will be understood that the present disclosure should not be limited to these preferred embodiments but one or more suitable changes and modifications can be made by those skilled in the art without departing from the scope of the present disclosure.

Accordingly, the technical scope of the present disclosure is not intended to be limited to the contents set forth in the detailed description of the specification, but is intended to be defined by the appended claims, and equivalents thereof.

## Claims

1. A light emitting element comprising:
a first electrode;
a hole transport region on the first electrode;
an emission layer on the hole transport region;
an electron transport region on the emission layer and comprising an electron transport layer and an electron injection layer on the electron transport layer; and
a second electrode on the electron transport region,
wherein the electron injection layer comprises a host represented by Formula A or Formula B, and a metal dopant, and
the metal dopant comprises Ag, Bi, Mg, Li, Yb, Cu, La, Pr, Nd, Pm, Sm, Eu, Gd, Tb, Dy, Ho, Er, Tm, and/or Lu: 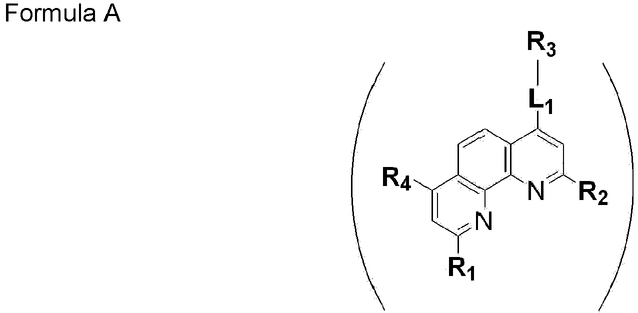 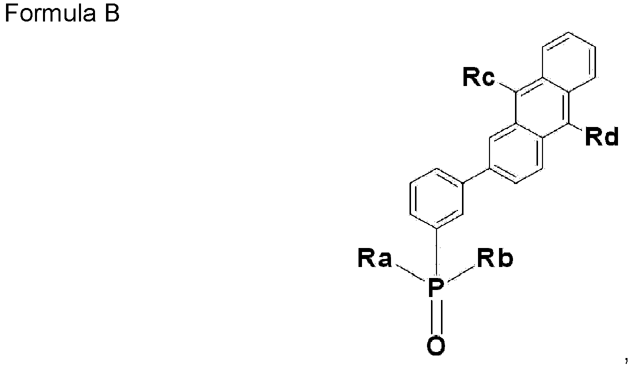
wherein, in Formula A,
L₁ is a direct linkage, or a substituted or unsubstituted phenylene group,
R₁ and R₂ are each independently a hydrogen atom, a substituted or unsubstituted methyl group, or a substituted or unsubstituted phenyl group,
R₃ and R₄ are each independently a hydrogen atom, a substituted or unsubstituted aryl group having 6 to 30 ring-forming carbon atoms, or a substituted or unsubstituted heteroaryl group having 2 to 30 ring-forming carbon atoms, and
in Formula B,
Ra and Rb are each independently a substituted or unsubstituted alkyl group having 1 to 20 carbon atoms, or a substituted or unsubstituted aryl group having 6 to 30 ring-forming carbon atoms, and
Rc and Rd are each independently a substituted or unsubstituted aryl group having 6 to 30 ring-forming carbon atoms.

2. The light emitting element of claim 1, wherein an absolute value of a difference between a lowest unoccupied molecular orbital (LUMO) energy level of the host doped with the metal dopant and a work function energy level of the second electrode is about 0.2 eV or less.

3. The light emitting element of claim 1 or claim 2, wherein a binding energy between the host and the metal dopant is about 2.0 eV or more.

4. The light emitting element of any one of claims 1 to 3, wherein:
(i) the metal dopant is Li, and a volume ratio of the metal dopant to a total volume of the host and the metal dopant in the electron injection layer is 3-10 volume%; or
(ii) the metal dopant is Yb, and a volume ratio of the metal dopant to a total volume of the host and the metal dopant in the electron injection layer is 5-10 volume%.

5. The light emitting element of any one of claims 1 to 4, wherein the second electrode is directly on the electron injection layer.

6. The light emitting element of any one of claims 1 to 5, wherein the host represented by Formula A is represented by Formula A-1 or Formula A-2: 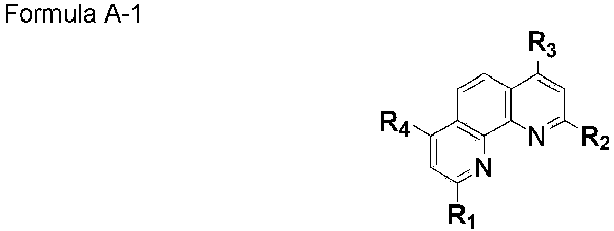 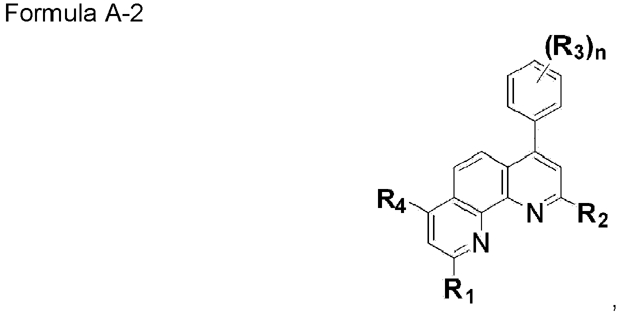 wherein, in Formula A-2, n is an integer of 0 to 5, and
in Formula A-1 and Formula A-2, R₁ to R₄ are each independently the same as defined in connection with Formula A, optionally wherein, in Formula A-2, R₃ is represented by any one among S1 to S25:

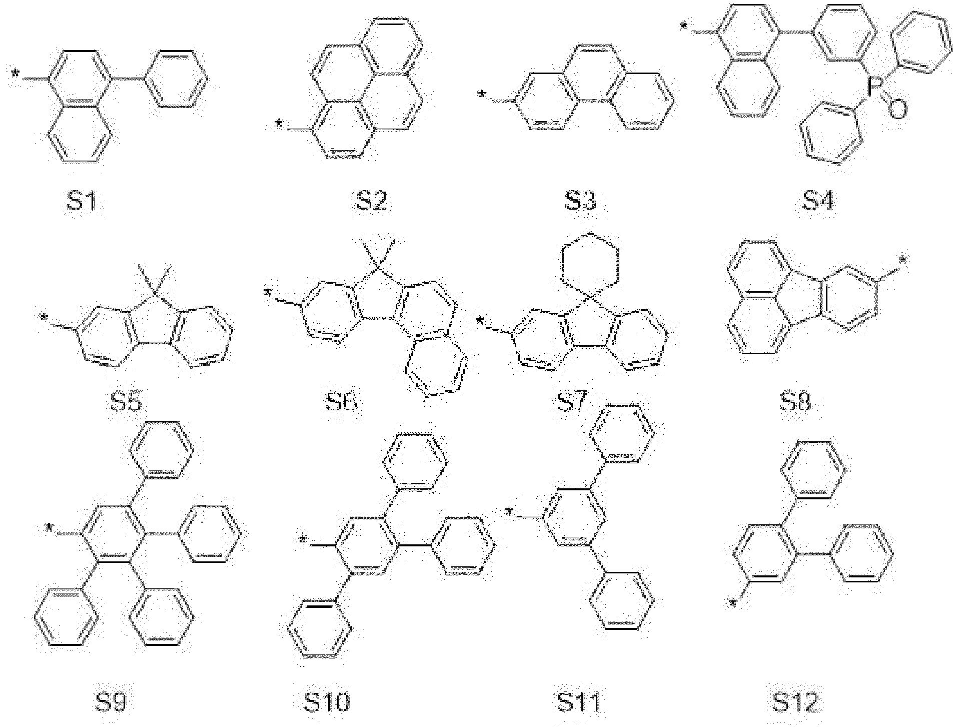

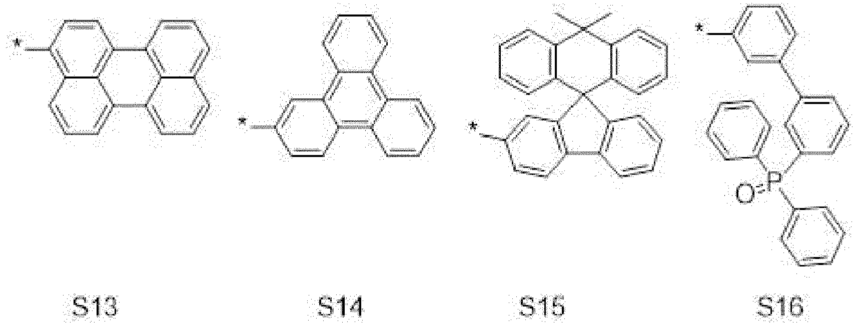

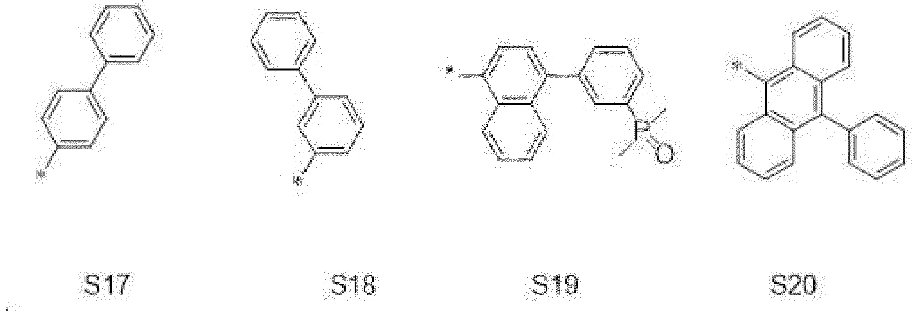

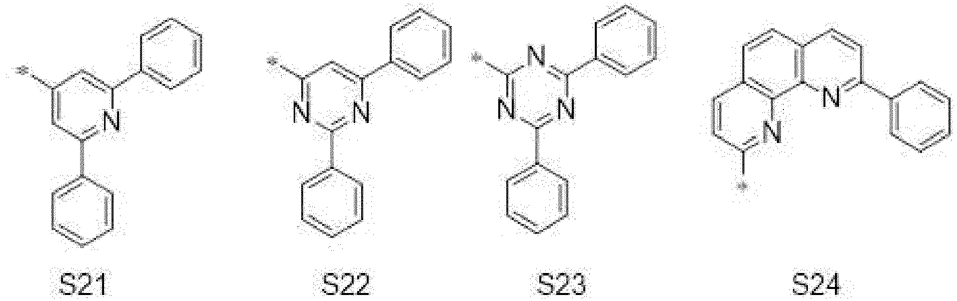

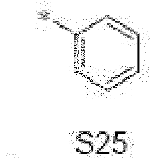

7. The light emitting element of any one of claims 1 to 6, wherein the electron injection layer comprises at least one among compounds of Compound Group 1:

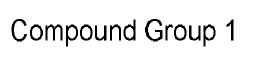

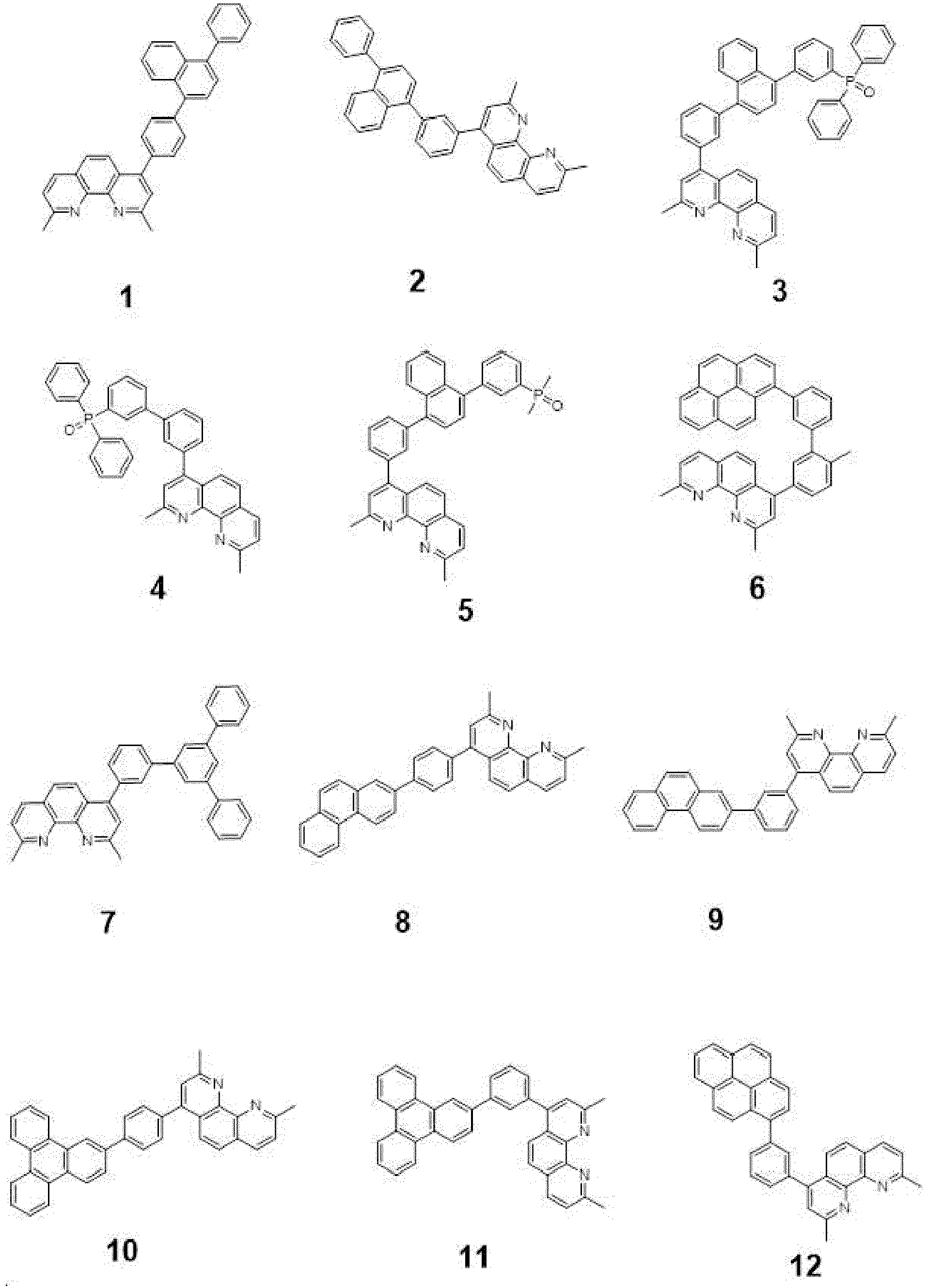

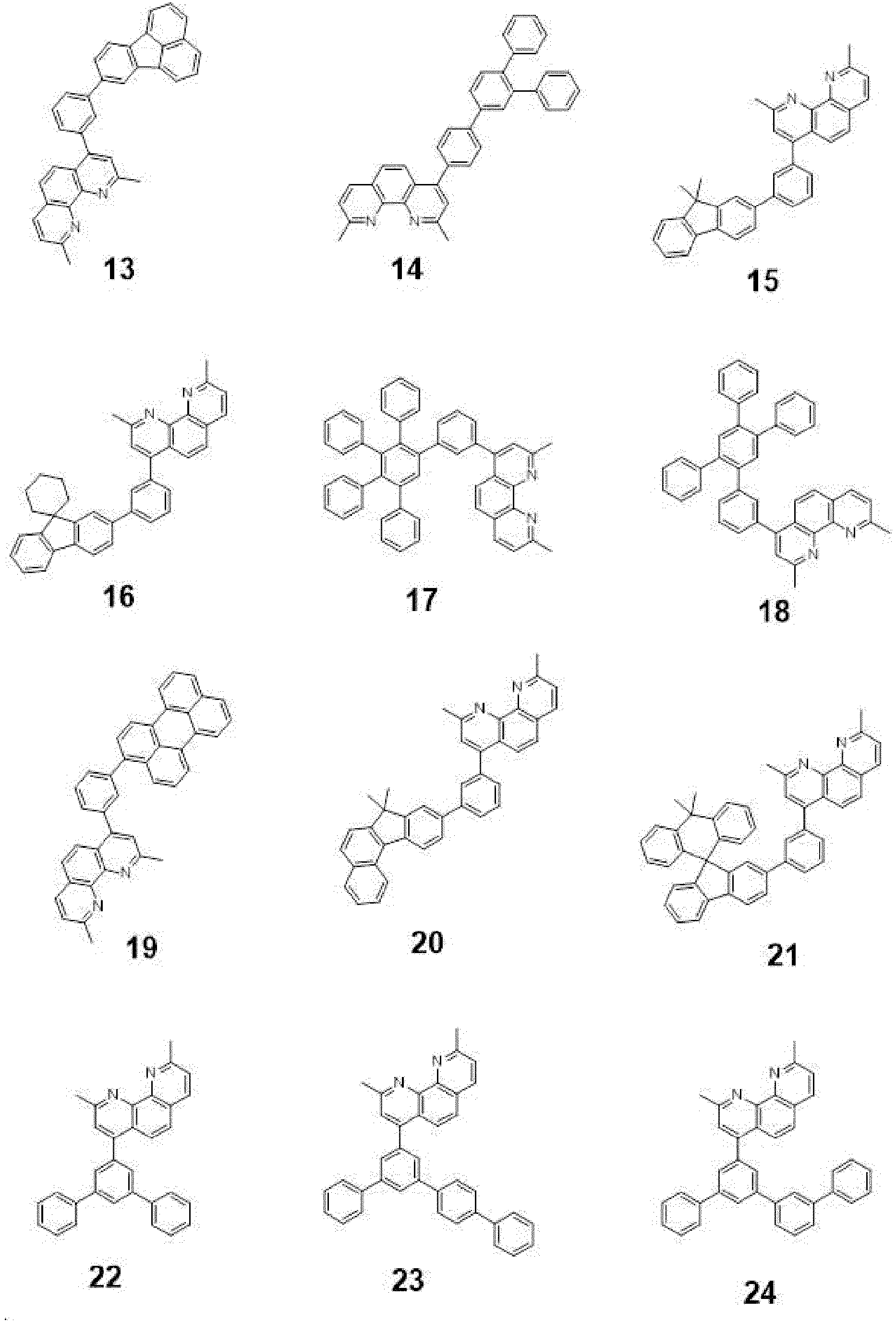

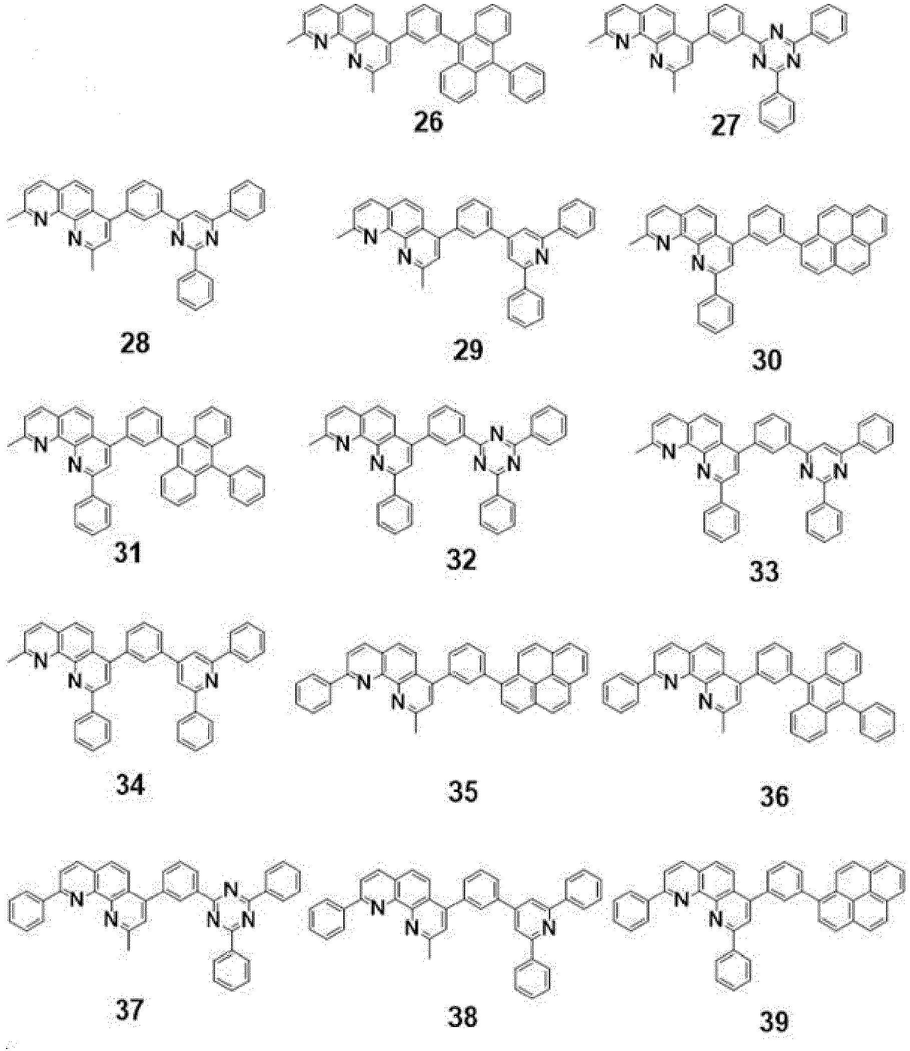

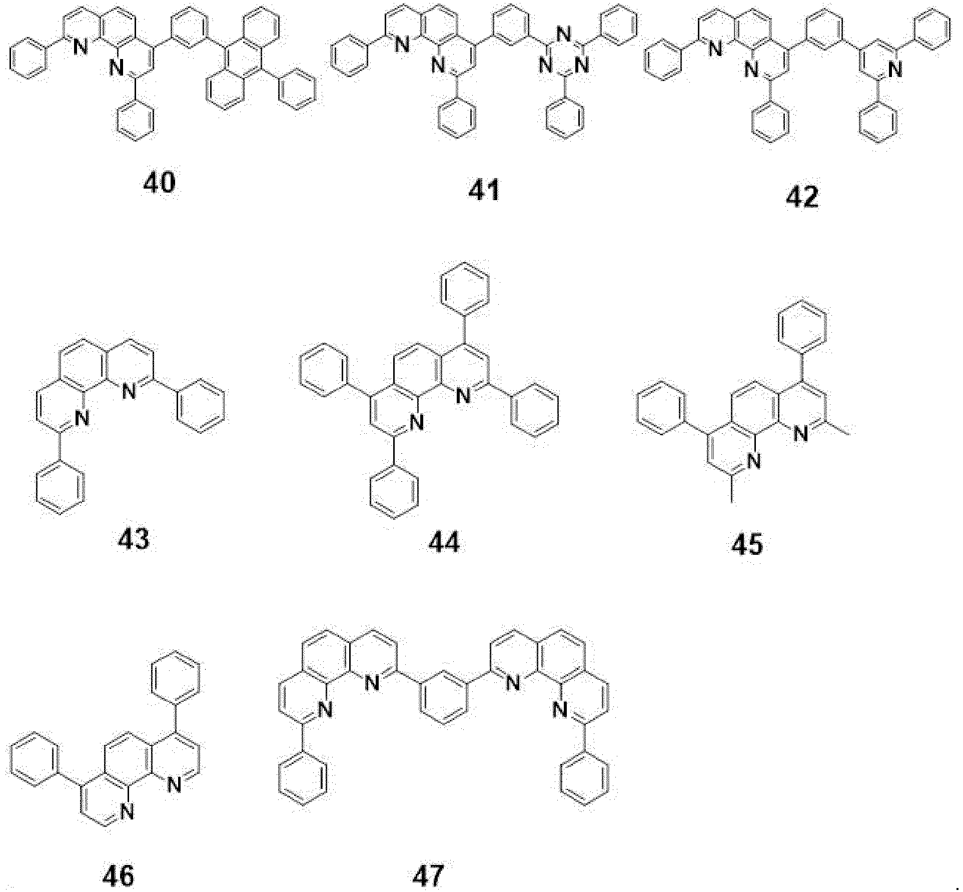

8. The light emitting element of any one of claims 1 to 5, wherein:
(i) the host represented by Formula B is represented by Formula B-1 or Formula B-2: 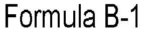 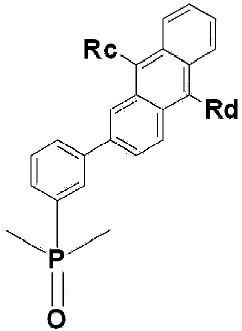 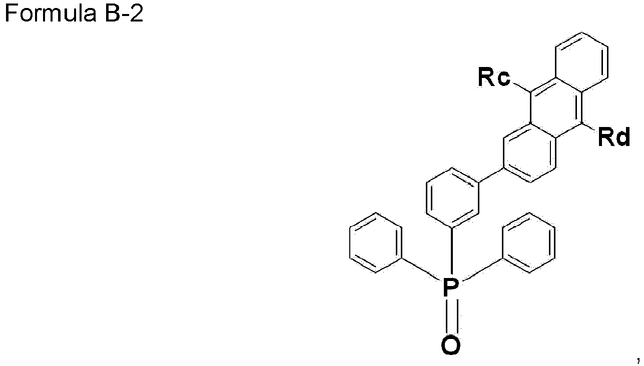 wherein, in Formula B-1 and Formula B-2, Rc and Rd are each independently the same as defined in connection with Formula B; and/or
(ii) Rc and Rd in Formula B are each independently represented by any one among T1 to T4:

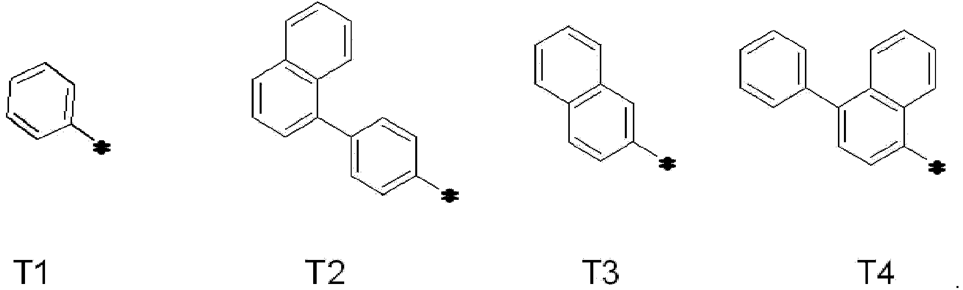

9. The light emitting element of any one of claims 1 to 5, wherein the electron injection layer comprises at least one compound of Compound Group 2:

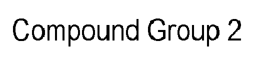

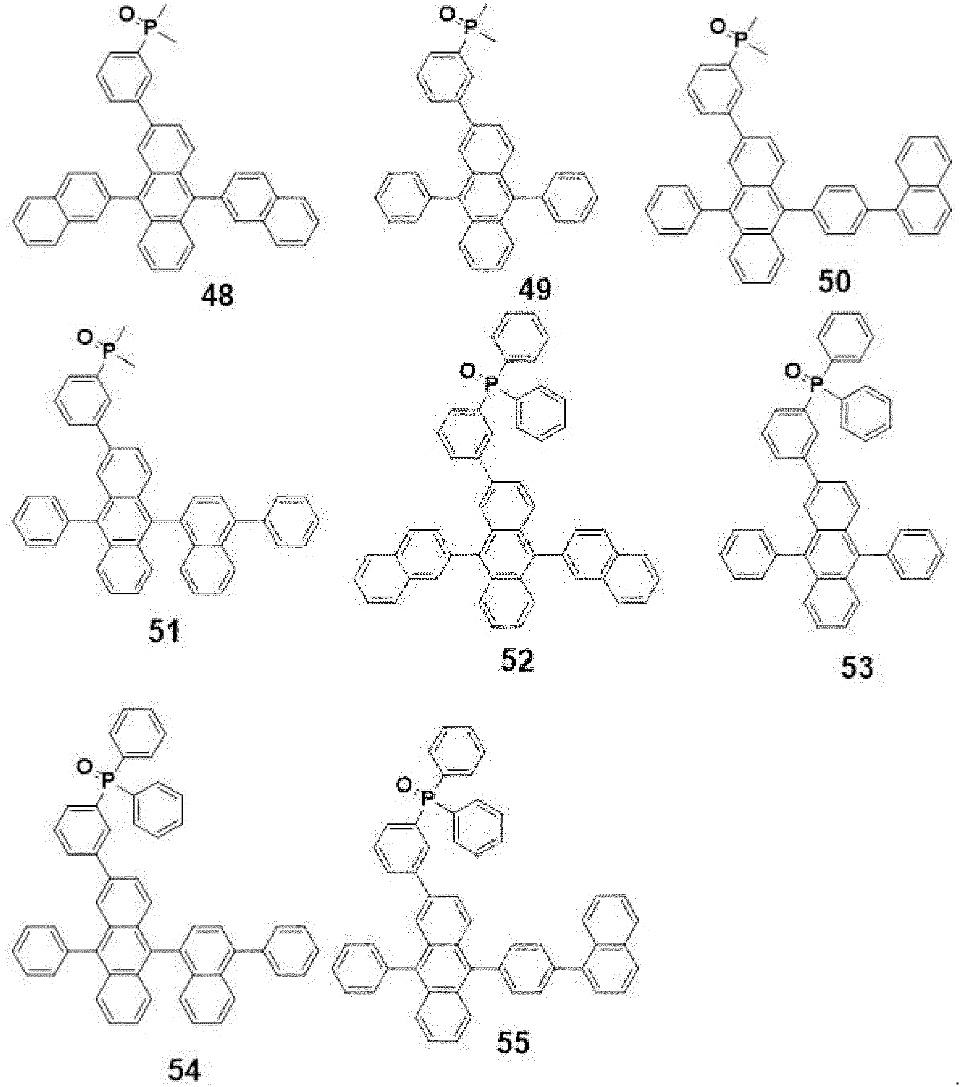

10. A light emitting element comprising:
a first electrode;
a hole transport region on the first electrode;
an emission layer on the hole transport region;
an electron transport region on the emission layer and comprising an electron transport layer and an electron injection layer on the electron transport layer; and
a second electrode on the electron transport region,
wherein the electron injection layer comprises a host represented by Formula A or Formula B, and a metal dopant, and
an absolute value of a difference between a lowest unoccupied molecular orbital (LUMO) energy level of the host doped with the metal dopant and a work function energy level of the second electrode is about 0.2 eV or less: 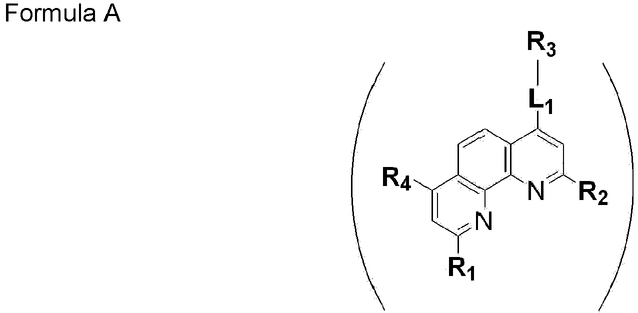 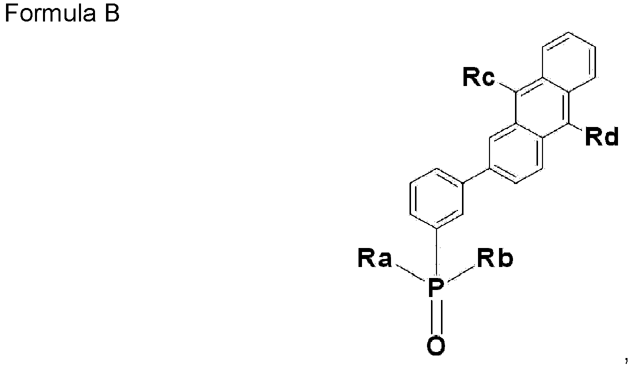
wherein, in Formula A,
L₁ is a direct linkage, or a substituted or unsubstituted phenylene group,
R₁ and R₂ are each independently a hydrogen atom, a substituted or unsubstituted methyl group, or a substituted or unsubstituted phenyl group,
R₃ and R₄ are each independently a hydrogen atom, a substituted or unsubstituted aryl group having 6 to 30 ring-forming carbon atoms, or a substituted or unsubstituted heteroaryl group having 2 to 30 ring-forming carbon atoms, and
in Formula B,
Ra and Rb are each independently a substituted or unsubstituted alkyl group having 1 to 20 carbon atoms, or a substituted or unsubstituted aryl group having 6 to 30 ring-forming carbon atoms, and
Rc and Rd are each independently a substituted or unsubstituted aryl group having 6 to 30 ring-forming carbon atoms.

11. The light emitting element of claim 10, wherein a binding energy between the host and the metal dopant is about 2.0 eV or more.

12. The light emitting element of claim 10 or claim 11, wherein the host represented by Formula A is represented by Formula A-1 or Formula A-2: 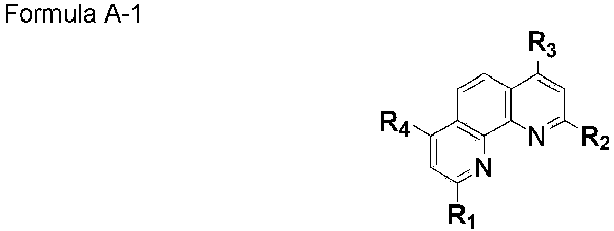 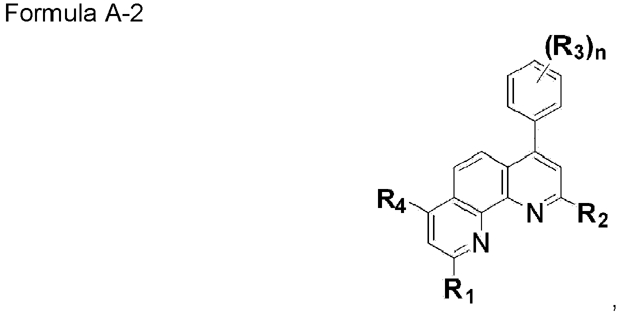 wherein, in Formula A-2, n is an integer of 0 to 5, and
in Formula A-1 and Formula A-2, R₁ to R₄ are each independently the same as defined in connection with Formula A, optionally wherein, in Formula A-2, R₃ is represented by any one among groups S1 to S25:

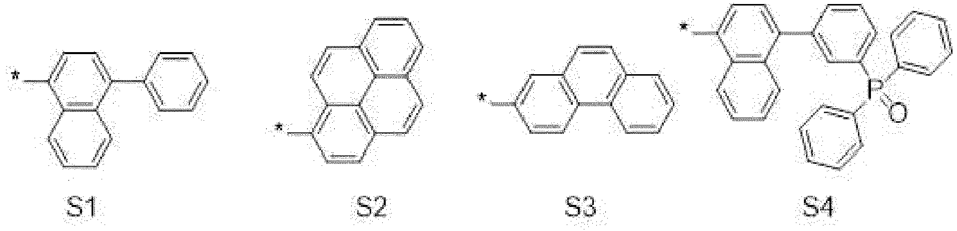

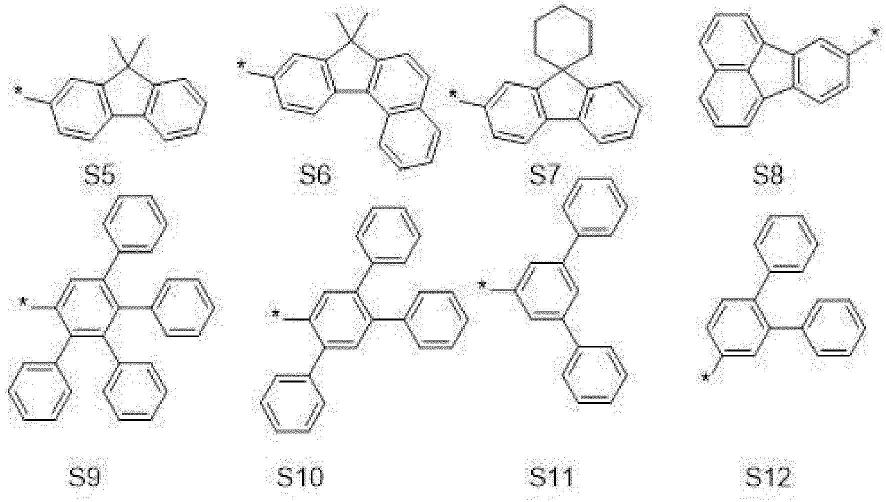

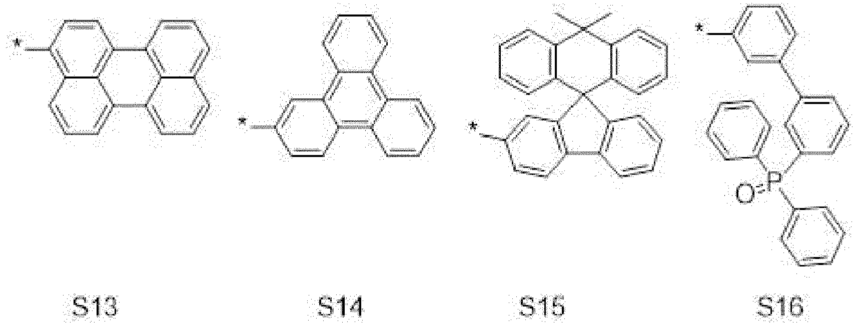

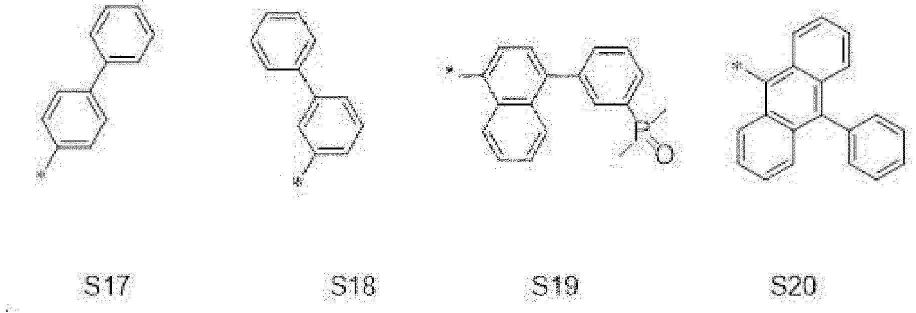

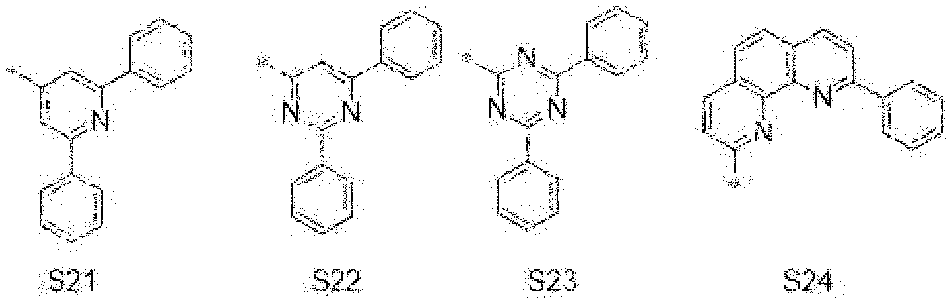

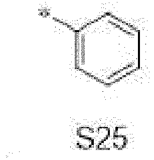

13. The light emitting element of any one of claims 10 to 12, wherein the host represented by Formula A is represented by any one among polycyclic compounds of Compound Group 1:

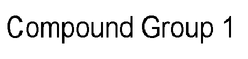

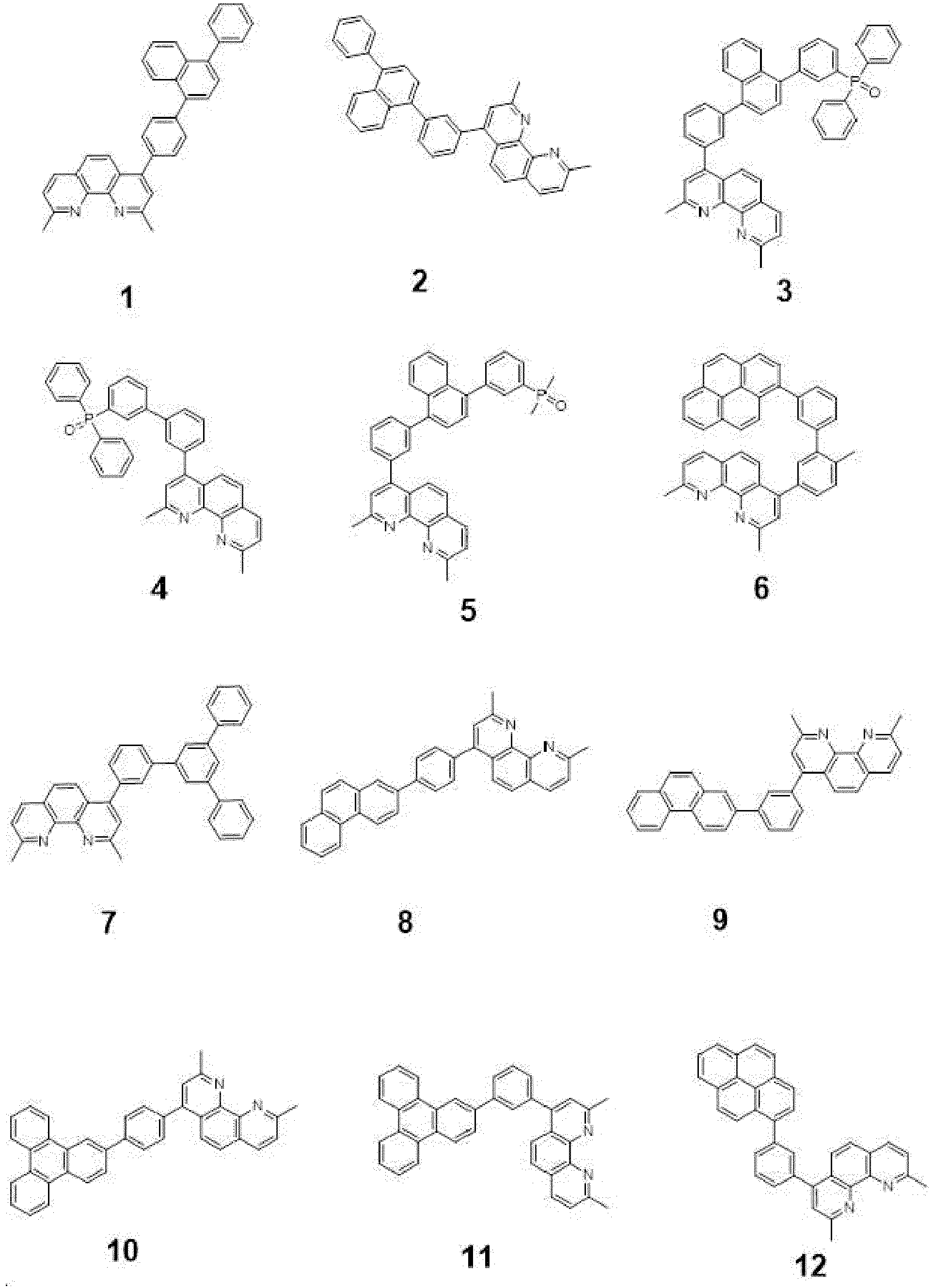

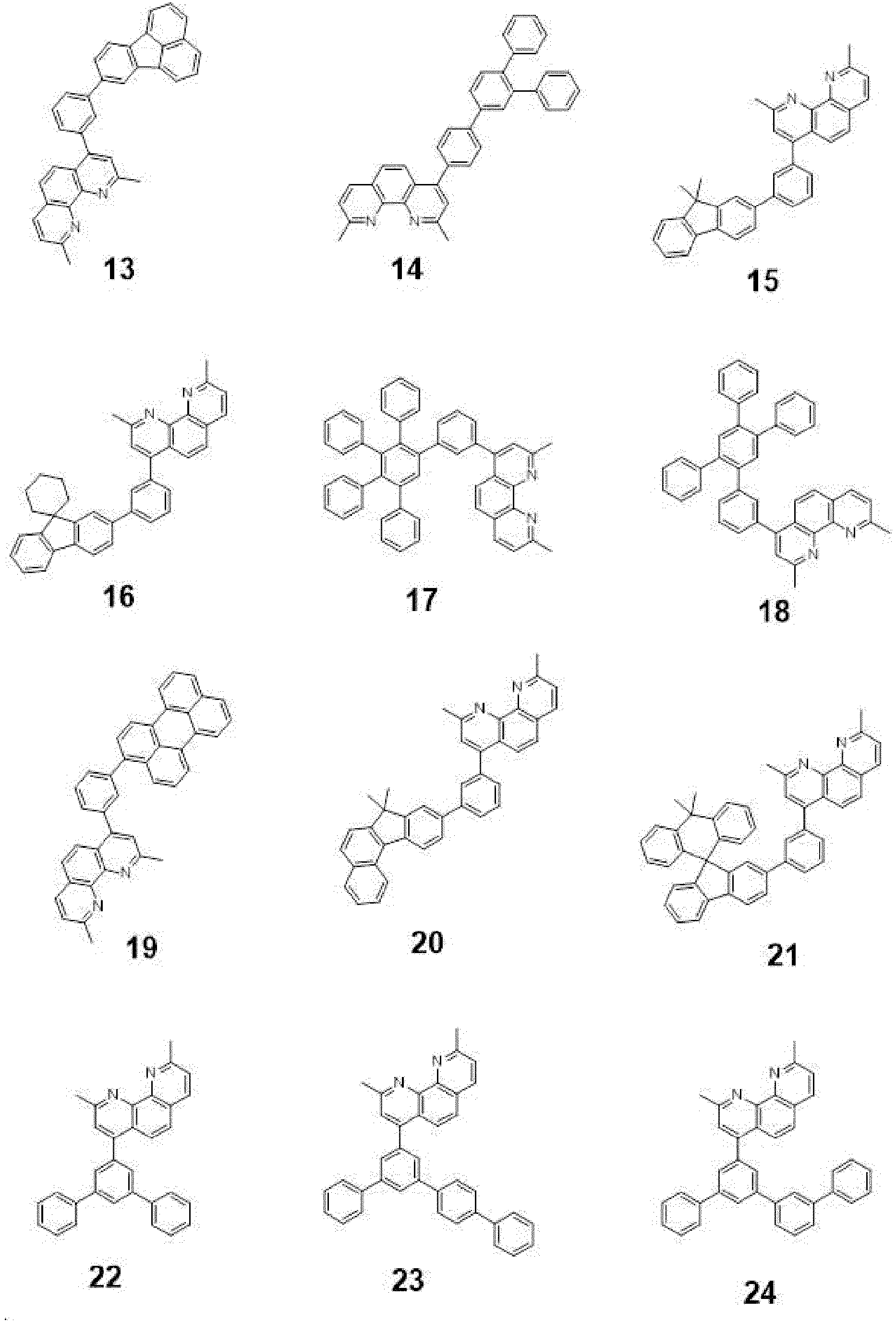

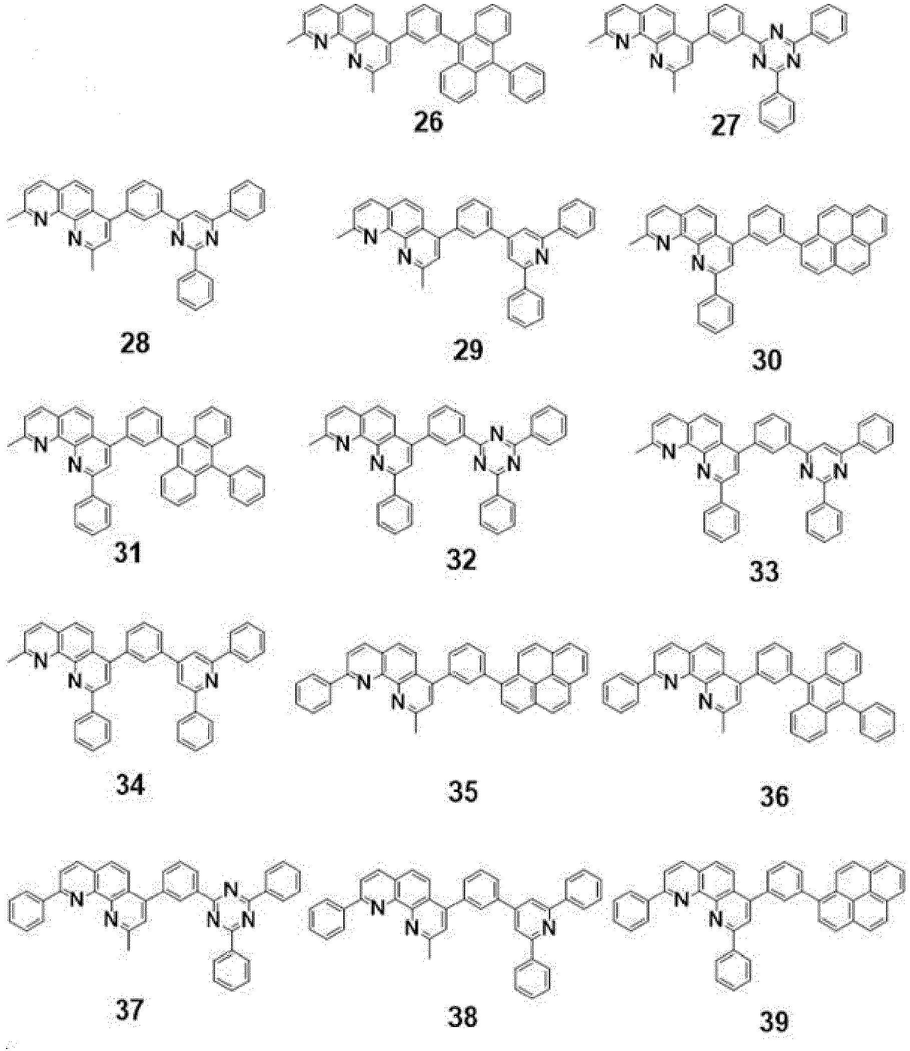

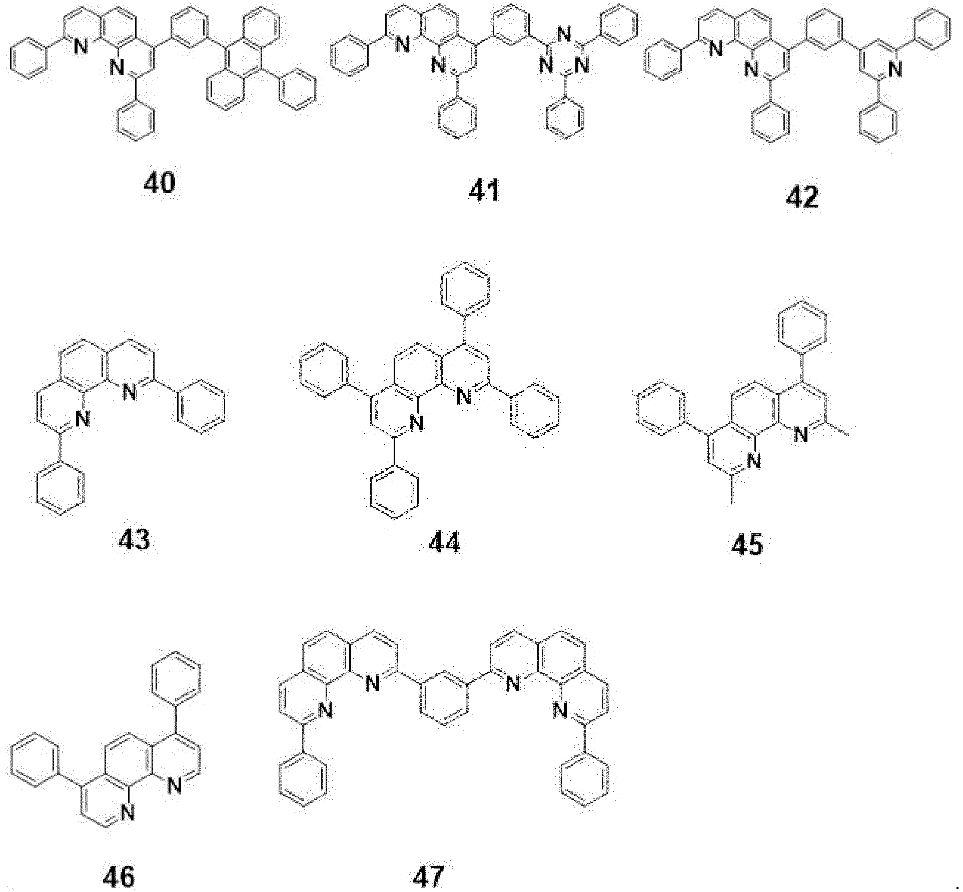

14. The light emitting element of claim 10 or claim 11, wherein:
(i) in Formula B, Ra and Rb are each independently an unsubstituted methyl group or an unsubstituted phenyl group; and/or
(ii) in Formula B, Rc and Rd are each independently a substituted or unsubstituted phenyl group, or a substituted or unsubstituted naphthyl group.

15. The light emitting element of claim 10 or claim 11, wherein the host represented by Formula B is any one among polycyclic compounds of Compound Group 2:
